(19) Europäisches Patentamt
European Patent Office
Office européen des brevets

(11) EP 3 269 753 B1

(12) **EUROPEAN PATENT SPECIFICATION**

(45) Date of publication and mention of the grant of the patent:
**29.09.2021 Bulletin 2021/39**

(21) Application number: **16761984.0**

(22) Date of filing: **09.03.2016**

(51) Int Cl.:
***C08G 61/12*** *(2006.01)* ***H01L 31/042*** *(2014.01)*
***C07D 417/14*** *(2006.01)* ***H01L 51/00*** *(2006.01)*
*H01L 51/42* *(2006.01)*

(86) International application number:
**PCT/KR2016/002356**

(87) International publication number:
**WO 2016/144097 (15.09.2016 Gazette 2016/37)**

(54) **POLYMER AND ORGANIC SOLAR CELL COMPRISING SAME**

POLYMER UND ORGANISCHE SOLARZELLE DAMIT

POLYMÈRE ET CELLULE SOLAIRE ORGANIQUE LE COMPRENANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **09.03.2015 KR 20150032475**

(43) Date of publication of application:
**17.01.2018 Bulletin 2018/03**

(73) Proprietor: **LG Chem, Ltd.**
**Seoul 07336 (KR)**

(72) Inventors:
- **LEE, Jiyoung**
**Daejeon 34122 (KR)**
- **CHOI, Doowhan**
**Daejeon 34122 (KR)**
- **LEE, Hangken**
**Daejeon 34122 (KR)**
- **LIM, Bogyu**
**Daejeon 34122 (KR)**
- **LEE, Jaechol**
**Daejeon 34122 (KR)**

(74) Representative: **Hoffmann Eitle**
**Patent- und Rechtsanwälte PartmbB**
**Arabellastraße 30**
**81925 München (DE)**

(56) References cited:
**WO-A1-2013/119022**
**CN-A- 103 030 790**
**KR-A- 20140 146 116**
**KR-A- 20150 008 806**
**KR-A- 20160 031 958**

- **ZHENG BANG LIM ET AL: "New moderate bandgap polymers containing alkoxysubstituted-benzo[c][1,2,5]thiadiazo le and thiophene-based units", JOURNAL OF POLYMER SCIENCE, PART A: POLYMER CHEMISTRY, vol. 49, no. 20, 15 October 2011 (2011-10-15), pages 4387-4397, XP055486699, ISSN: 0887-624X, DOI: 10.1002/pola.24879**
- **NAGARJUNA, G. ET AL.: 'A Straightforward Route to Electron Transporting Conjugated Polymers' JOURNAL OF MATERIALS CHEMISTRY. vol. 22, no. 31, 2012, pages 1 - 28, XP055337658**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 269 753 B1

## Description

[Technical Field]

This application claims priority to and the benefit of Korean Patent Application No. 10-2015-0032475 filed in the Korean Intellectual Property Office on March 9, 2015.

The present specification relates to a polymer and an organic solar cell including the same.

[Background Art]

An organic solar cell is a device that may directly convert solar energy into electric energy by applying a photovoltaic effect. A solar cell may be divided into an inorganic solar cell and an organic solar cell, depending on the materials constituting a thin film. Typical solar cells are made through a p-n junction by doping crystalline silicon (Si), which is an inorganic semiconductor. Electrons and holes generated by absorbing light diffuse to p-n junction points and move to an electrode while being accelerated by the electric field. The power conversion efficiency in this process is defined as the ratio of electric power given to an external circuit and solar power entering the solar cell, and the efficiency have reached approximately 24% when measured under a currently standardized virtual solar irradiation condition. However, since inorganic solar cells in the related art have already shown the limitation in economic feasibility and material demands and supplies, an organic semiconductor solar cell, which is easily processed and inexpensive and has various functionalities, has come into the spotlight as a long-term alternative energy source.

For the solar cell, it is important to increase efficiency so as to output as much electric energy as possible from solar energy. In order to increase the efficiency of the solar cell, it is important to generate as many excitons as possible inside a semiconductor, but it is also important to pull the generated charges to the outside without loss. One of the reasons for the charge loss is the dissipation of generated electrons and holes due to recombination. Various methods have been proposed to deliver generated electrons and holes to an electrode without loss, but additional processes are required in most cases, and accordingly, manufacturing costs may be increased.

[Patent Documents]

Korean Patent Application Laid-Open No. 2014-0025621; and CN103030790A, the latter disclosing polymers and their use in photoelectron materials.

[Non-Patent Document]

Two-Layer Organic Photovoltaic Cell (C.W. Tang, Appl. Phys. Lett., 48, 183.(1996))

Efficiencies via Network of Internal Donor-Acceptor Heterojunctions (G. Yu, J. Gao, J. C. Hummelen, F. Wudl, A. J. Heeger, Science, 270, 1789. (1995))

New moderate bandgap polymers containing alkoxysubstituted-benzo[c][1,2,5]thiadiazole and thiophene-based units (Zheng Bang Lim et al, Journal of Polymer Science, Part A: Polymer Chemistry, vol. 49, no.20, pp 4387-4397)

[Detailed Description of the Invention]

[Technical Problem]

An object of the present specification is to provide a polymer and an organic solar cell including the same.

[Technical Solution]

The present invention relates to a polymer consisting of a unit that is represented by any of Chemical Formula 4-1, Chemical Formula 5-1, Chemical Formula 6-1, and Chemical Formula 7-1 as defined herein below. The invention further relates to an organic cell as defined in claims 6 to 9.

While the present invention relates to the polymers and organic cells that are defined in the claims, the present disclosure also provides a polymer comprising: a first unit represented by the following Chemical Formula 1; and a second unit represented by the following Chemical Formula 2.

[Chemical Formula 1]

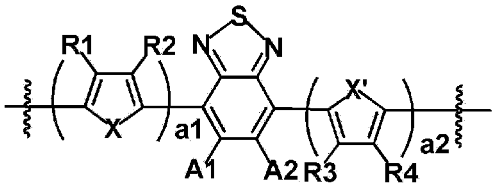

[Chemical Formula 2]

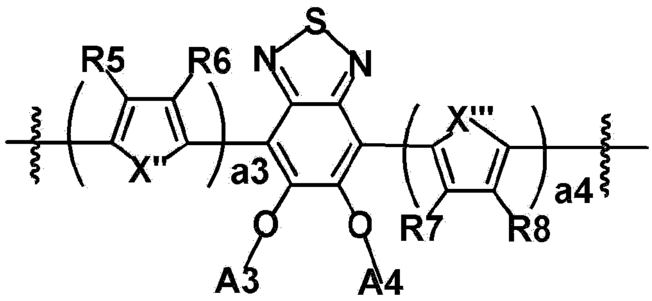

In Chemical Formulae 1 and 2,

X, X', X", and X"' are the same as or different from each other, and are each independently S or Se,
A1 and A2 are the same as or different from each other, and are each independently hydrogen; or fluorine,
A3 and A4 are the same as or different from each other, and are each independently hydrogen; fluorine; a substituted or unsubstituted alkyl group; a substituted or unsubstituted aryl group; or a substituted or unsubstituted heterocyclic group,
R1 to R8 are the same as or different from each other, and are each independently hydrogen; deuterium; a halogen group; a hydroxy group; a substituted or unsubstituted alkyl group; a substituted or unsubstituted alkoxy group; a substituted or unsubstituted aryl group; or a substituted or unsubstituted heterocyclic group, and
a1 to a4 are each an integer of 0 or 1.

Further, the present disclosure provides an organic solar cell comprising: a first electrode; a second electrode which is disposed to face the first electrode; and an organic material layer having one or more layers which is disposed between the first electrode and the second electrode and includes a photoactive layer, in which one or more layers of the organic material layer include the above-described polymer.

[Advantageous Effects]

A polymer according to an exemplary embodiment of the present specification has an energy level of 700 nm or more, and thus may provide a device having high efficiency due to the high short-circuit current ($J_{sc}$). Further, the polymer according to an exemplary embodiment of the present specification has excellent solubility, and thus is economically efficient in terms of time and costs when a device is manufactured.

[Brief Description of Drawings]

FIG. 1 is a view illustrating an organic solar cell according to an exemplary embodiment of the present specification.
FIG. 2 is a view illustrating a UV-vis absorption spectrum of Polymer 1.
FIG. 3 is a view illustrating a UV-vis absorption spectrum of Polymer 2.
FIG. 4 is a view illustrating the current density according to the voltage in an organic solar cell according to Experimental Example 1.
FIG. 5 is a view illustrating the current density according to the voltage in organic solar cells according to Experimental Examples 3 to 5.
FIG. 6 is a view illustrating the current density according to the voltage in organic solar cells according to Experimental

Examples 6 to 8.

FIG. 7 is a view illustrating the current density according to the voltage in organic solar cells according to Experimental Examples 9 to 11.

FIG. 8 is a view illustrating a UV-vis absorption spectrum of Polymer 3.

FIG. 9 is a view illustrating a UV-vis absorption spectrum of Polymer 4.

FIG. 10 is a view illustrating a UV-vis absorption spectrum of Polymer 5.

FIG. 11 is a view illustrating a UV-vis absorption spectrum of Polymer 6.

FIG. 12 is a view illustrating UV-vis absorption spectra of Polymer 7.

FIG. 13 is a view illustrating a UV-vis absorption spectrum of Polymer 8.

FIG. 14 is a view illustrating UV-vis absorption spectra of Polymer 9.

FIG. 15 is a view illustrating a UV-vis absorption spectrum of Polymer 10.

FIG. 16 is a view illustrating a UV-vis absorption spectrum of Polymer 11.

FIG. 17 is a view illustrating UV-vis absorption spectra of Polymer 12.

FIG. 18 is a view illustrating UV-vis absorption spectra of Polymer 13.

FIG. 19 is a view illustrating UV-vis absorption spectra of Polymer 14.

FIG. 20 is a view illustrating UV-vis absorption spectra of Polymer 15.

FIG. 21 is a view illustrating UV-vis absorption spectra of Polymer 16.

FIG. 22 is a view illustrating UV-vis absorption spectra of Polymer 17.

FIG. 23 is a view illustrating UV-vis absorption spectra of Polymer 18.

FIG. 24 is a view illustrating UV-vis absorption spectra of Polymer 19.

FIG. 25 is a view illustrating the current density according to the voltage in organic solar cells according to Experimental Examples 16-1 and 16-2.

FIG. 26 is a view illustrating the current density according to the voltage in organic solar cells according to Experimental Examples 17-1 and 17-2.

FIG. 27 is a view illustrating the current density according to the voltage in organic solar cells according to Experimental Examples 18-1 and 18-2.

FIG. 28 is a view illustrating the current density according to the voltage in organic solar cells according to Experimental Examples 19-1 and 19-2.

FIG. 29 is a view illustrating the current density according to the voltage in organic solar cells according to Experimental Examples 20-1 and 20-2.

FIG. 30 is a view illustrating the current density according to the voltage in organic solar cells according to Experimental Examples 21-1 and 21-2.

FIG. 31 is a view illustrating the current density according to the voltage in organic solar cells according to Experimental Examples 22-1 and 22-2.

FIG. 32 is a view illustrating the current density according to the voltage in organic solar cells according to Experimental Examples 23-1 and 23-2.

FIG. 33 is a view illustrating the current density according to the voltage in organic solar cells according to Experimental Examples 24-1 and 24-2.

FIG. 34 is a view illustrating the current density according to the voltage in organic solar cells according to Experimental Examples 25-1 and 25-2.

FIG. 35 is a view illustrating the current density according to the voltage in organic solar cells according to Experimental Examples 26-1 and 26-2.

FIG. 36 is a view illustrating the current density according to the voltage in organic solar cells according to Experimental Examples 27-1 and 27-2.

FIG. 37 is a view illustrating the current density according to the voltage in organic solar cells according to Experimental Examples 28-1 and 28-2.

[Best Mode]

Hereinafter, the present specification will be described in more detail.

In the present specification, the 'unit' means a repeated structure in which a monomer is included in a polymer, and a structure in which the monomer is bonded into the polymer by polymerization.

In the present specification, the meaning of 'including a unit' means that the unit is included in a main chain in the polymer.

When one part "includes" one constituent element in the present disclosure, unless otherwise specifically described, this does not mean that another constituent element is excluded, but means that another constituent element may be further included.

In an exemplary embodiment of the present disclosure, the polymer includes the first unit represented by

Chemical Formula 1 and the second unit represented by Chemical Formula 2.

In another exemplary embodiment of the present disclosure, the polymer includes one or two or more first units represented by Chemical Formula 1 and one or two or more second units represented by Chemical Formula 2, which are included in the polymer.

In the present disclosure, when two or more first units and/or second units are included in the polymer, the two or more first units and/or second units may be the same as or different from each other. By adjusting a plurality of the first units and/or the second units equally or differently, it is possible to adjust the solubility of a polymer required when a device is manufactured and/or the service life, efficiency characteristics, and the like of the device.

The first unit represented by Chemical Formula 1 includes fluorine, and the second unit represented by Chemical Formula 2 includes an alkoxy group or a thioether group. Accordingly, when the polymer simultaneously includes the first unit represented by Chemical Formula 1 and the second unit represented by Chemical Formula 2, the solubility of the polymer is excellent. In this case, there is an economic advantage in terms of time and/or costs when a device is manufactured.

Further, a polymer according to an exemplary embodiment of the present specification has an energy level of 700 nm or more, and thus may provide a device having high efficiency due to the high short-circuit current ($J_{sc}$). In addition, the polymer according to an exemplary embodiment of the present specification has excellent solubility, and thus is economically efficient in terms of time and costs when a device is manufactured.

Furthermore, in an exemplary embodiment of the present specification, the second unit including -O-A3 and -OA4 increases a HOMO energy level value, and the first unit including A1 and A2 decreases a HOMO energy level value. Accordingly, a high organic solar cell may be implemented by adjusting a ratio of the first unit and the second unit to adjust an appropriate HOMO energy level.

In the present specification, the energy level means the size of energy. Accordingly, even when the energy level is expressed in the negative (-) direction from the vacuum level, it is interpreted that the energy level means an absolute value of the corresponding energy value. For example, the HOMO energy level means the distance from the vacuum level to the highest occupied molecular orbital. Further, the LUMO energy level means the distance from the vacuum level to the lowest unoccupied molecular orbital.

In addition, the meaning of decreasing the HOMO energy level value means that the absolute value of the energy level is increased, and the meaning of increasing the HOMO energy level value means that the absolute value of the energy level is decreased.

Examples of the substituents will be described below, but are not limited thereto.

The term "substitution" means that a hydrogen atom bonded to a carbon atom of a compound is changed into another substituent, and a position to be substituted is not limited as long as the position is a position at which the hydrogen atom is substituted, that is, a position at which the substituent may be substituted, and when two or more are substituted, the two or more substituents may be the same as or different from each other.

In the present specification, the term "substituted or unsubstituted" means being substituted with one or more substituents selected from the group consisting of deuterium; a halogen group; a nitrile group; a nitro group; an imide group; an amide group; a hydroxy group; a substituted or unsubstituted alkyl group; a substituted or unsubstituted cycloalkyl group; a substituted or unsubstituted alkoxy group; a substituted or unsubstituted aryloxy group; a substituted or unsubstituted alkylthioxy group; a substituted or unsubstituted arylthioxy group; a substituted or unsubstituted alkylsulfoxy group; a substituted or unsubstituted arylsulfoxy group; a substituted or unsubstituted alkenyl group; a substituted or unsubstituted aryl group; and a substituted or unsubstituted heterocyclic group or being substituted with a substituent to which two or more substituents are linked among the substituents exemplified above, or having no substituent. For example, "the substituent to which two or more substituents are linked" may be a biphenyl group. That is, the biphenyl group may also be an aryl group, and may be interpreted as a substituent to which two phenyl groups are linked.

In the present specification, the number of carbon atoms of an imide group is not particularly limited, but is preferably 1 to 30. Specifically, the imide group may be a compound having the following structures, but is not limited thereto.

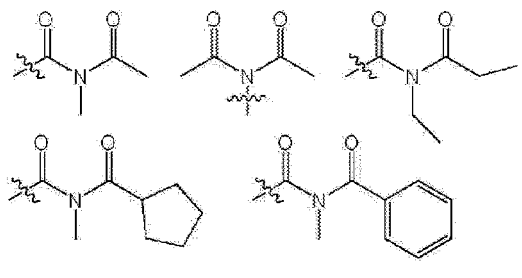

In the present disclosure, for an amide group, one or two nitrogen atoms of the amide group may be substituted with hydrogen, a straight, branched, or cyclic alkyl group having 1 to 30 carbon atoms, or an aryl group having 6 to 30 carbon atoms. Specifically, the amide group may be a compound having the following structural formulae, but is not limited thereto.

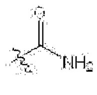 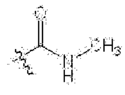 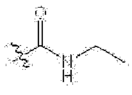 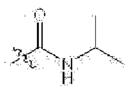 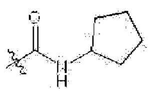

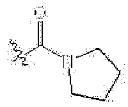 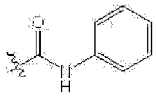 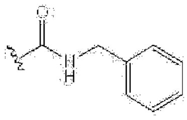 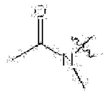 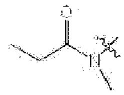

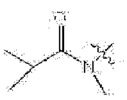 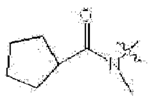 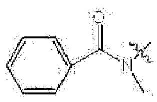 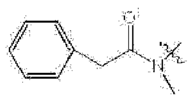

In the present specification, examples of a halogen group include fluorine, chlorine, bromine or iodine.

In the present specification, the alkyl group may be straight or branched, and the number of carbon atoms thereof is not particularly limited, but is preferably 1 to 50. Specific examples thereof include methyl, ethyl, propyl, n-propyl, isopropyl, butyl, n-butyl, isobutyl, tert-butyl, sec-butyl, 1-methyl-butyl, 1-ethyl-butyl, pentyl, n-pentyl, isopentyl, neopentyl, tert-pentyl, hexyl, n-hexyl, 1-methylpentyl, 2-methylpentyl, 4-methyl-2-pentyl, 3,3-dimethylbutyl, 2-ethylbutyl, heptyl, n-heptyl, 1-methylhexyl, cyclopentylmethyl, cyclohexylmethyl, octyl, n-octyl, tert-octyl, 1-methylheptyl, 2-ethylhexyl, 2-propylpentyl, n-nonyl, 2,2-dimethylheptyl, 1-ethyl-propyl, 1,1-dimethyl-propyl, isohexyl, 2-methylpentyl, 4-methylhexyl, 5-methylhexyl, and the like, but are not limited thereto.

In the present specification, a cycloalkyl group is not particularly limited, but the number of carbon atoms thereof is preferably 3 to 60, and specific examples thereof include cyclopropyl, cyclobutyl, cyclopentyl, 3-methylcyclopentyl, 2,3-dimethylcyclopentyl, cyclohexyl, 3-methylcyclohexyl, 4-methylcyclohexyl, 2,3-dimethylcyclohexyl, 3,4,5-trimethylcyclohexyl, 4-tert-butylcyclohexyl, cycloheptyl, cyclooctyl, and the like, but are not limited thereto.

In the present specification, the alkoxy group may be straight, branched, or cyclic. The number of carbon atoms of the alkoxy group is not particularly limited, but is preferably 1 to 20. Specific examples thereof include methoxy, ethoxy, n-propoxy, isopropoxy, i-propyloxy, n-butoxy, isobutoxy, tert-butoxy, sec-butoxy, n-pentyloxy, neopentyloxy, isopentyloxy, n-hexyloxy, 3,3-dimethylbutyloxy, 2-ethylbutyloxy, n-octyloxy, n-nonyloxy, n-decyloxy, benzyloxy, p-methylbenzyloxy, and the like, but are not limited thereto.

In the present disclosure, the alkenyl group may be straight or branched, and the number of carbon atoms thereof is not particularly limited, but is preferably 2 to 40. Specific examples thereof include vinyl, 1-propenyl, isopropenyl, 1-butenyl, 2-butenyl, 3-butenyl, 1-pentenyl, 2-pentenyl, 3-pentenyl, 3-methyl-1-butenyl, 1,3-butadienyl, allyl, 1-phenylvinyl-1-yl, 2-phenylvinyl-1-yl, 2,2-diphenylvinyl-1-yl, 2-phenyl-2-(naphthyl-1-yl)vinyl-1-yl, 2,2-bis(diphenyl-1-yl)vinyl-1-yl, a stilbenyl group, a styrenyl group, and the like, but are not limited thereto.

In the present disclosure, when the aryl group is a monocyclic aryl group, the number of carbon atoms thereof is not particularly limited, but is preferably 6 to 25. Specific examples of the monocyclic aryl group include a phenyl group, a biphenyl group, a terphenyl group, and the like, but are not limited thereto.

In the present disclosure, when the aryl group is a polycyclic aryl group, the number of carbon atoms thereof is not particularly limited, but is preferably 10 to 24. Specific examples of the polycyclic aryl group include a naphthyl group, an anthracenyl group, a phenanthryl group, a pyrenyl group, a perylenyl group, a chrysenyl group, a fluorenyl group, and the like, but are not limited thereto.

In the present disclosure, the fluorenyl group may be substituted, and adjacent substituents may be bonded to each other to form a ring.

When the fluorenyl group is substituted, the substituent may be

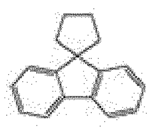, 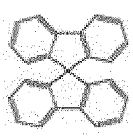, 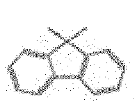, 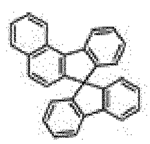, 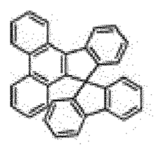

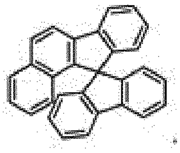,
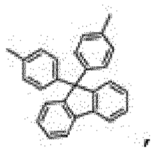,
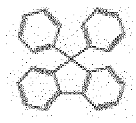

, and the like. However, the substituent is not limited thereto.

In the present disclosure, a heterocyclic group includes one or more atoms other than carbon, that is, a heteroatom, and specifically, the heteroatom may include one or more atoms selected from the group consisting of O, N, Si, Se, S, and the like. The number of carbon atoms of the heterocyclic group is not particularly limited, but is preferably 2 to 60. Examples of the heterocyclic group include a thiophene group, a furan group, a pyrrole group, an imidazole group, a thiazole group, an oxazole group, an oxadiazole group, a triazole group, a pyridyl group, a bipyridyl group, a pyrimidyl group, a triazine group, a triazole group, an acridyl group, a pyridazine group, a pyrazinyl group, a qinolinyl group, a quinazoline group, a quinoxalinyl group, a phthalazinyl group, a pyridopyrimidinyl group, a pyridopyrazinyl group, a pyrazinopyrazinyl group, an isoquinoline group, an indole group, a carbazole group, a benzoxazole group, a benzimidazole group, a benzothiazole group, a benzocarbazole group, a benzothiophene group, a dibenzothiophene group, a benzofuranyl group, a phenanthroline group, an isoxazolyl group, a thiadiazolyl group, a phenothiazinyl group, a dibenzofuranyl group, and the like, but are not limited thereto.

In the present disclosure, the number of carbon atoms of an amine group is not particularly limited, but is preferably 1 to 30. An N atom in the amine group may be substituted with an aryl group, an alkyl group, an arylalkyl group, a heterocyclic group, and the like, and specific examples of the amine group include a methylamine group, a dimethylamine group, an ethylamine group, a diethylamine group, a phenylamine group, a naphthylamine group, a biphenylamine group, an anthracenylamine group, a 9-methyl-anthracenylamine group, a diphenylamine group, a phenylnaphthylamine group, a ditolylamine group, a phenyltolylamine group, a triphenylamine group, and the like, but are not limited thereto.

In the present disclosure, the aryl group in the aryloxy group, the arylthioxy group, and the arylsulfoxy group is the same as the above-described examples of the aryl group. Specifically, examples of the aryloxy group include phenoxy, p-tolyloxy, m-tolyloxy, 3,5-dimethyl-phenoxy, 2,4,6-trimethylphenoxy, p-tert-butylphenoxy, 3-biphenyloxy, 4-biphenyloxy, 1-naphthyloxy, 2-naphthyloxy, 4-methyl-1-naphthyloxy, 5-methyl-2-naphthyloxy, 1-anthryloxy, 2-anthryloxy, 9-anthryloxy, 1-phenanthryloxy, 3-phenanthryloxy, 9-phenanthryloxy, and the like, examples of the arylthioxy group include a phenylthioxy group, a 2-methylphenylthioxy group, a 4-tert-butylphenylthioxy group, and the like, and examples of the arylsulfoxy group include a benzenesulfoxy group, a p-toluenesulfoxy group, and the like, but the examples are not limited thereto.

In the present disclosure, the alkyl group in the alkylthioxy group and the alkylsulfoxy group is the same as the above-described examples of the alkyl group. Specifically, examples of the alkylthioxy group include a methylthioxy group, an ethylthioxy group, a tert-butylthioxy group, a hexylthioxy group, an octylthioxy group, and the like, and examples of the alkylsulfoxy group include mesyl, an ethylsulfoxy group, a propylsulfoxy group, a butylsulfoxy group, and the like, but the examples are not limited thereto.

In an exemplary embodiment of the present disclosure, a1 is 1.

In another exemplary embodiment, a2 is 1.

In an exemplary embodiment of the present specification, R2 is hydrogen.

In another exemplary embodiment, R3 is hydrogen.

In an exemplary embodiment of the present disclosure, one or two or more first units represented by Chemical Formula 1 is or are included.

In an exemplary embodiment of the present disclosure, one or two or more units represented by Chemical Formula 2 is or are included.

In an exemplary embodiment of the present disclosure, the first unit represented by Chemical Formula 1 is represented by the following Chemical Formula 1-1.

[Chemical Formula 1-1]

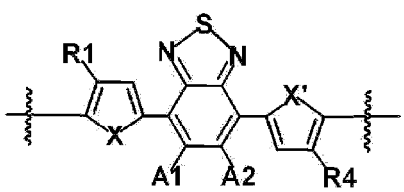

In Chemical Formula 1-1,

X, X', A1, A2, R1, and R4 are the same as those defined in Chemical Formula 1.

In an exemplary embodiment of the present disclosure, X is S.

In another exemplary embodiment, X' is S.

In still another exemplary embodiment, X is Se.

In an exemplary embodiment of the present disclosure, X' is Se.

In an exemplary embodiment of the present specification, A1 is hydrogen.

In another exemplary embodiment, A1 is a halogen group.

In still another exemplary embodiment, A1 is fluorine.

In an exemplary embodiment of the present specification, A2 is hydrogen.

In another exemplary embodiment, A2 is a halogen group.

In still another exemplary embodiment, A2 is fluorine.

In an exemplary embodiment of the present disclosure, the first unit represented by Chemical Formula 1-1 is represented by any one of the following Chemical Formulae 1-1-1 to 1-1-3.

[Chemical Formula 1-1-1]

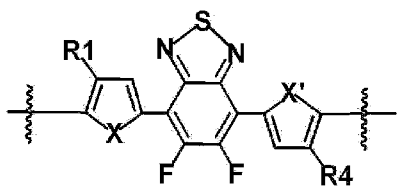

[Chemical Formula 1-1-2]

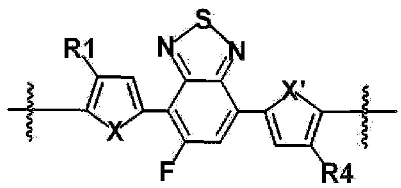

[Chemical Formula 1-1-3]

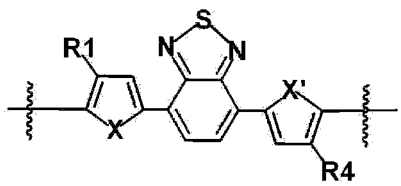

In Chemical Formulae 1-1-1 to 1-1-3,

X, X', R1, and R4 are the same as those described above.

In an exemplary embodiment of the present disclosure, a3 is 0.

In another exemplary embodiment, a3 is 1.

In still another exemplary embodiment, a4 is 0.

In yet another exemplary embodiment, a4 is 1.

In an exemplary embodiment of the present disclosure, the second unit represented by Chemical Formula 2 is represented by the following Chemical Formula 2-1 or 2-2.

[Chemical Formula 2-1]

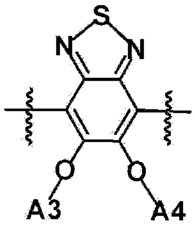

[Chemical Formula 2-2]

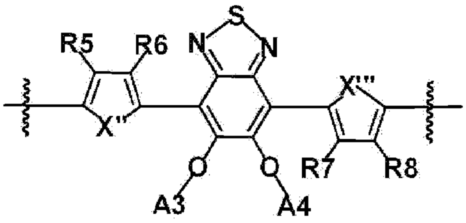

In Chemical Formulae 2-1 and 2-2,

X", X'", R5 to R8, A3, and A4 are the same as those defined in Chemical Formula 2.

In an exemplary embodiment of the present disclosure, a1 to a4 are 0 or 1.

In an exemplary embodiment of the present disclosure, when a1 to a4 are 1, the rotation of a molecule may be prevented, and the planarity may be increased through interaction of S or Se atoms of X to X'" with halogen groups of A1 and A2 or O atoms of Chemical Formula 2.

In an exemplary embodiment of the present disclosure, X" is S.

In another exemplary embodiment, X" is Se.

In an exemplary embodiment of the present disclosure, X"' is S.

In another exemplary embodiment of the present disclosure, X"' is Se.

In an exemplary embodiment of the present disclosure, the polymer further includes a third unit represented by any one of the following Chemical Formula 3.

[Chemical Formula 3]

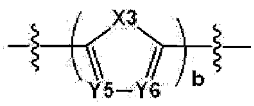
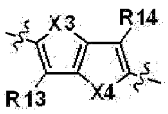
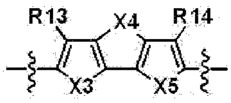

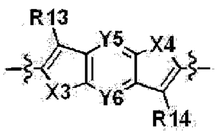
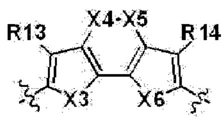

In Chemical Formula 3,

X3 to X6 are the same as or different from each other, and are each independently CR10R11, NR10, O, SiR10R11, PR10, S, GeR10R11, Se, or Te,
Y5 and Y6 are the same as or different from each other, and are each independently CR12, N, SiR12, P, or GeR12,
b is an integer from 1 to 3,
when b is an integer of 2 or more, two or more structures in the parenthesis are the same as or different from each other, and

R10 to R14 are the same as or different from each other, and are each independently hydrogen; deuterium; a halogen group; a hydroxy group; a substituted or unsubstituted alkyl group; a substituted or unsubstituted alkoxy group; a substituted or unsubstituted thioether group; a substituted or unsubstituted aryl group; or a substituted or unsubstituted heterocyclic group.

In an exemplary embodiment of the present disclosure, X3 is S.
In another exemplary embodiment, Y5 is CR12.
In still another exemplary embodiment, Y6 is CR12.
In an exemplary embodiment of the present specification, R12 is hydrogen.
In an exemplary embodiment of the present disclosure, R12 is a halogen group.
In another exemplary embodiment, R12 is fluorine.
In an exemplary embodiment of the present disclosure, X3 is Se.
In another exemplary embodiment, X3 is GeR10R11.
In still another exemplary embodiment of the present disclosure, X4 is S.
In an exemplary embodiment of the present disclosure, X4 is Se.
In another exemplary embodiment, X4 is Ge R10R11.
In still another exemplary embodiment, X4 is NR10.
In an exemplary embodiment of the present disclosure, X4 is SiR10R11.
In another exemplary embodiment, X4 is CR10R11.
In an exemplary embodiment of the present disclosure, X4 is GeR10R11.
In another exemplary embodiment, X4 is CR10R11.
In an exemplary embodiment of the present disclosure, X5 is S.
In an exemplary embodiment of the present disclosure, X5 is O.
In an exemplary embodiment of the present disclosure, X6 is S.
In an exemplary embodiment of the present disclosure, Y5 is CR12.
In another exemplary embodiment, Y6 is CR12.
In an exemplary embodiment of the present disclosure, the polymer further includes a third unit represented by any one of the following Chemical Formula 3-1.

[Chemical Formula 3-1]

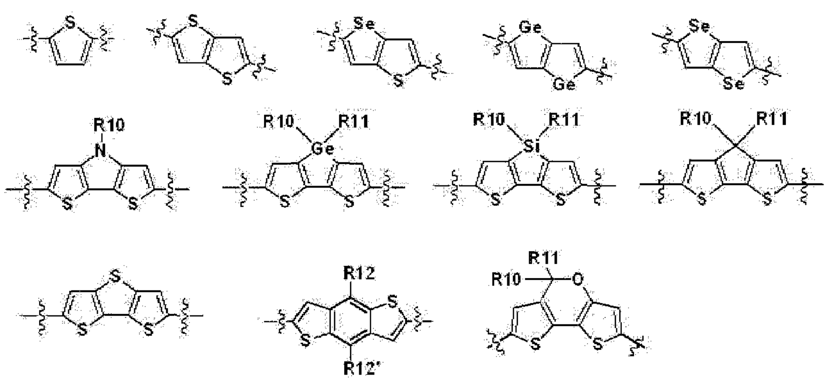

In Chemical Formula 3-1, R10, R11, and R12 are the same as those described above,
R12' is the same as the definition of R12, and
the structures of Chemical Formula 3-1 may be each independently additionally unsubstituted or substituted with a substituent selected from the group consisting of deuterium; a halogen group; a hydroxy group; a substituted or unsubstituted alkyl group; a substituted or unsubstituted alkoxy group; a substituted or unsubstituted thioether group; a substituted or unsubstituted aryl group; and a substituted or unsubstituted heterocyclic group.
In an exemplary embodiment of the present disclosure, the polymer including the first unit and the second unit is an alternate polymer.
In another exemplary embodiment, the polymer including the first unit and the second unit is a random polymer.
In an exemplary embodiment of the present disclosure, the polymer includes a unit represented by any one of the following Chemical Formulae 4 to 7.

[Chemical Formula 4]

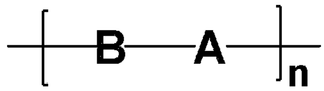

[Chemical Formula 5]

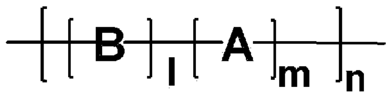

[Chemical Formula 6]

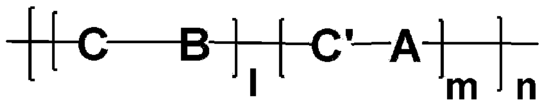

[Chemical Formula 7]

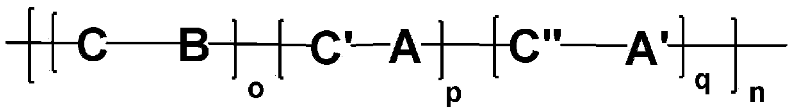

In Chemical Formulae 4 to 7,

A and A' are the same as or different from each other, and are each independently the first unit represented by Chemical Formula 1,
B is the second unit represented by Chemical Formula 2,
C, C', and C" are the same as or different from each other, and are each independently a third unit represented by any one of the following Chemical Formula 3,

[Chemical Formula 3]

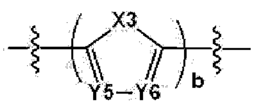 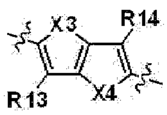 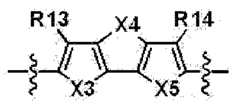

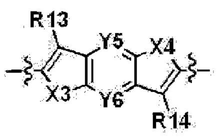 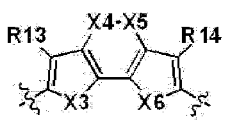

in Chemical Formula 3,

X3 to X6 are the same as or different from each other, and are each independently CR10R11, NR10, O, SiR10R11, PR10, S, GeR10R11, Se, or Te,
Y5 and Y6 are the same as or different from each other, and are each independently CR12, N, SiR12, P, or GeR12,
b is an integer from 1 to 3,
when b is an integer of 2 or more, two or more structures in the parenthesis are the same as or different from each other,
R10 to R14 are the same as or different from each other, and are each independently hydrogen; deuterium; a

halogen group; a hydroxy group; a substituted or unsubstituted alkyl group; a substituted or unsubstituted alkoxy group; a substituted or unsubstituted thioether group; a substituted or unsubstituted aryl group; or a substituted or unsubstituted heterocyclic group,
l is a molar ratio and $0 < l < 1$,
m is a molar ratio and $0 < m < 1$,
o is a molar ratio and $0 < o < 1$,
p is a molar ratio and $0 < p < 1$,
q is a molar ratio and $0 < q < 1$,
$l + m = 1$,
$o + p + q = 1$, and
n is a repeating number of the unit, and an integer from 1 to 10,000.

In the present disclosure, a polymer including the unit represented by Chemical Formula 4 may constitute an alternate polymer by including a unit composed only of the first unit and the second unit.

In the present disclosure, a polymer including the unit represented by Chemical Formula 5 may constitute a random polymer by including a unit composed only of the first unit and the second unit, and the contents of the first unit and the second unit may be adjusted according to the molar ratio of l and m.

In the present disclosure, a polymer including the unit represented by Chemical Formula 6 may constitute a random polymer by further including an additional unit in addition to the first unit and the second unit.

In the present disclosure, a polymer including the unit represented by Chemical Formula 7 may constitute a random polymer by further including an additional unit in addition to the first unit and the second unit, which are the same as or different from each other.

In an exemplary embodiment of the present disclosure, the unit represented by Chemical Formula 4 is represented by the following Chemical Formula 4-1.

In another exemplary embodiment, the unit represented by Chemical Formula 5 is represented by the following Chemical Formula 5-1.

In an exemplary embodiment of the present disclosure, the unit represented by Chemical Formula 6 is represented by the following Chemical Formula 6-1.

In an exemplary embodiment of the present disclosure, the unit represented by Chemical Formula 7 is represented by the following Chemical Formula 7-1.

According to the invention, the polymer consists of a unit represented by any one of the following Chemical Formula 4-1, Chemical Formula 5-1, Chemical Formula 6-1, and Chemical Formula 7-1.

[Chemical Formula 4-1]

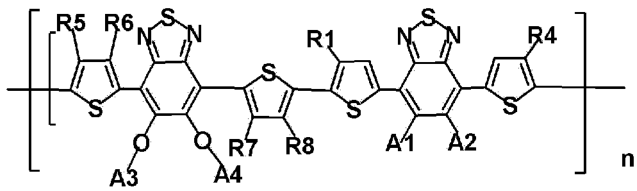

[Chemical Formula 5-1]

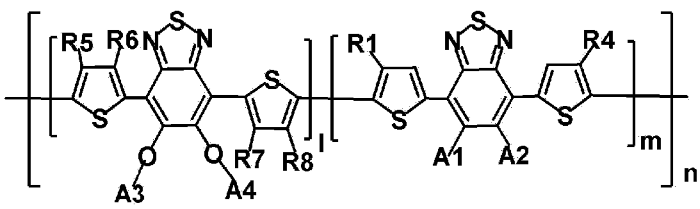

[Chemical Formula 6-1]

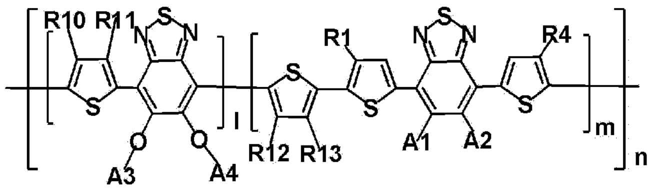

[Chemical Formula 7-1]

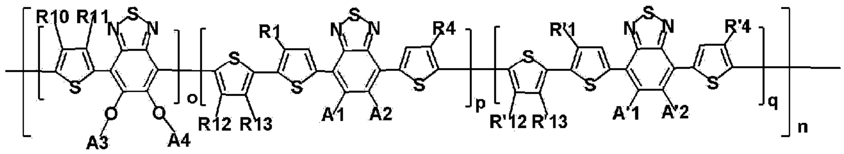

In Chemical Formula 4-1, Chemical Formula 5-1, Chemical Formula 6-1, and Chemical Formula 7-1,

A1, A2, A'1 and A'2 are the same as or different from each other, and are each independently hydrogen; or fluorine,
A3 and A4 are the same as or different from each other, and are each independently a substituted or unsubstituted alkyl group,
R1, R4 to R8, R'1, R'4, R10 to R13, R'12, and R'13 are the same as or different from each other, and are each independently hydrogen; or a substituted or unsubstituted alkyl group,
l is a molar ratio and $0 < l < 1$,
m is a molar ratio and $0 < m < 1$,
o is a molar ratio and $0 < o < 1$,
p is a molar ratio and $0 < p < 1$,
q is a molar ratio and $0 < q < 1$,
$l + m = 1$,
$o + p + q = 1$, and
n is a repeating number of the unit, and an integer from 1 to 10,000
wherein the polymer has a number average molecular weight of 5,000 g/mol to 1,000,000 g/mol, and wherein the number average molecular weight is measured by GPC..

In an exemplary embodiment of the present specification, Ar3 and Ar4 are the same as or different from each other, and each independently a substituted or unsubstituted alkyl group.
In another exemplary embodiment, A3 and A4 are the same as or different from each other, and are each independently a substituted or unsubstituted alkyl group having 1 to 30 carbon atoms.
In an exemplary embodiment of the present specification, A3 and A4 are a substituted or unsubstituted dodecyl group.
In an exemplary embodiment of the present specification, A3 and A4 are a substituted or unsubstituted octyl group.
In an exemplary embodiment of the present specification, A3 and A4 are a substituted or unsubstituted hexyl group.
In an exemplary embodiment of the present specification, A3 and A4 are a substituted or unsubstituted butyl group.
In an exemplary embodiment of the present specification, A3 is a dodecyl group.
In an exemplary embodiment of the present specification, A4 is a dodecyl group.
In an exemplary embodiment of the present specification, A3 is an n-dodecyl group.
In an exemplary embodiment of the present specification, A4 is an n-dodecyl group.
In an exemplary embodiment of the present specification, A3 is an octyl group.
In an exemplary embodiment of the present specification, A4 is an octyl group.
In an exemplary embodiment of the present specification, A3 is an n-octyl group.
In an exemplary embodiment of the present specification, A4 is an n-octyl group.

In an exemplary embodiment of the present specification, A3 is a hexyl group.
In an exemplary embodiment of the present specification, A4 is a hexyl group.
In an exemplary embodiment of the present specification, A3 is an n-hexyl group.
In an exemplary embodiment of the present specification, A4 is an n-hexyl group.
In an exemplary embodiment of the present specification, A3 is a butyl group.
In an exemplary embodiment of the present specification, A4 is a butyl group.
In an exemplary embodiment of the present specification, A3 is an n-butyl group.
In an exemplary embodiment of the present specification, A4 is an n-butyl group.
In an exemplary embodiment of the present specification, R1 and R4 are the same as or different from each other, and are each independently a substituted or unsubstituted alkyl group.
In an exemplary embodiment of the present specification, R1 and R4 are the same as or different from each other, and are each independently a substituted or unsubstituted alkyl group having 1 to 30 carbon atoms.
In an exemplary embodiment of the present specification, R1 and R4 are the same as or different from each other, and are each independently a substituted or unsubstituted straight or branched alkyl group having 1 to 30 carbon atoms.
In an exemplary embodiment of the present specification, R1 and R4 are the same as or different from each other, and are each independently a substituted or unsubstituted 2-ethylhexyl group.
In an exemplary embodiment of the present specification, R1 and R4 are the same as or different from each other, and are each independently a substituted or unsubstituted 2-octyldodecyl group.
In an exemplary embodiment of the present specification, R1 and R4 are the same as or different from each other, and are each independently a substituted or unsubstituted 2-ethyldecyl group.
In an exemplary embodiment of the present specification, R1 and R4 are the same as or different from each other, and are each independently a substituted or unsubstituted 2-butyloctyl group.
In an exemplary embodiment of the present specification, R1 is a 2-ethylhexyl group.
In another exemplary embodiment, R4 is a 2-ethylhexyl group.
In an exemplary embodiment of the present specification, R1 is a 2-octyldodecyl group.
In another exemplary embodiment, R4 is a 2-octyldodecyl group.
In an exemplary embodiment of the present specification, R1 is a 2-ethyldecyl group.
In another exemplary embodiment, R4 is a 2-ethyldecyl group.
In an exemplary embodiment of the present specification, R1 is a 2-butyloctyl group.
In another exemplary embodiment, R4 is a 2-butyloctyl group.
In an exemplary embodiment of the present specification, R5 is hydrogen.
In another exemplary embodiment, R5 is a halogen group.
In an exemplary embodiment of the present specification, R6 is hydrogen.
In an exemplary embodiment of the present specification, R7 is hydrogen.
In an exemplary embodiment of the present specification, R8 is hydrogen.
In an exemplary embodiment of the present specification, R10 is hydrogen.
In an exemplary embodiment of the present specification, R11 is hydrogen.
In an exemplary embodiment of the present specification, R12 is hydrogen.
In an exemplary embodiment of the present specification, R13 is hydrogen.
In an exemplary embodiment of the present specification, A'1 is hydrogen.
In another exemplary embodiment, A'1 is fluorine.
In an exemplary embodiment of the present specification, A'2 is hydrogen.
In another exemplary embodiment, A'2 is fluorine.
In an exemplary embodiment of the present specification, R'1 and R'4 are the same as or different from each other, and are each independently a substituted or unsubstituted alkyl group.
In an exemplary embodiment of the present specification, R'1 and R'4 are the same as or different from each other, and are each independently a substituted or unsubstituted alkyl group having 1 to 30 carbon atoms.
In an exemplary embodiment of the present specification, R'1 and R'4 are the same as or different from each other, and are each independently a substituted or unsubstituted straight or branched alkyl group having 1 to 30 carbon atoms.
In an exemplary embodiment of the present specification, R'1 and R'4 are the same as or different from each other, and are each independently a substituted or unsubstituted 2-ethylhexyl group.
In an exemplary embodiment of the present specification, R'1 and R'4 are the same as or different from each other, and are each independently a substituted or unsubstituted 2-octyldodecyl group.
In an exemplary embodiment of the present specification, R'1 and R'4 are the same as or different from each other, and are each independently a substituted or unsubstituted 2-ethyldecyl group.
In an exemplary embodiment of the present specification, R'1 and R'4 are the same as or different from each

other, and are each independently a substituted or unsubstituted 2-butyloctyl group.

In an exemplary embodiment of the present specification, R'1 is a 2-ethylhexyl group.

In another exemplary embodiment, R'4 is a 2-ethylhexyl group.

In an exemplary embodiment of the present specification, R'1 is a 2-octyldodecyl group.

In another exemplary embodiment, R'4 is a 2-octyldodecyl group.

In an exemplary embodiment of the present specification, R'1 is a 2-ethyldecyl group.

In another exemplary embodiment, R'4 is a 2-ethyldecyl group.

In an exemplary embodiment of the present specification, R'1 is a 2-butyloctyl group.

In another exemplary embodiment, R'4 is a 2-butyloctyl group.

In an exemplary embodiment of the present specification, R'12 is hydrogen.

In an exemplary embodiment of the present specification, R'13 is hydrogen.

In an exemplary embodiment of the present specification, the polymer includes a unit represented by any one of the following Chemical Formulae 4-1-1 to 4-1-10, Chemical Formulae 5-1-1 to 5-1-3, Chemical Formulae 6-1-1 to 6-1-14, and Chemical Formulae 7-1-1 to 7-1-5.

[Chemical Formula 4-1-1]

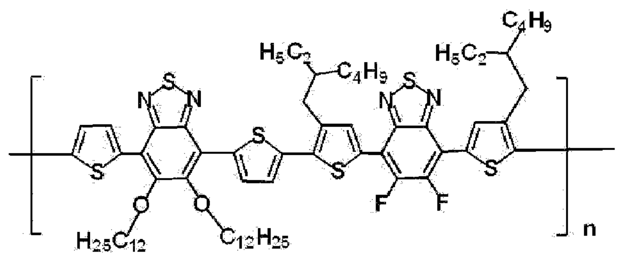

[Chemical Formula 4-1-2]

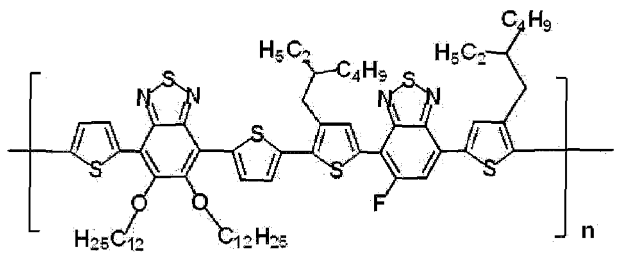

[Chemical Formula 4-1-3]

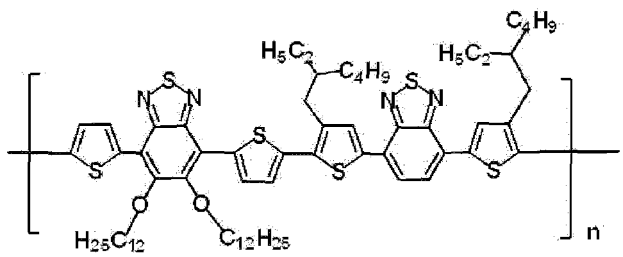

[Chemical Formula 4-1-4]

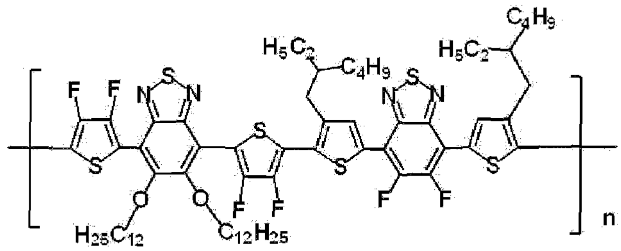

[Chemical Formula 4-1-5]

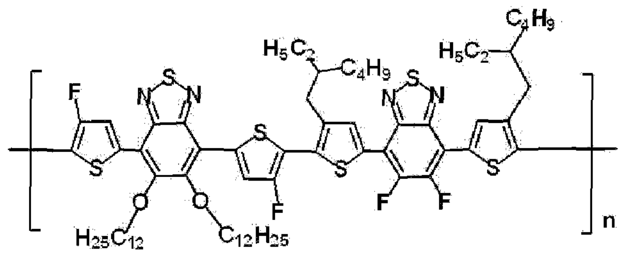

[Chemical Formula 4-1-6]

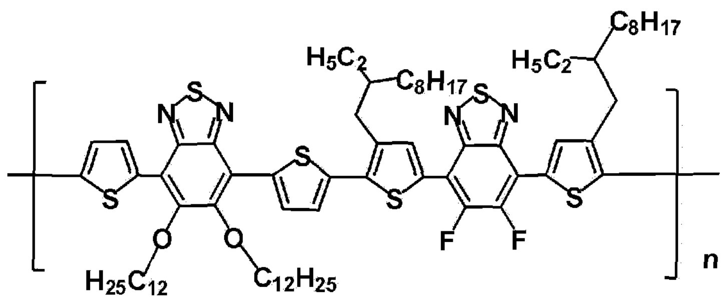

[Chemical Formula 4-1-7]

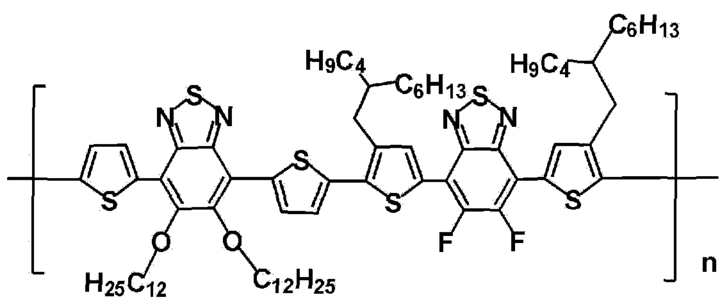

[Chemical Formula 4-1-8]

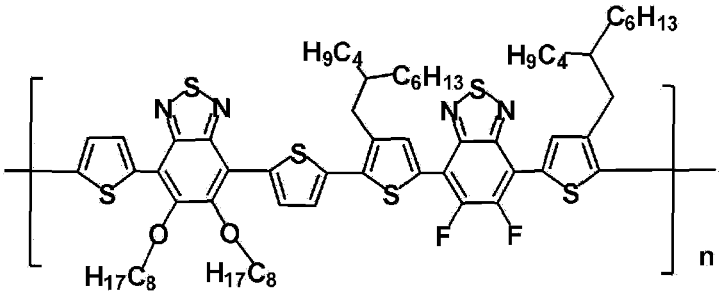

[Chemical Formula 4-1-9]

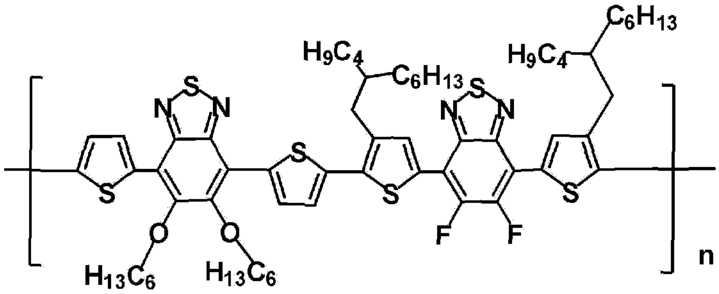

[Chemical Formula 4-1-10]

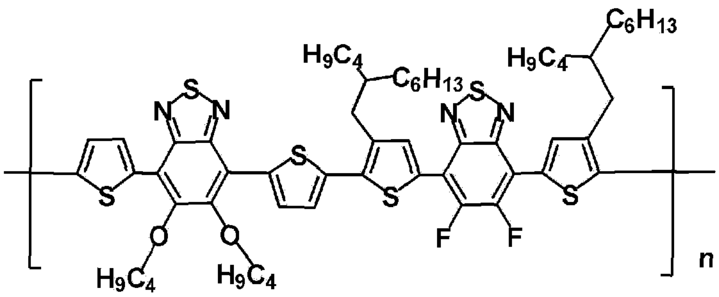

[Chemical Formula 5-1-1]

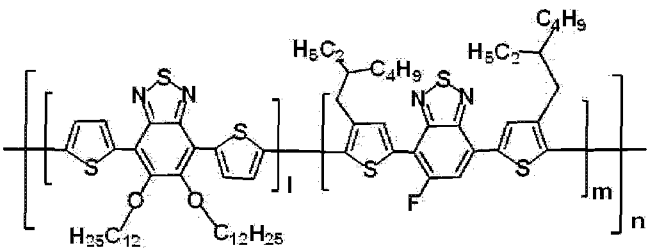

[Chemical Formula 5-1-2]

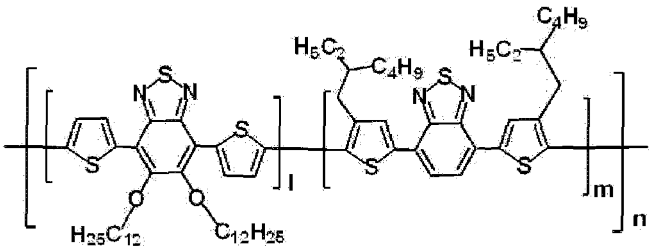

[Chemical Formula 5-1-3]

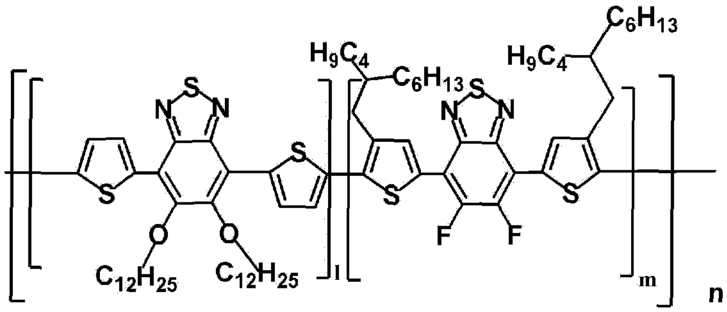

[Chemical Formula 6-1-1]

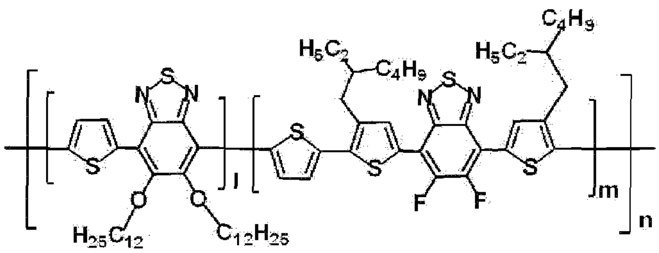

[Chemical Formula 6-1-2]

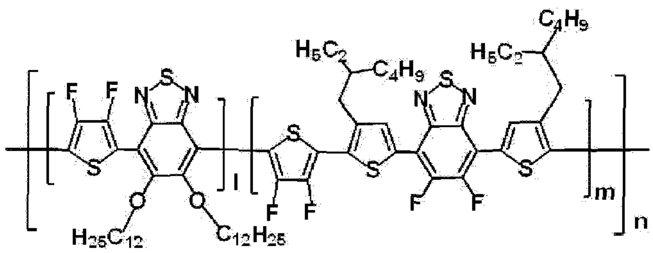

[Chemical Formula 6-1-3]

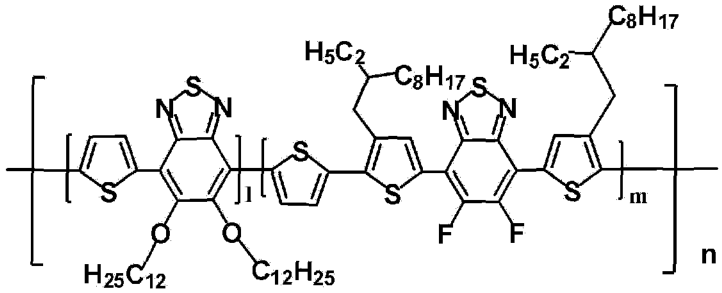

[Chemical Formula 6-1-4]

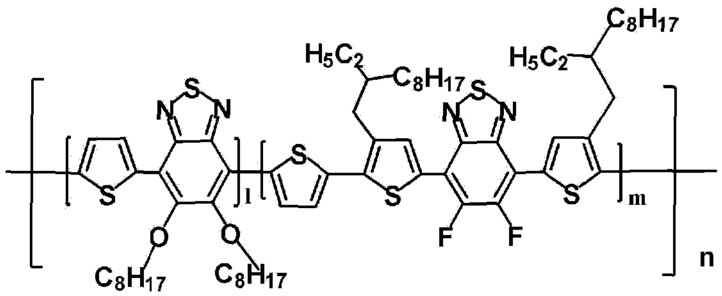

[Chemical Formula 6-1-5]

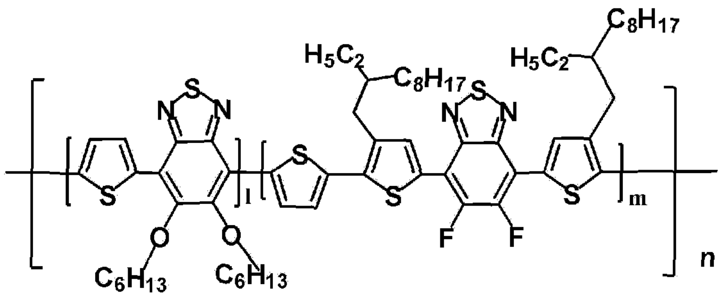

[Chemical Formula 6-1-6]

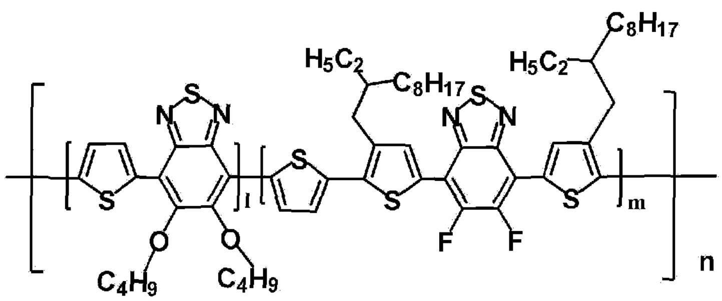

[Chemical Formula 6-1-7]

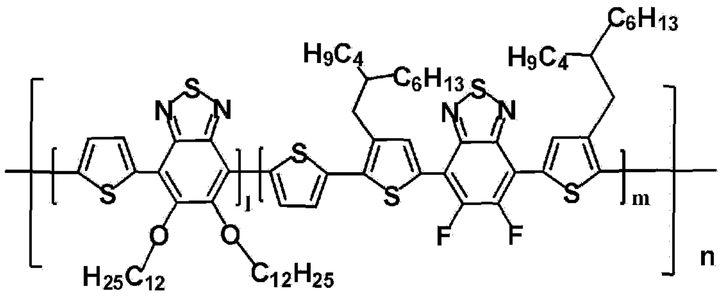

[Chemical Formula 6-1-8]

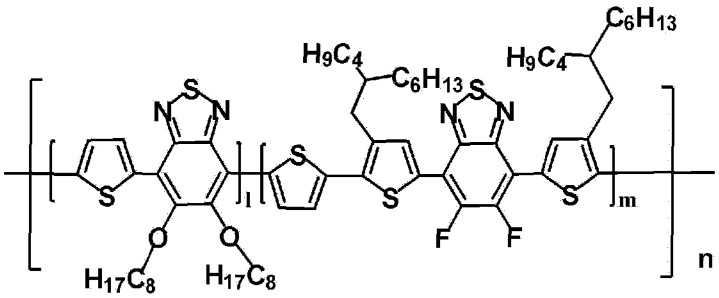

[Chemical Formula 6-1-9]

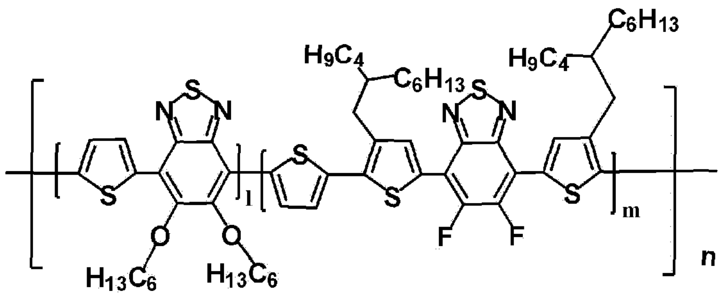

[Chemical Formula 6-1-10]

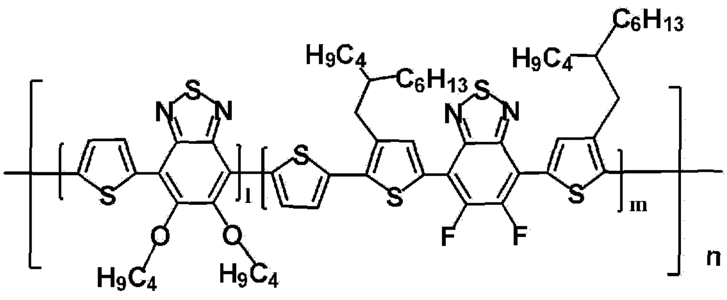

[Chemical Formula 6-1-11]

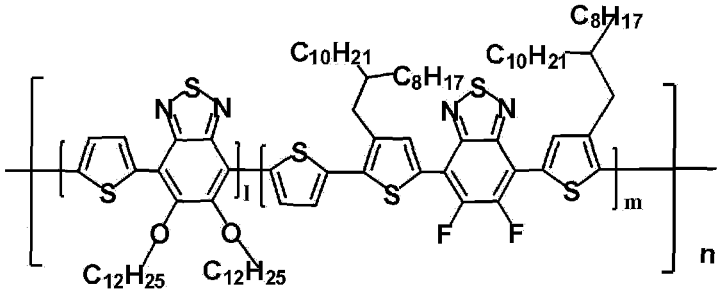

[Chemical Formula 6-1-12]

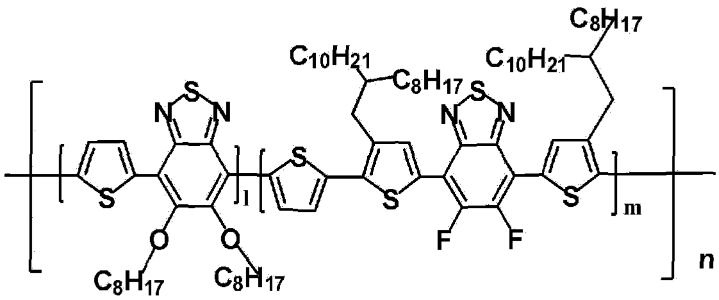

[Chemical Formula 6-1-13]

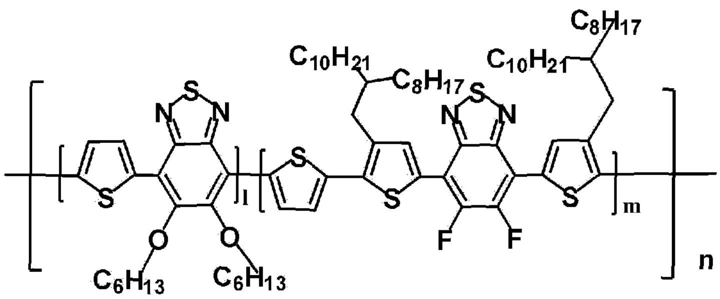

[Chemical Formula 6-1-14]

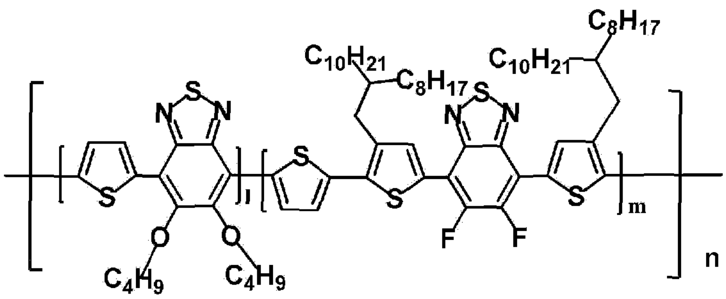

[Chemical Formula 7-1-1]

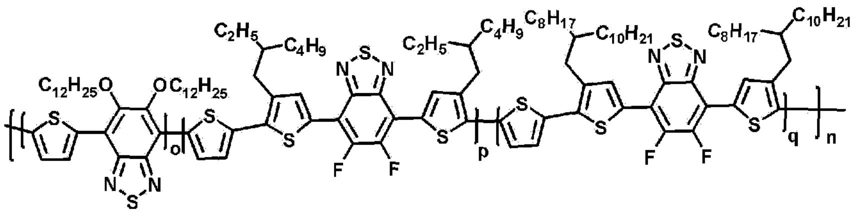

[Chemical Formula 7-1-2]

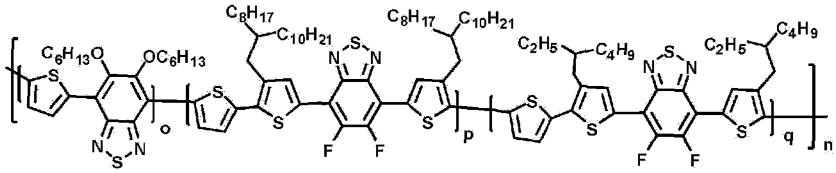

[Chemical Formula 7-1-3]

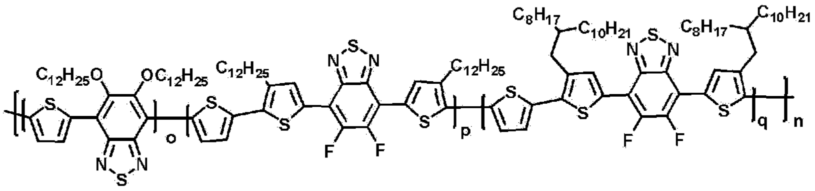

[Chemical Formula 7-1-4]

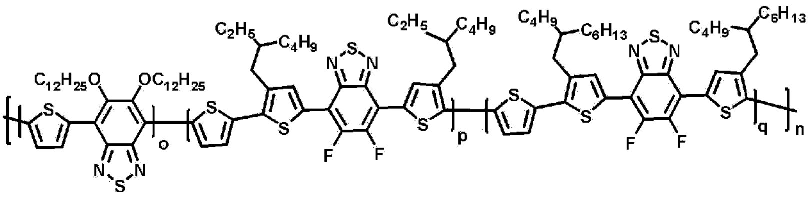

[Chemical Formula 7-1-5]

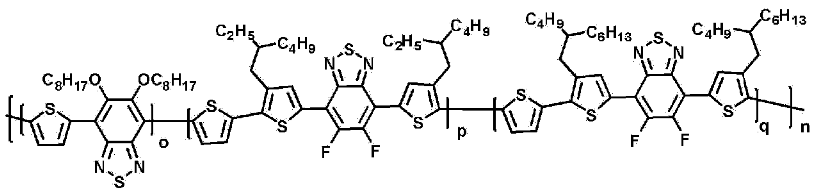

In Chemical Formulae 4-1-1 to 4-1-10, Chemical Formulae 5-1-1 to 5-1-3, Chemical Formulae 6-1-1 to 6-1-14, and Chemical Formulae 7-1-1 to 7-1-5,

l is a molar ratio and $0 < l < 1$,
m is a molar ratio and $0 < m < 1$,
o is a molar ratio and $0 < o < 1$,

p is a molar ratio and $0 < p < 1$,
q is a molar ratio and $0 < q < 1$,
$l + m = 1$,
$o + p + q = 1$, and
n is a repeating number of the unit, and an integer from 1 to 10,000.

In an exemplary embodiment of the present specification, l is 0.5.
In another exemplary embodiment, l is 0.6.
In an exemplary embodiment of the present specification, m is 0.5.
In another exemplary embodiment, m is 0.4.
In an exemplary embodiment of the present specification, o is 0.5.
In an exemplary embodiment of the present specification, p is 0.4.
In another exemplary embodiment, p is 0.35.
In still another exemplary embodiment, p is 0.3.
In yet another exemplary embodiment, p is 0.25.
In still yet another exemplary embodiment, p is 0.2.
In a further exemplary embodiment, p is 0.15.
In an exemplary embodiment of the present specification, q is 0.1.
In another exemplary embodiment, q is 0.15.
In still another exemplary embodiment, q is 0.2.
In yet another exemplary embodiment, q is 0.25.
In still yet another exemplary embodiment, q is 0.3.
In a further exemplary embodiment, q is 0.35.
In an exemplary embodiment of the present specification, the HOMO energy level is 5 eV to 5.9 eV.
In the present specification, the HOMO energy level was measured by means of a cyclic voltammetry which is an electrochemical method, and the LUMO energy level was measured as a difference between energy band gaps emitted from the HOMO energy to the UV edge.
Specifically, the cyclic voltammetry is composed of a working electrode which is a carbon electrode, a reference electrode, and a counter electrode which is a platinum plate, and is a method which measures electric current flowing in the electrodes while allowing the electric potential to fluctuate at a constant rate according to the time. The calculation equation of HOMO and LUMO is as follows.

[Equation]

$$\text{HOMO (or LUMO) (eV)} = -4.8-(E_{onset} - E_{1/2(Ferrocene)})$$

In an exemplary embodiment of the present specification, the polymer has a solubility of 0.1 wt% to 20 wt% for chlorobenzene. The measurement of the solubility may mean a value measured at room temperature.
In one exemplary embodiment of the present specification, as an end group of the polymer, a trifluoro-benzene group and/or 4-bromodiphenyl ether are/is used, but in general, an end group publicly known may be modified and used according to the need of a person with ordinary skill in the art, and the end group is not limited.
According to the present invention, the polymer has a number average molecular weight of preferably 5,000 g/mol to 1,000,000 g/mol.
According to an exemplary embodiment of the present specification, the polymer may have a molecular weight distribution of 1 to 10. Preferably, the polymer has a molecular weight distribution of 1 to 3.
Further, the number average molecular weight is preferably 100,000 or less so that the polymer has predetermined or more solubility, and thus, a solution application method is advantageously applied.
The polymer according to the present specification may be prepared by a multi-step chemical reaction.
Monomers are prepared through an alkylation reaction, a Grignard reaction, a Suzuki coupling reaction, a Stille coupling reaction, and the like, and then final polymers may be prepared through a carbon-carbon coupling reaction such as a Stille coupling reaction. When a substituent to be introduced is a boronic acid or boronic ester compound, the final polymers may be prepared through a Suzuki coupling reaction, and when a substituent to be introduced is a tributyltin or trimethyltin compound, the final polymers may be prepared through a Stille coupling reaction, but the method is not limited thereto.
An exemplary embodiment of the present specification provides an organic solar cell including: a first electrode; a second electrode which is disposed to face the first electrode; and an organic material layer having one or more layers which is disposed between the first electrode and the second electrode and includes a photoactive layer, in which one

or more layers of the organic material layer include the polymer.

When one member is disposed "on" another member in the present specification, this includes not only a case where the one member is brought into contact with another member, but also a case where still another member is present between the two members.

The organic solar cell according to an exemplary embodiment of the present specification includes a first electrode, a photoactive layer, and a second electrode. The organic solar cell may further include a substrate, a hole transporting layer, and/or an electron transporting layer.

In an exemplary embodiment of the present specification, when the organic solar cell accepts a photon from an external light source, an electron and a hole are generated between an electron donor and an electron acceptor. The generated hole is transported to a positive electrode through an electron donor layer.

In an exemplary embodiment of the present specification, the organic material layer includes a hole transporting layer, a hole injection layer, or a layer which simultaneously transports and injects holes, and the hole transporting layer, the hole injection layer, or the layer which simultaneously transports and injects holes includes the polymer.

In another exemplary embodiment, the organic material layer includes an electron injection layer, an electron transporting layer, or a layer which simultaneously injects and transports electrons, and the electron injection layer, the electron transporting layer, or the layer which simultaneously injects and transports electrons includes the polymer.

FIG. 1 is a view illustrating an organic solar cell according to an exemplary embodiment of the present specification.

In an exemplary embodiment of the present specification, when the organic solar cell accepts a photon from an external light source, an electron and a hole are generated between an electron donor and an electron acceptor. The generated hole is transported to a positive electrode through an electron donor layer.

In an exemplary embodiment of the present specification, the organic solar cell may further include an additional organic material layer. The organic solar cell may reduce the number of organic material layers by using an organic material which simultaneously has various functions.

In an exemplary embodiment of the present specification, the first electrode is an anode, and the second electrode is a cathode. In another exemplary embodiment, the first electrode is a cathode, and the second electrode is an anode.

In an exemplary embodiment of the present specification, in the organic solar cell, a cathode, a photoactive layer, and an anode may be arranged in this order, and an anode, a photoactive layer, and a cathode may be arranged in this order, but the arrangement order is not limited thereto.

In another exemplary embodiment, in the organic solar cell, an anode, a hole transporting layer, a photoactive layer, an electron transporting layer, and a cathode may also be arranged in this order, and a cathode, an electron transporting layer, a photoactive layer, a hole transporting layer, and an anode may also be arranged in this order, but the arrangement order is not limited thereto.

In an exemplary embodiment of the present specification, the organic solar cell has a normal structure. The normal structure may mean that an anode is formed on a substrate. Specifically, according to an exemplary embodiment of the present specification, when the organic solar cell has a normal structure, a first electrode to be formed on a substrate may be an anode.

In an exemplary embodiment of the present specification, the organic solar cell has an inverted structure. The inverted structure may mean that a cathode is formed on a substrate. Specifically, according to an exemplary embodiment of the present specification, when the organic solar cell has an inverted structure, a first electrode to be formed on a substrate may be a cathode.

In an exemplary embodiment of the present specification, the organic solar cell has a tandem structure. In this case, the organic solar cell may include a photoactive layer having two or more layers. In the organic solar cell according to an exemplary embodiment of the present specification, a photoactive layer may have one layer or two or more layers.

In another exemplary embodiment, a buffer layer may be disposed between a photoactive layer and a hole transporting layer, or between a photoactive layer and an electron transporting layer. In this case, a hole injection layer may be further disposed between an anode and a hole transporting layer. Further, an electron injection layer may be further disposed between a cathode and an electron transporting layer.

In an exemplary embodiment of the present specification, the photoactive layer includes one or two or more selected from the group consisting of an electron donor and an electron acceptor, and the electron donor includes the polymer.

In an exemplary embodiment of the present specification, the electron acceptor material may be selected from the group consisting of fullerene, fullerene derivatives, bathocuproine, semi-conducting elements, semi-conducting compounds, and combinations thereof. Specifically, the electron acceptor material is one or two or more compounds selected from the group consisting of fullerene, fullerene derivatives ((6,6)-phenyl-C61-butyric acid-methylester (PCBM) or (6,6)-phenyl-C61-butyric acid-cholesteryl ester (PCBCR)), perylene, polybenzimidazole (PBI), and 3,4,9,10-perylene-tetracarboxylic bis-benzimidazole (PTCBI).

In an exemplary embodiment of the present specification, the electron donor and the electron acceptor constitute a bulk heterojunction (BHJ).

The bulk heterojunction means that an electron donor material and an electron acceptor material are mixed with each other in a photoactive layer.

In an exemplary embodiment of the present specification, the photoactive layer further includes an additive.

In an exemplary embodiment of the present specification, the additive has a molecular weight of 50 g/mol to 1,000 g/mol.

In another exemplary embodiment, the additive is an organic material having a boiling point of 30°C to 300°C.

In the present specification, the organic material means a material including at least one or more carbon atoms.

In one exemplary embodiment, the additive may further include one or two additives among additives selected from the group consisting of 1,8-diiodooctane (DIO), 1-chloronaphthalene (1-CN), diphenylether (DPE), octane dithiol, and tetrabromothiophene.

For smoothly separating excitons from the organic solar cell and effectively transporting separated electric charges, the interface between the electron donor and the electron acceptor needs to be maximally increased, but it is required to induce an improvement in the morphology by securing a continuous channel of the electron donor and the electron acceptor through a suitable phase separation.

According to an exemplary embodiment of the present specification, an additive is introduced into an active layer, thereby inducing a selective solubility of a polymer and a fullerene derivative for the additive and an effective phase separation induced by a difference in a boiling point between the solvent and the additive. Further, the morphology is fixed by cross-linking an electron acceptor material or an electron donor material, so that the phase separation may be allowed not to occur, and the morphology may be controlled by changing the molecular structure of the electron donor material.

Additionally, the morphology may be improved by controlling the stereoregularity of the electron donor material, and the morphology may be improved through a post-treatment such as a heat treatment at high temperature. Through this, the orientation and crystallization of the polymer according to an exemplary embodiment of the present specification may be induced, and the contact with an electrode is facilitated by increasing the roughness of a photoactive layer, and as a result, an effective movement of electric charges may be induced.

In an exemplary embodiment of the present specification, the photoactive layer has a bilayer thin film structure including an n-type organic material layer and a p-type organic material layer, and the p-type organic material layer includes the polymer.

In the present specification, the substrate may be a glass substrate or a transparent plastic substrate having excellent transparency, surface smoothness, ease of handling, and waterproofing properties, but is not limited thereto, and the substrate is not limited as long as the substrate is typically used in the organic solar cell. Specific examples thereof include glass or polyethylene terephthalate (PET), polyethylene naphthalate (PEN), polypropylene (PP), polyimide (PI), triacetyl cellulose (TAC), and the like, but are not limited thereto.

The anode electrode may be made of a material which is transparent and has excellent conductivity, but is not limited thereto. Examples thereof include: a metal such as vanadium, chromium, copper, zinc, and gold, or an alloy thereof; a metal oxide such as zinc oxide, indium oxide, indium tin oxide (ITO), and indium zinc oxide (IZO); a combination of a metal and an oxide, such as ZnO:Al or $SnO_2$:Sb; a conductive polymer such as poly(3-methylthiophene), poly[3,4-(ethylene-1,2-dioxy)thiophene] (PEDOT), polypyrrole, and polyaniline, and the like, but are not limited thereto.

A method of forming the anode electrode is not particularly limited, but the anode electrode may be formed, for example, by being applied onto one surface of a substrate using sputtering, e-beam, thermal deposition, spin coating, screen printing, inkjet printing, doctor blade, or a gravure printing method, or by being coated in the form of a film.

When the anode electrode is formed on a substrate, the anode electrode may be subjected to processes of cleaning, removing moisture, and hydrophilic modification.

For example, a patterned ITO substrate is sequentially cleaned with a cleaning agent, acetone, and isopropyl alcohol (IPA), and then dried on a heating plate at 100°C to 150°C for 1 to 30 minutes, preferably at 120°C for 10 minutes in order to remove moisture, and when the substrate is completely cleaned, the surface of the substrate is hydrophilically modified.

Through the surface modification as described above, the junction surface potential may be maintained at a level suitable for a surface potential of a photoactive layer. Further, during the modification, a polymer thin film may be easily formed on an anode electrode, and the quality of the thin film may also be improved.

Examples of a pre-treatment technology for an anode electrode include a) a surface oxidation method using a parallel plate-type discharge, b) a method of oxidizing a surface through ozone produced by using UV (ultraviolet) rays in a vacuum state, c) an oxidation method using oxygen radicals produced by plasma, and the like.

One of the methods may be selected depending on the state of an anode electrode or a substrate. However, even though any method is used, it is preferred to commonly prevent oxygen from leaving from the surface of the anode electrode or the substrate, and maximally suppress moisture and organic materials from remaining. In this case, it is

possible to maximize a substantial effect of the pre-treatment.

As a specific example, it is possible to use a method of oxidizing a surface through ozone produced by using UV. In this case, a patterned ITO substrate after being ultrasonically cleaned is baked on a hot plate and dried well, and then introduced into a chamber, and the patterned ITO substrate may be cleaned by ozone generated by reacting an oxygen gas with UV light by operating a UV lamp.

However, the surface modification method of the patterned ITO substrate in the present specification need not be particularly limited, and any method may be used as long as the method is a method of oxidizing a substrate.

The cathode electrode may be a metal having a low work function, but is not limited thereto. Specific examples thereof include: a metal such as magnesium, calcium, sodium, potassium, titanium, indium, yttrium, lithium, gadolinium, aluminum, silver, tin, and lead, or an alloy thereof; and a multi-layer structured material such as LiF/Al, $LiO_2$/Al, LiF/Fe, Al:Li, Al:$BaF_2$, and Al:$BaF_2$:Ba, but are not limited thereto.

The cathode electrode may be deposited and formed in a thermal evaporator showing a vacuum degree of 5 x $10^{-7}$ torr or less, but the forming method is not limited only to this method.

The hole transporting layer and/or electron transporting layer materials serve to efficiently transfer electrons and holes separated from a photoactive layer to an electrode, and the materials are not particularly limited.

The hole transporting layer material may be poly(3,4-ethylenedioxythiophene)-poly(styrenesulfonate)} (PEDOT:PSS) and molybdenum oxide ($MoO_x$) ; vanadium oxide ($V_2O_5$); nickel oxide (NiO); and tungsten oxide ($WO_x$) , and the like, but is not limited thereto.

The electron transporting layer material may be electron-extracting metal oxides, and specific examples thereof include: metal complexes of 8-hydroxyquinoline; complexes including $Alq_3$; metal complexes including Liq; LiF; Ca; titanium oxide ($TiO_x$); zinc oxide (ZnO); and cesium carbonate ($Cs_2CO_3$) , poly(ethylene imine) (PEI), and the like, but are not limited thereto.

The photoactive layer may be formed by dissolving a photoactive material such as an electron donor and/or an electron acceptor in an organic solvent, and then applying the solution by a method such as spin coating, dip coating, screen printing, spray coating, doctor blade, and brush painting, but the forming method is not limited thereto.

[Mode for Invention]

Hereinafter, the present specification will be described in detail with reference to Examples for specifically describing the present specification. However, the Examples according to the present specification may be modified in various forms, and it is not interpreted that the scope of the present specification is limited to the Examples described below in detail. The Examples of the present specification are provided to more completely explain the present specification to a person with ordinary skill in the art.

Synthesis Example 1. Synthesis of Monomer 1

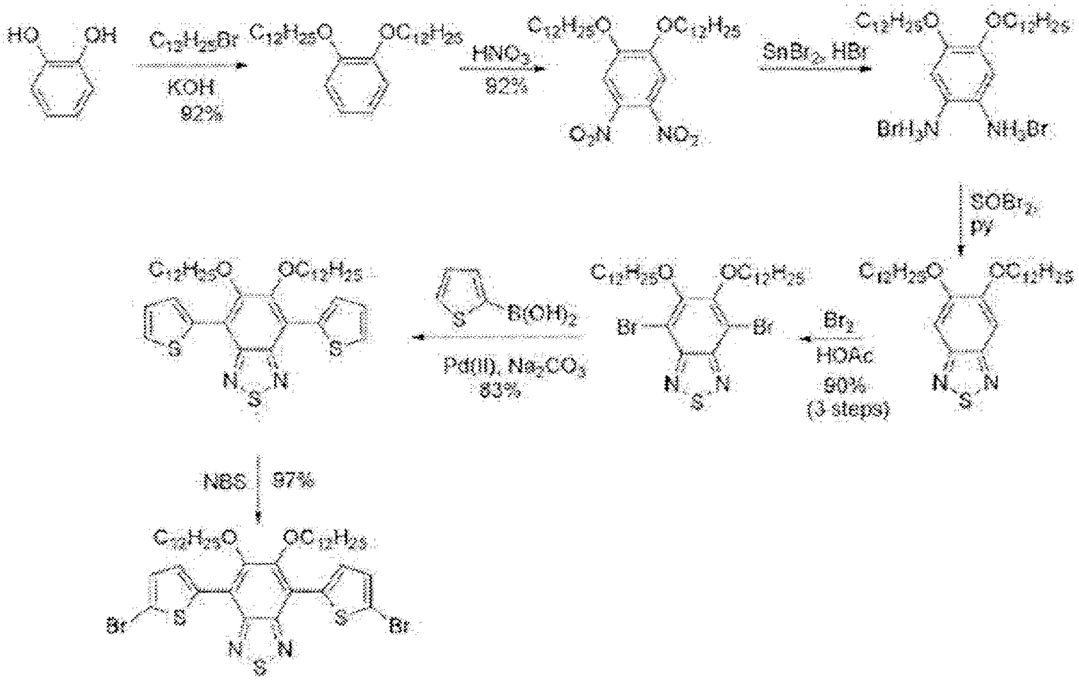


[Monomer 1]

A compound of Monomer 1 was synthesized on the basis of JOURNAL OF POLYMER SCIENCE PART A: POLYMER CHEMISTRY 2011, 49, 4387-4397 4389.

Synthesis Example 2. Synthesis of Monomer 2

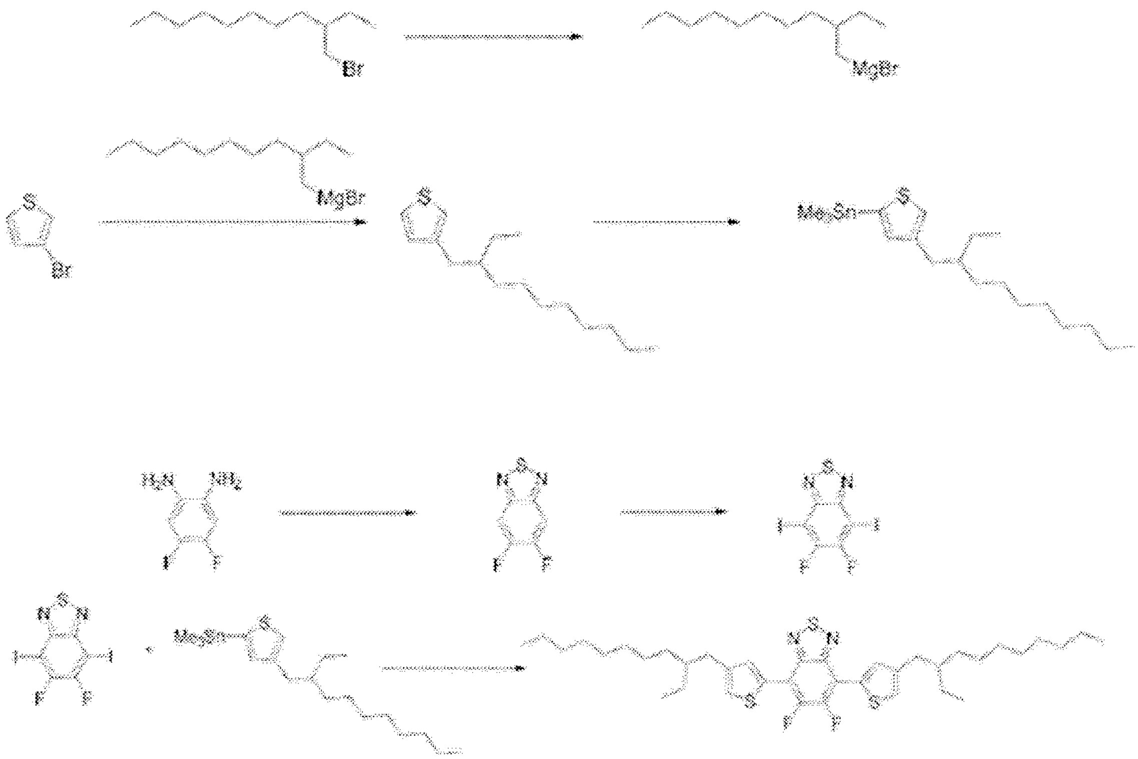

1) Synthesis of 3-(2-ethyldecyl)thiophene

50 mmol of 1-bromo-2-ethyldecane and 50 mmol of Mg turnings were put into 50 ml of diethylether, a Grignard reagent was made by stirring the resulting mixture, and then 0.1 mmol of Ni(dppp)$Cl_2$ was added thereto at room temperature, and 50 mmol of 3-bromothiophene contained in 20 ml of diethylether was slowly added thereto. The resulting mixture was quenched with 2M HCl at 0°C by being stirred under the reflux conditions for 15 hours, and then extraction was performed with diethyl ether. The extract was purified with column chromatography to obtain a colorless liquid 3-(2-ethyldecyl)thiophene. (Yield 70%)

2) Synthesis of 2-(trimethylstannyl)-4-(2-ethyldecyl)thiophene

10 mmol of 3-(2-ethyldecyl)thiophene was dissolved in 100 ml of tetrahydrofuran, 11 mmol of n-BuLi was added thereto at -78°C, the resulting mixture was stirred for 1 hour, and then was stirred at 0°C for 30 minutes. The mixture was cooled again to -78°C, and 12 mmol of $Me_3SnCl$ was added thereto. The resulting mixture was stirred at - 78°C for 1 hour, was stirred while slowly increasing the temperature to room temperature, and then after removing the solvent, the remaining residue was dissolved in hexane and filtered. The precipitate was collected with filtrate to obtain colorless 2-(trimethylstannyl)-4-(2-ethyldecyl)thiophene crystals.

3) Synthesis of 5,6-difluoro-4,7-diiodobenzo[c] [1,2,5]thiadiazole 5,6-difluoro-4,7-diiodobenzo[c][1,2,5]thiadiazole was synthesized on the basis of Polymer Chemistry, 5(2), 502-511; 2014.

4) Synthesis of 5,6-difluoro-4,7-bis(4-(2-ethyldecyl)-2-thienyl)-2,1,3-benzothiadiazole 12 mmol of 5,6-difluoro-4,7-diiodobenzo[c][1,2,5]thiadiazole and 26.4 mmol of 2-(trimethylstannyl)-4-(2-ethyldecyl)thiophene were dissolved in 50 mL of dry toluene, 100 mg of $Pd(PPh_3)_4$ was put into the resulting solution, and the resulting mixture was stirred under reflux for 24 hours. When the reaction was terminated, the temperature was lowered to room temperature, the solvent was removed, and then the residue was purified with column chromatography to obtain 5,6-difluoro-4,7-diiodobenzo[c][1,2,5]thiadiazole which was an orange color solid.

On the basis of the above-described Synthesis Examples 1 and 2, a first unit represented by Chemical Formula 1 and a second unit represented by Chemical Formula 2 were prepared.

Preparation Example 1. Preparation of Polymer

The monomer of each of the first unit and the second unit of the polymer was prepared by using chlorobenzene as a solvent, adding $Pd_2(dba)_2$ and $P(o\text{-}tolyl)_3$ to the solvent, and polymerizing the mixture by means of a microwave reactor.

Measurement of Characteristics of Polymer

Characteristics of the following Polymers 1 to 19 prepared in Preparation Example 1 are as follows.

[Polymer 1]

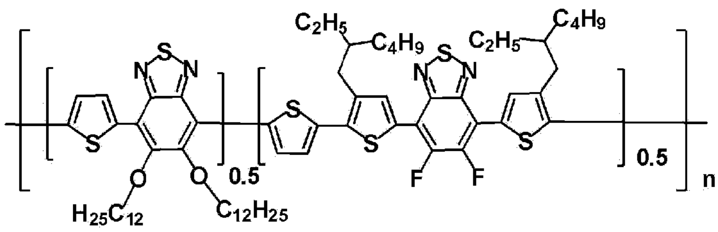

After Polymer 1 was prepared, GPC measurement was carried out, and the results were as follows: the number average molecular weight was 18,700, the weight average molecular weight was 26,200, the HOMO was 5.28 eV, the LUMO was 3.62 eV, and the band gap was 1.63.

FIG. 2 is a view illustrating a UV-vis absorption spectrum of Polymer 1.

Specifically, the UV absorption spectrum of FIG. 3 is 1) an absorption spectrum of a film sample made by dissolving Polymer 1, which come out while being dissolved in chloroform in a soxhlet, in chlorobenzene, 2) an absorption spectrum of a film sample made by dissolving Polymer 1, which come out while being dissolved in chlorobenzene, in chlorobenzene, 3) an absorption spectrum of a sample measured after 1) was subjected to a heat treatment at 120°C, and 4) an absorption spectrum of a sample measured after 2) was subjected to a heat treatment at 120°C, and was analyzed by using a UV-vis absorption spectrometer.

[Polymer 2]

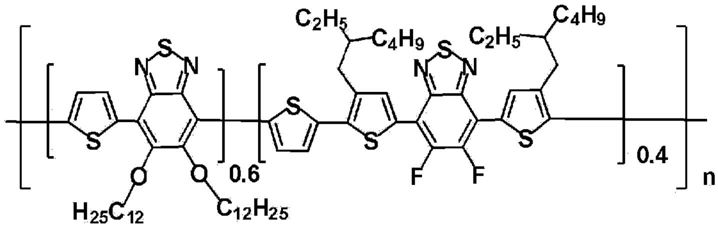

FIG. 3 is a view illustrating a UV-vis absorption spectrum of Polymer 2.

Specifically, the UV absorption spectrum of FIG. 3 is 1) an absorption spectrum of a sample of Polymer 2 in a film state, 2) an absorption spectrum of a sample measured after Polymer 2 in a film state was subjected to a heat treatment at 120°C, 3) an absorption spectrum of a sample made by dissolving Polymer 2 in chlorobenzene, and 4) an absorption spectrum of a sample made by dissolving Polymer 2 in chloroform, and then performing a heat treatment at 120°C, and was analyzed by using a UV-vis absorption spectrometer.

[Polymer 3]

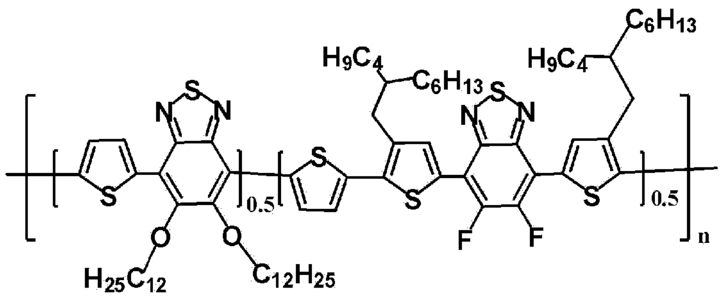

After Polymer 3 was prepared, GPC measurement was carried out, and the results were as follows: the number average molecular weight was 30,740, the weight average molecular weight was 49,500, the HOMO was 5.31 eV, the LUMO was 3.62 eV, and the band gap was 1.69.

FIG. 8 is a view illustrating a UV-vis absorption spectrum of Polymer 3.

Specifically, the UV absorption spectrum of FIG. 8 is an absorption spectrum of a sample of Polymer 3 in a film state, and was analyzed by using a UV-vis absorption spectrometer.

[Polymer 4]

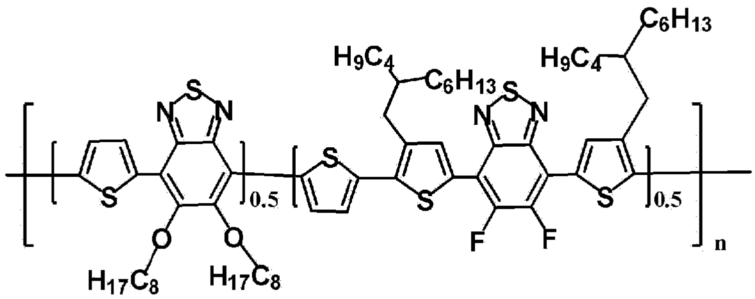

After Polymer 4 was prepared, GPC measurement was carried out, and the results were as follows: the number average molecular weight was 38,540, the weight average molecular weight was 54,000, the HOMO was 5.32 eV, the LUMO was 3.63 eV, and the band gap was 1.69.

FIG. 9 is a view illustrating a UV-vis absorption spectrum of Polymer 4.

Specifically, the UV absorption spectrum of FIG. 9 is an absorption spectrum of a sample of Polymer 4 in a film state, and was analyzed by using a UV-vis absorption spectrometer.

[Polymer 5]

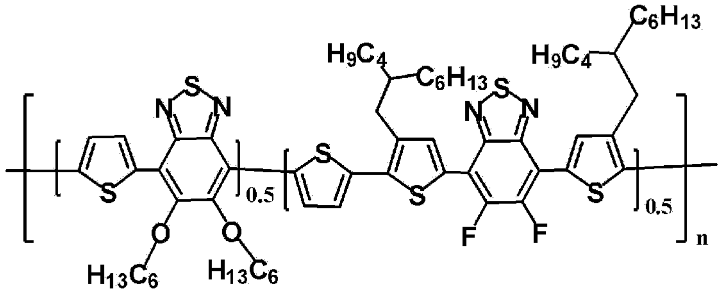

After Polymer 5 was prepared, GPC measurement was carried out, and the results were as follows: the number average molecular weight was 33,742, the weight average molecular weight was 47,700, the HOMO was 5.32 eV, the LUMO was 3.63 eV, and the band gap was 1.69.

FIG. 10 is a view illustrating a UV-vis absorption spectrum of Polymer 5.

Specifically, the UV absorption spectrum of FIG. 10 is an absorption spectrum of a sample of Polymer 5 in a film state, and was analyzed by using a UV-vis absorption spectrometer.

[Polymer 6]

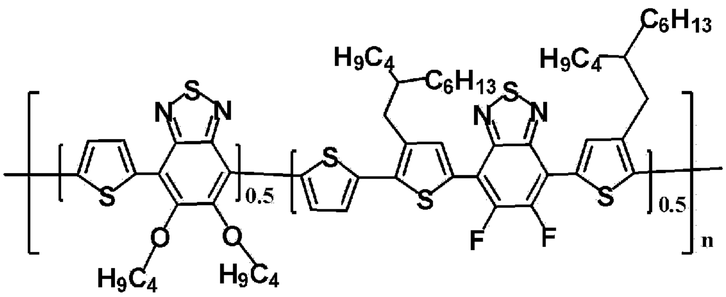

After Polymer 6 was prepared, GPC measurement was carried out, and the results were as follows: the number average molecular weight was 31,650, the weight average molecular weight was 43,920, the HOMO was 5.31 eV, the LUMO was 3.63 eV, and the band gap was 1.68.

FIG. 11 is a view illustrating a UV-vis absorption spectrum of Polymer 6.

Specifically, the UV absorption spectrum of FIG. 11 is an absorption spectrum of a sample of Polymer 6 in a film state, and was analyzed by using a UV-vis absorption spectrometer.

[Polymer 7]

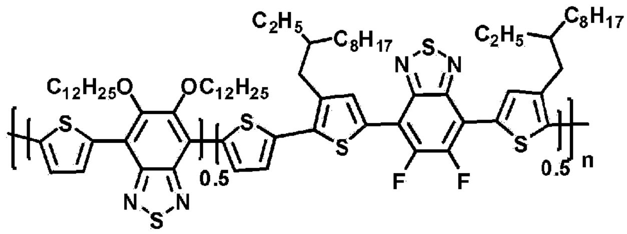

After Polymer 7 was prepared, GPC measurement was carried out, and the results were as follows: the number average molecular weight was 36,866, the weight average molecular weight was 50,477, the HOMO was 5.33 eV, the LUMO was 3.67 eV, the band gap was 1.66, $\lambda_{edge}$ was 743 nm, and PDI was 1.37.

FIG. 12 is a view illustrating UV-vis absorption spectra of Polymer 7.

Specifically, the UV absorption spectra of FIG. 12 are absorption spectra of samples of Polymer 7 in a film state and in a solution state, and were analyzed by using a UV-vis absorption spectrometer.

[Polymer 8]

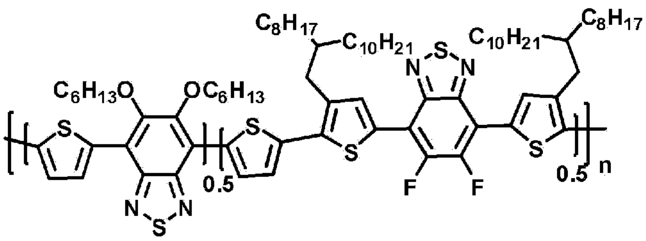

After Polymer 8 was prepared, GPC measurement was carried out, and the results were as follows: the number average molecular weight was 30,000, the weight average molecular weight was 47,100, the HOMO was 5.4 eV, the LUMO was 3.7 eV, the band gap was 1.7, $\lambda_{edge}$ was 732 nm, and PDI was 1.57.

FIG. 13 is a view illustrating UV-vis absorption spectra of Polymer 8.

Specifically, the UV absorption spectra of FIG. 13 are absorption spectra of samples of Polymer 8 in a film state and in a solution state, and were analyzed by using a UV-vis absorption spectrometer.

[Polymer 9]

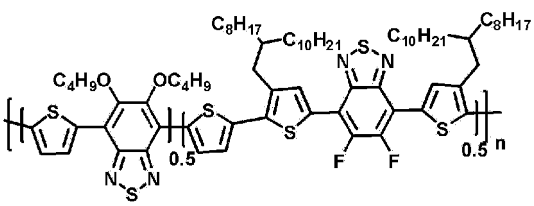

After Polymer 9 was prepared, GPC measurement was carried out, and the results were as follows: the number average molecular weight was 27,300, the weight average molecular weight was 45,400, the HOMO was 5.32 eV, the

LUMO was 3.63 eV, the band gap was 1.69, $\lambda_{edge}$ was 732 nm, and PDI was 1.66.

FIG. 14 is a view illustrating UV-vis absorption spectra of Polymer 9.

Specifically, the UV absorption spectra of FIG. 14 are absorption spectra of samples of Polymer 9 in a film state and in a solution state, and were analyzed by using a UV-vis absorption spectrometer.

[Polymer 10]

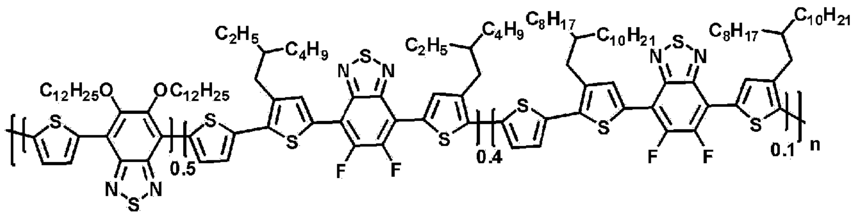

After Polymer 10 was prepared, GPC measurement was carried out, and the results were as follows: the number average molecular weight was 31,300, the weight average molecular weight was 48,700, the HOMO was 5.3 eV, the LUMO was 3.63 eV, the band gap was 1.67, $\lambda_{edge}$ was 743.8 nm, and PDI was 1.56.

FIG. 15 is a view illustrating a UV-vis absorption spectrum of Polymer 10.

Specifically, the UV absorption spectrum of FIG. 15 is an absorption spectrum of a sample of Polymer 10 in a film state, and was analyzed by using a UV-vis absorption spectrometer.

[Polymer 11]

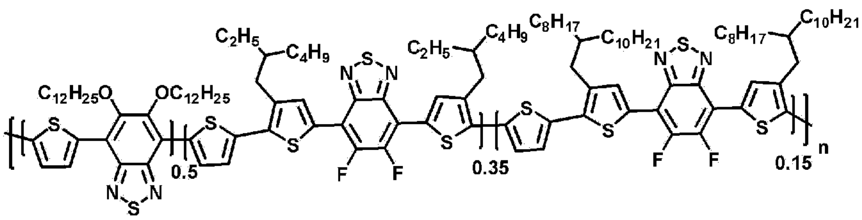

After Polymer 11 was prepared, GPC measurement was carried out, and the results were as follows: the number average molecular weight was 36,200, the weight average molecular weight was 51,800, the HOMO was 5.29 eV, the LUMO was 3.61 eV, the band gap was 1.68, $\lambda_{edge}$ was 740 nm, and PDI was 1.43.

FIG. 16 is a view illustrating a UV-vis absorption spectrum of Polymer 11.

Specifically, the UV absorption spectrum of FIG. 16 is an absorption spectrum of a sample of Polymer 11 in a film state, and was analyzed by using a UV-vis absorption spectrometer.

[Polymer 12]

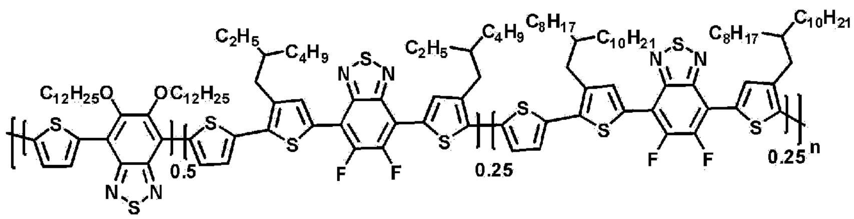

After Polymer 12 was prepared, GPC measurement was carried out, and the results were as follows: the number average molecular weight was 34,800, the weight average molecular weight was 51,900, the HOMO was 5.30 eV, the LUMO was 3.62 eV, the band gap was 1.68, $\lambda_{edge}$ was 739 nm, and PDI was 1.49.

FIG. 17 is a view illustrating UV-vis absorption spectra of Polymer 12.

Specifically, the UV absorption spectra of FIG. 17 are absorption spectra of samples of Polymer 12 in a film state and in a solution state, and were analyzed by using a UV-vis absorption spectrometer.

[Polymer 13]

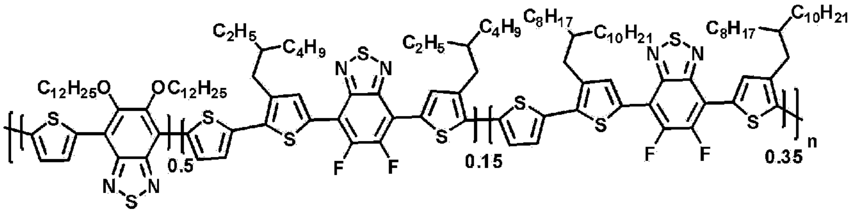

After Polymer 13 was prepared, GPC measurement was carried out, and the results were as follows: the number average molecular weight was 31,800, the weight average molecular weight was 50,360, the HOMO was 5.31 eV, the LUMO was 3.62 eV, the band gap was 1.69, $\lambda_{edge}$ was 734 nm, and PDI was 1.58.

FIG. 18 is a view illustrating UV-vis absorption spectra of Polymer 13.

Specifically, the UV absorption spectra of FIG. 18 are absorption spectra of samples of Polymer 13 in a film state and in a solution state, and were analyzed by using a UV-vis absorption spectrometer.

[Polymer 14]

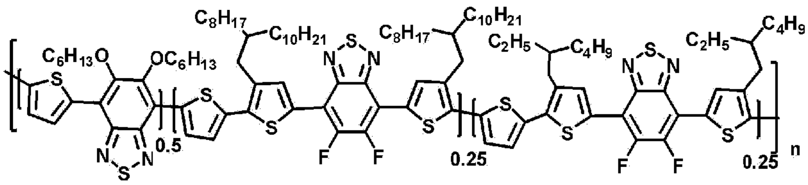

After Polymer 14 was prepared, GPC measurement was carried out, and the results were as follows: the number average molecular weight was 38,300, the weight average molecular weight was 52,000, the HOMO was 5.3 eV, the LUMO was 3.65 eV, the band gap was 1.65, $\lambda_{edge}$ was 741 nm, and PDI was 1.36.

FIG. 19 is a view illustrating UV-vis absorption spectra of Polymer 14.

Specifically, the UV absorption spectra of FIG. 19 are absorption spectra of samples of Polymer 14 in a film state and in a solution state, and were analyzed by using a UV-vis absorption spectrometer.

[Polymer 15]

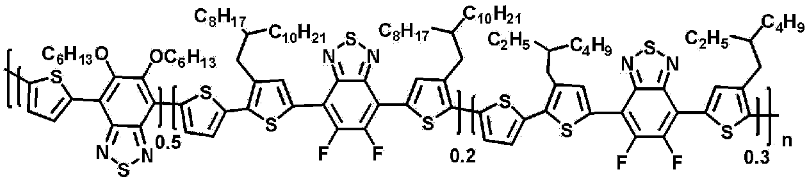

After Polymer 15 was prepared, GPC measurement was carried out, and the results were as follows: the number average molecular weight was 38,500, the weight average molecular weight was 52,700, the HOMO was 5.29 eV, the LUMO was 3.62 eV, the band gap was 1.67, $\lambda_{edge}$ was 742 nm, and PDI was 1.37.

FIG. 20 is a view illustrating UV-vis absorption spectra of Polymer 15.

Specifically, the UV absorption spectra of FIG. 20 are absorption spectra of samples of Polymer 15 in a film state and in a solution state, and were analyzed by using a UV-vis absorption spectrometer.

[Polymer 16]

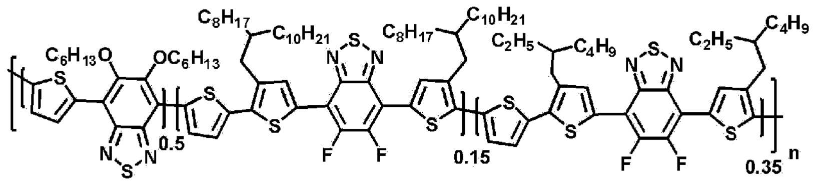

After Polymer 16 was prepared, GPC measurement was carried out, and the results were as follows: the number average molecular weight was 28,900, the weight average molecular weight was 43,500, the HOMO was 5.27 eV, the LUMO was 3.61 eV, the band gap was 1.66, $\lambda_{edge}$ was 745 nm, and PDI was 1.5.

FIG. 21 is a view illustrating UV-vis absorption spectra of Polymer 16.

Specifically, the UV absorption spectra of FIG. 21 are absorption spectra of samples of Polymer 16 in a film state and in a solution state, and were analyzed by using a UV-vis absorption spectrometer.

[Polymer 17]

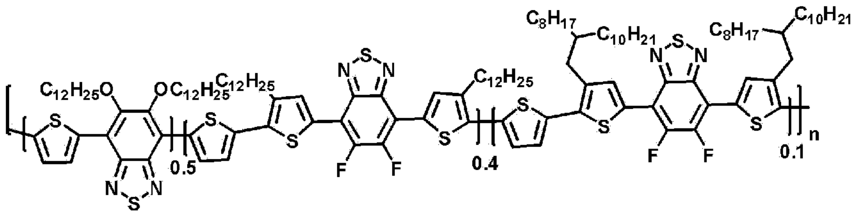

After Polymer 17 was prepared, GPC measurement was carried out, and the results were as follows: the number average molecular weight was 34,000, the weight average molecular weight was 52,400, the HOMO was 5.33 eV, the LUMO was 3.66 eV, the band gap was 1.67, $\lambda_{edge}$ was 744.6 nm, and PDI was 1.54.

FIG. 22 is a view illustrating a UV-vis absorption spectra of Polymer 17.

Specifically, the UV absorption spectra of FIG. 22 are absorption spectra of samples of Polymer 17 in a film state and in a solution state, and were analyzed by using a UV-vis absorption spectrometer.

[Polymer 18]

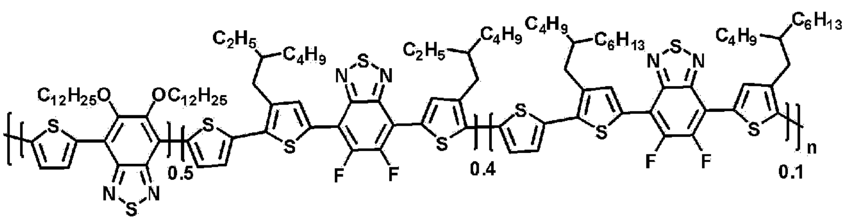

After Polymer 18 was prepared, GPC measurement was carried out, and the results were as follows: the number average molecular weight was 26,390, the weight average molecular weight was 39,310, the HOMO was 5.31 eV, the LUMO was 3.63 eV, the band gap was 1.68, $\lambda_{edge}$ was 737 nm, and PDI was 1.49.

FIG. 23 is a view illustrating a UV-vis absorption spectrum of Polymer 18.

Specifically, the UV absorption spectra of FIG. 23 are absorption spectra of samples of Polymer 18 in a film state and in a solution state, and were analyzed by using a UV-vis absorption spectrometer.

[Polymer 19]

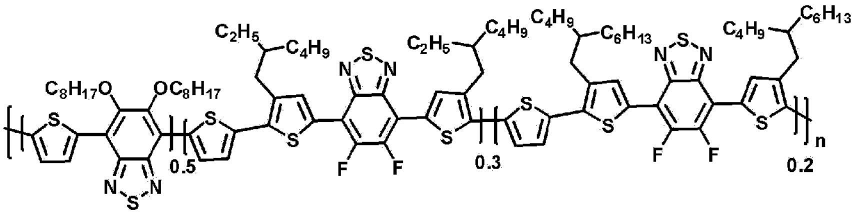

After Polymer 19 was prepared, GPC measurement was carried out, and the results were as follows: the number average molecular weight was 25,600, the weight average molecular weight was 38,400, the HOMO was 5.31 eV, the LUMO was 3.63 eV, the band gap was 1.68, $\lambda_{edge}$ was 740 nm, and PDI was 1.5.

FIG. 24 is a view illustrating a UV-vis absorption spectrum of Polymer 19.

Specifically, the UV absorption spectra of FIG. 24 are absorption spectra of samples of Polymer 19 in a film state and in a solution state, and were analyzed by using a UV-vis absorption spectrometer.

Experimental Example 1. Manufacture of Organic Solar Cell

A composite solution was prepared by dissolving Polymer 1 and $PC_{61}BM$ at a ratio of 1:2 in chlorobenzene (CB). In this case, the concentration was adjusted to 4 wt%, and the organic solar cell was made to have a structure of ITO/PEDOT:PSS/a photoactive layer/Al. A glass substrate coated with ITO with 1.5 × 1.5 $cm^2$ as a bar type was ultrasonically washed using distilled water, acetone, and 2-propanol, the ITO surface was treated with ozone for 10 minutes, and then PEDOT:PSS (AI4083) was spin-coated to have a thickness of 45 nm at 4,000 rpm for 40 seconds, and a heat treatment was performed at 235°C for 10 minutes. For the coating of a photoactive layer, the polymer $PC_{61}BM$ composite solution was spin-coated to have a thickness of 158 nm at 1,000 rpm for 20 seconds, and Al was deposited to have a thickness of 100 nm at a rate of 1 Å/s by using a thermal evaporator under a vacuum of 3 x $10^{-8}$ torr, thereby manufacturing an organic solar cell.

FIG. 4 is a view illustrating the current density according to the voltage in an organic solar cell according to Experimental Example 1.

The photoelectric conversion characteristics of the organic solar cells manufactured in Experimental Example 1 and the following Experimental Example 2 were measured under the condition of 100 $mW/cm^2$ (AM 1.5), and the results are shown in the following Table 1.

[Table 1]

| | $V_{OC}$ (V) | $J_{SC}$ ($mA/cm^2$) | FF (%) | PCE (%) |
|---|---|---|---|---|
| Experimental Example 1 | 0.643 | 16.728 | 0.495 | 5.32 |
| Experimental Example 2 | 0.723 | 14.307 | 0.607 | 6.27 |

Experimental Example 2. Manufacture of Organic Solar Cell

A composite solution was prepared by dissolving Polymer 1 and $PC_{71}BM$ at a ratio of 1:2 in chlorobenzene (CB). In this case, the concentration was adjusted to 4 wt%, and the organic solar cell was made to have an inverted structure of ITO/ZnO/a photoactive layer/$MoO_3$/Ag.

A glass substrate coated with ITO with 1.5 × 1.5 $cm^2$ as a bar type was ultrasonically washed by using distilled water, acetone, and 2-propanol, the ITO surface was treated with ozone for 10 minutes, and then a zinc oxide precursor (ZnO precursor solution: ZnO nanoparticle 25 mg/ml in butanol) was produced, the zinc oxide (ZnO) solution was spin-coated at 4,000 rpm for 40 seconds, and then the remaining solvent was removed by performing a heat treatment at 100°C for 10 minutes, thereby completing an electron transporting layer. In order to coat the photoactive layer, the composite solution of Polymer 1 and $PC_{71}BM$ was spin-coated at 1,000 rpm for 20 seconds. In a thermal deposition apparatus, $MoO_3$ was deposited to have a thickness of 10 nm at a rate of 0.2 Å/s, thereby manufacturing a hole transporting layer. After the electron transporting layer and the hole transporting layer were manufactured in the above order, Ag was deposited to have a thickness of 100 nm at a rate of 1 Å/s in a thermal deposition apparatus, thereby manufacturing an organic solar cell having an inverted structure.

Experimental Example 3. Manufacture of Organic Solar Cell

An organic solar cell was manufactured in the same manner as in Experimental Example 2, except that 1 vol% of 1,8-diiodooctane (DIO) was added to the composite solution of Polymer 1 and $PC_{71}BM$ in Experimental Example 2.

Experimental Example 4. Manufacture of Organic Solar Cell

An organic solar cell was manufactured in the same manner as in Experimental Example 2, except that 2 vol% of 1,8-diiodooctane (DIO) was added to the composite solution of Polymer 1 and $PC_{71}BM$ in Experimental Example 2.

Experimental Example 5. Manufacture of Organic Solar Cell

An organic solar cell was manufactured in the same manner as in Experimental Example 2, except that 3 vol% of 1,8-diiodooctane (DIO) was added to the composite solution of Polymer 1 and $PC_{71}BM$ in Experimental Example 2.

The photoelectric conversion characteristics of the organic solar cells manufactured in Experimental Examples 3 to 5 were measured under the condition of 100 mW/cm$^2$ (AM 1.5), and the results are shown in the following Table 2.

[Table 2]

| | $V_{OC}$ (V) | $J_{SC}$ (mA/cm$^2$) | FF (%) | PCE (%) |
|---|---|---|---|---|
| Experimental Example 3 | 0.754 | 17.795 | 0.605 | 8.12 |
| Experimental Example 4 | 0.74 | 17.538 | 0.594 | 7.72 |
| Experimental Example 5 | 0.734 | 17.263 | 0.578 | 7.33 |

FIG. 5 is a view illustrating the current density according to the voltage in organic solar cells according to Experimental Examples 3 to 5.

Experimental Example 6. Manufacture of Organic Solar Cell

An organic solar cell was manufactured in the same manner as in Experimental Example 2, except that 1 vol% of 1-chloronaphthalene (1-CN) was added to the composite solution of Polymer 1 and $PC_{71}BM$ in Experimental Example 2.

Experimental Example 7. Manufacture of Organic Solar Cell

An organic solar cell was manufactured in the same manner as in Experimental Example 2, except that 2 vol% of 1-chloronaphthalene (1-CN) was added to the composite solution of Polymer 1 and $PC_{71}BM$ in Experimental Example 2.

Experimental Example 8. Manufacture of Organic Solar Cell

An organic solar cell was manufactured in the same manner as in Experimental Example 2, except that 3 vol% of 1-chloronaphthalene (1-CN) was added to the composite solution of Polymer 1 and $PC_{71}BM$ in Experimental Example 2.

The photoelectric conversion characteristics of the organic solar cells manufactured in Experimental Examples 6 to 8 were measured under the condition of 100 mW/cm$^2$ (AM 1.5), and the results are shown in the following Table 3.

[Table 3]

| | $V_{OC}$ (V) | $J_{SC}$ (mA/cm$^2$) | FF (%) | PCE (%) |
|---|---|---|---|---|
| Experimental Example 6 | 0.8 | 16.711 | 0.57 | 7.62 |
| Experimental Example 7 | 0.796 | 16.076 | 0.587 | 7.51 |
| Experimental Example 8 | 0.792 | 15.324 | 0.583 | 7.08 |

FIG. 6 is a view illustrating the current density according to the voltage in organic solar cells according to Experimental Examples 6 to 8.

Experimental Example 9. Manufacture of Organic Solar Cell

An organic solar cell was manufactured in the same manner as in Experimental Example 2, except that 1 vol% of diphenylether (DPE) was added to the composite solution of Polymer 1 and $PC_{71}BM$ in Experimental Example 2.

Experimental Example 10. Manufacture of Organic Solar Cell

An organic solar cell was manufactured in the same manner as in Experimental Example 2, except that 2 vol% of diphenylether (DPE) was added to the composite solution of Polymer 1 and $PC_{71}BM$ in Experimental Example 2.

Experimental Example 11. Manufacture of Organic Solar Cell

An organic solar cell was manufactured in the same manner as in Experimental Example 2, except that 3 vol% of diphenylether (DPE) was added to the composite solution of Polymer 1 and $PC_{71}BM$ in Experimental Example 2.
The photoelectric conversion characteristics of the organic solar cells manufactured in Experimental Examples 9 to 11 were measured under the condition of 100 mW/cm$^2$ (AM 1.5), and the results are shown in the following Table 4.

[Table 4]

| | $V_{OC}$ (V) | $J_{SC}$ (mA/cm$^2$) | FF (%) | PCE (%) |
|---|---|---|---|---|
| Experimental Example 9 | 0.767 | 17.672 | 0.597 | 8.09 |
| Experimental Example 10 | 0.755 | 16.72 | 0.62 | 7.82 |
| Experimental Example 11 | 0.744 | 17.35 | 0.635 | 8.19 |

FIG. 7 is a view illustrating the current density according to the voltage in organic solar cells according to Experimental Examples 9 to 11.

Experimental Example 12-1. Manufacture of Organic Solar Cell

A composite solution was prepared by dissolving Polymer 3 and $PC_{61}BM$ at a ratio of 1:2 in chlorobenzene (CB). In this case, the concentration was adjusted to 4 wt%, and the organic solar cell was made to have an inverted structure of ITO/ZnO NP/a photoactive layer/$MoO_3$/Ag.
A glass substrate coated with ITO with 1.5 cm × 1.5 cm as a bar type was ultrasonically washed by using distilled water, acetone, and 2-propanol, the ITO surface was treated with ozone for 10 minutes, and then ZnO NP (2.5 wt% of ZnO nanograde N-10 in isopropanol) was produced, the ZnO NP solution was spin-coated at 4,000 rpm for 20 seconds, and then the remaining solvent was removed by performing a heat treatment at 100°C for 10 minutes, thereby completing an electron transporting layer. For the coating of the photoactive layer, the composite solution of Polymer 3 and $PC_{61}BM$ was spin-coated at 1,000 rpm for 20 seconds. In a thermal deposition apparatus, $MoO_3$ was deposited to have a thickness of 10 nm at a rate of 0.2 Å/s, thereby manufacturing a hole transporting layer. After the electron transporting layer and the hole transporting layer were manufactured in the above order, Ag was deposited to have a thickness of 100 nm at a rate of 1 Å/s in a thermal deposition apparatus, thereby manufacturing an organic solar cell having an inverted structure.

Experimental Example 12-2. Manufacture of Organic Solar Cell

An organic solar cell was manufactured in the same manner as in Experimental Example 12-1, except that the composite solution of Polymer 3 and $PC_{61}BM$ was spin-coated at 1,500 rpm instead of 1,000 rpm for the coating of the photoactive layer in Experimental Example 12-1.

Experimental Example 12-3. Manufacture of Organic Solar Cell

An organic solar cell was manufactured in the same manner as in Experimental Example 12-1, except that the composite solution of Polymer 3 and $PC_{61}BM$ was spin-coated at 2,000 rpm instead of 1,000 rpm for the coating of the photoactive layer in Experimental Example 12-1.
The photoelectric conversion characteristics of the organic solar cells manufactured in Experimental Examples 12-1 to 12-3 were measured under the condition of 100 mW/cm$^2$ (AM 1.5), and the results are shown in the following

Table 5.

[Table 5]

| | $V_{OC}$ (V) | $J_{SC}$ (mA/cm$^2$) | FF (%) | PCE (%) |
|---|---|---|---|---|
| Experimental Example 12-1 | 0.808 | 11.388 | 0.714 | 6.57 |
| Experimental Example 12-2 | 0.807 | 9.679 | 0.736 | 5.75 |
| Experimental Example 12-3 | 0.802 | 9.303 | 0.687 | 5.12 |

Experimental Example 12-4. Manufacture of Organic Solar Cell

An organic solar cell was manufactured in the same manner as in Experimental Example 12-1, except that $PC_{71}BM$ was used instead of $PC_{61}BM$ as an electron acceptor material of the photoactive layer in Experimental Example 12-1.

Experimental Example 12-5. Manufacture of Organic Solar Cell

An organic solar cell was manufactured in the same manner as in Experimental Example 12-4, except that the composite solution of Polymer 3 and $PC_{71}BM$ was spin-coated at 1,500 rpm instead of 1,000 rpm for the coating of the photoactive layer in Experimental Example 12-4.

Experimental Example 12-6. Manufacture of Organic Solar Cell

An organic solar cell was manufactured in the same manner as in Experimental Example 12-4, except that the composite solution of Polymer 3 and $PC_{71}BM$ was spin-coated at 2,000 rpm instead of 1,000 rpm for the coating of the photoactive layer in Experimental Example 12-4.

The photoelectric conversion characteristics of the organic solar cells manufactured in Experimental Examples 12-4 to 12-6 were measured under the condition of 100 mW/cm$^2$ (AM 1.5), and the results are shown in the following Table 6.

[Table 6]

| | $V_{OC}$ (V) | $J_{SC}$ (mA/cm$^2$) | FF (%) | PCE (%) |
|---|---|---|---|---|
| Experimental Example 12-4 | 0.823 | 12.727 | 0.673 | 7.05 |
| Experimental Example 12-5 | 0.830 | 11.264 | 0.719 | 6.72 |
| Experimental Example 12-6 | 0.831 | 11.549 | 0.730 | 7.01 |

Experimental Example 13-1. Manufacture of Organic Solar Cell

An organic solar cell was manufactured in the same manner as in Experimental Example 12-1, except that Polymer 4 was used instead of Polymer 3 as an electron donor material of the photoactive layer in Experimental Example 12-1.

Experimental Example 13-2. Manufacture of Organic Solar Cell

An organic solar cell was manufactured in the same manner as in Experimental Example 13-1, except that the composite solution of Polymer 4 and $PC_{61}BM$ was spin-coated at 1,500 rpm instead of 1,000 rpm for the coating of the photoactive layer in Experimental Example 13-1.

Experimental Example 13-3. Manufacture of Organic Solar Cell

An organic solar cell was manufactured in the same manner as in Experimental Example 13-1, except that the composite solution of Polymer 4 and $PC_{61}BM$ was spin-coated at 2,000 rpm instead of 1,000 rpm for the coating of the photoactive layer in Experimental Example 13-1.

The photoelectric conversion characteristics of the organic solar cells manufactured in Experimental Examples

13-1 to 13-3 were measured under the condition of 100 $mW/cm^2$ (AM 1.5), and the results are shown in the following Table 7.

[Table 7]

| | $V_{OC}$ (V) | $J_{SC}$ ($mA/cm^2$) | FF (%) | PCE (%) |
|---|---|---|---|---|
| Experimental Example 13-1 | 0.784 | 15.577 | 0.708 | 8.65 |
| Experimental Example 13-2 | 0.798 | 13.35 | 0.691 | 7.36 |
| Experimental Example 13-3 | 0.806 | 12.182 | 0.716 | 7.03 |

Experimental Example 13-4. Manufacture of Organic Solar Cell

An organic solar cell was manufactured in the same manner as in Experimental Example 13-1, except that $PC_{71}BM$ was used instead of $PC_{61}BM$ as an electron acceptor material of the photoactive layer in Experimental Example 13-1.

Experimental Example 13-5. Manufacture of Organic Solar Cell

An organic solar cell was manufactured in the same manner as in Experimental Example 13-4, except that the composite solution of Polymer 4 and $PC_{71}BM$ was spin-coated at 1,500 rpm instead of 1,000 rpm for the coating of the photoactive layer in Experimental Example 13-4.

Experimental Example 13-6. Manufacture of Organic Solar Cell

An organic solar cell was manufactured in the same manner as in Experimental Example 13-4, except that the composite solution of Polymer 4 and $PC_{71}BM$ was spin-coated at 2,000 rpm instead of 1,000 rpm for the coating of the photoactive layer in Experimental Example 13-4.

The photoelectric conversion characteristics of the organic solar cells manufactured in Experimental Examples 13-4 to 13-6 were measured under the condition of 100 $mW/cm^2$ (AM 1.5), and the results are shown in the following Table 8.

[Table 8]

| | $V_{OC}$ (V) | $J_{SC}$ ($mA/cm^2$) | FF (%) | PCE (%) |
|---|---|---|---|---|
| Experimental Example 13-4 | 0.804 | 16.651 | 0.632 | 8.46 |
| Experimental Example 13-5 | 0.820 | 15.614 | 0.603 | 7.71 |
| Experimental Example 13-6 | 0.819 | 13.302 | 0.713 | 7.77 |

Experimental Example 14-1. Manufacture of Organic Solar Cell

An organic solar cell was manufactured in the same manner as in Experimental Example 12-1, except that Polymer 5 was used instead of Polymer 3 as an electron donor material of the photoactive layer in Experimental Example 12-1.

Experimental Example 14-2. Manufacture of Organic Solar Cell

An organic solar cell was manufactured in the same manner as in Experimental Example 14-1, except that the composite solution of Polymer 5 and $PC_{61}BM$ was spin-coated at 1,500 rpm instead of 1,000 rpm for the coating of the photoactive layer in Experimental Example 14-1.

Experimental Example 14-3. Manufacture of Organic Solar Cell

An organic solar cell was manufactured in the same manner as in Experimental Example 14-1, except that the composite solution of Polymer 5 and $PC_{61}BM$ was spin-coated at 2,000 rpm instead of 1,000 rpm for the coating of the photoactive layer in Experimental Example 14-1.

The photoelectric conversion characteristics of the organic solar cells manufactured in Experimental Examples 14-1 to 14-3 were measured under the condition of 100 mW/cm$^2$ (AM 1.5), and the results are shown in the following Table 9.

[Table 9]

| | $V_{OC}$ (V) | $J_{SC}$ (mA/cm$^2$) | FF (%) | PCE (%) |
|---|---|---|---|---|
| Experimental Example 14-1 | 0.785 | 16.581 | 0.644 | 8.38 |
| Experimental Example 14-2 | 0.79 | 14.24 | 0.638 | 7.17 |
| Experimental Example 14-3 | 0.794 | 12.946 | 0.663 | 6.82 |

Experimental Example 14-4. Manufacture of Organic Solar Cell

An organic solar cell was manufactured in the same manner as in Experimental Example 14-1, except that $PC_{71}BM$ was used instead of $PC_{61}BM$ as an electron acceptor material of the photoactive layer in Experimental Example 14-1.

Experimental Example 14-5. Manufacture of Organic Solar Cell

An organic solar cell was manufactured in the same manner as in Experimental Example 14-4, except that the composite solution of Polymer 5 and $PC_{71}BM$ was spin-coated at 1,500 rpm instead of 1,000 rpm for the coating of the photoactive layer in Experimental Example 14-4.

Experimental Example 14-6. Manufacture of Organic Solar Cell

An organic solar cell was manufactured in the same manner as in Experimental Example 14-4, except that the composite solution of Polymer 5 and $PC_{71}BM$ was spin-coated at 2,000 rpm instead of 1,000 rpm for the coating of the photoactive layer in Experimental Example 14-4.

The photoelectric conversion characteristics of the organic solar cells manufactured in Experimental Examples 14-4 to 14-6 were measured under the condition of 100 mW/cm$^2$ (AM 1.5), and the results are shown in the following Table 10.

[Table 10]

| | $V_{OC}$ (V) | $J_{SC}$ (mA/cm$^2$) | FF (%) | PCE (%) |
|---|---|---|---|---|
| Experimental Example 14-4 | 0.798 | 16.481 | 0.569 | 7.48 |
| Experimental Example 14-5 | 0.807 | 14.573 | 0.561 | 6.60 |
| Experimental Example 14-6 | 0.810 | 14.848 | 0.615 | 7.39 |

Experimental Example 15-1. Manufacture of Organic Solar Cell

An organic solar cell was manufactured in the same manner as in Experimental Example 12-1, except that Polymer 6 was used instead of Polymer 3 as an electron donor material of the photoactive layer in Experimental Example 12-1.

Experimental Example 15-2. Manufacture of Organic Solar Cell

An organic solar cell was manufactured in the same manner as in Experimental Example 15-1, except that the composite solution of Polymer 6 and $PC_{61}BM$ was spin-coated at 1,500 rpm instead of 1,000 rpm for the coating of the photoactive layer in Experimental Example 15-1.

Experimental Example 15-3. Manufacture of Organic Solar Cell

An organic solar cell was manufactured in the same manner as in Experimental Example 15-1, except that the composite solution of Polymer 6 and $PC_{61}BM$ was spin-coated at 2,000 rpm instead of 1,000 rpm for the coating of the

photoactive layer in Experimental Example 15-1.

The photoelectric conversion characteristics of the organic solar cells manufactured in Experimental Examples 15-1 to 15-3 were measured under the condition of 100 $mW/cm^2$ (AM 1.5), and the results are shown in the following Table 11.

[Table 11]

| | $V_{OC}$ (V) | $J_{SC}$ ($mA/cm^2$) | FF (%) | PCE (%) |
|---|---|---|---|---|
| Experimental Example 15-1 | 0.742 | 16.534 | 0.555 | 6.82 |
| Experimental Example 15-2 | 0.76 | 13.556 | 0.603 | 6.21 |
| Experimental Example 15-3 | 0.76 | 12.401 | 0.633 | 5.97 |

Experimental Example 15-4. Manufacture of Organic Solar Cell

An organic solar cell was manufactured in the same manner as in Experimental Example 15-1, except that $PC_{71}BM$ was used instead of $PC_{61}BM$ as an electron acceptor material of the photoactive layer in Experimental Example 15-1.

Experimental Example 15-5. Manufacture of Organic Solar Cell

An organic solar cell was manufactured in the same manner as in Experimental Example 15-4, except that the composite solution of Polymer 6 and $PC_{71}BM$ was spin-coated at 1,500 rpm instead of 1,000 rpm for the coating of the photoactive layer in Experimental Example 15-4.

Experimental Example 15-6. Manufacture of Organic Solar Cell

An organic solar cell was manufactured in the same manner as in Experimental Example 15-4, except that the composite solution of Polymer 6 and $PC_{71}BM$ was spin-coated at 2,000 rpm instead of 1,000 rpm for the coating of the photoactive layer in Experimental Example 15-4.

The photoelectric conversion characteristics of the organic solar cells manufactured in Experimental Examples 15-4 to 15-6 were measured under the condition of 100 $mW/cm^2$ (AM 1.5), and the results are shown in the following Table 12.

[Table 12]

| | $V_{OC}$ (V) | $J_{SC}$ ($mA/cm^2$) | FF (%) | PCE (%) |
|---|---|---|---|---|
| Experimental Example 15-4 | 0.758 | 14.489 | 0.477 | 5.23 |
| Experimental Example 15-5 | 0.769 | 13.910 | 0.565 | 6.05 |
| Experimental Example 15-6 | 0.774 | 13.350 | 0.575 | 5.95 |

Experimental Example 16-1. Manufacture of Organic Solar Cell

An organic solar cell was manufactured in the same manner as in Experimental Example 2, except that Polymer 7 was used instead of Polymer 1 in Experimental Example 2.

Experimental Example 16-2. Manufacture of Organic Solar Cell

An organic solar cell was manufactured in the same manner as in Experimental Example 16-1, except that the composite solution of Polymer 7 and $PC_{71}BM$ was spin-coated at 1,200 rpm instead of 1,000 rpm for the coating of the photoactive layer in Experimental Example 16-1.

The photoelectric conversion characteristics of the organic solar cells manufactured in Experimental Examples 16-1 and 16-2 were measured under the condition of 100 $mW/cm^2$ (AM 1.5), and the results are shown in the following Table 13.

[Table 13]

| | $V_{OC}$ (V) | $J_{SC}$ (mA/cm$^2$) | FF (%) | PCE (%) |
|---|---|---|---|---|
| Experimental Example 16-1 | 0.792 | 15.623 | 0.637 | 7.89 |
| Experimental Example 16-2 | 0.797 | 15.498 | 0.632 | 7.80 |

FIG. 25 is a view illustrating the current density according to the voltage in the organic solar cells according to Experimental Examples 16-1 and 16-2.

Experimental Example 17-1. Manufacture of Organic Solar Cell

An organic solar cell was manufactured in the same manner as in Experimental Example 2, except that Polymer 8 was used instead of Polymer 1 and the composite solution of Polymer 8 and $PC_{71}BM$ was spin-coated at 700 rpm instead of 1,000 rpm in Experimental Example 2.

Experimental Example 17-2. Manufacture of Organic Solar Cell

An organic solar cell was manufactured in the same manner as in Experimental Example 17-1, except that the composite solution of Polymer 8 and $PC_{71}BM$ was spin-coated at 1,100 rpm instead of 700 rpm for the coating of the photoactive layer in Experimental Example 17-1.

The photoelectric conversion characteristics of the organic solar cells manufactured in Experimental Examples 17-1 and 17-2 were measured under the condition of 100 mW/cm$^2$ (AM 1.5), and the results are shown in the following Table 14.

[Table 14]

| | $V_{OC}$ (V) | $J_{SC}$ (mA/cm$^2$) | FF (%) | PCE (%) |
|---|---|---|---|---|
| Experimental Example 17-1 | 0.792 | 11.711 | 0.706 | 6.55 |
| Experimental Example 17-2 | 0.799 | 10.446 | 0.703 | 5.87 |

FIG. 26 is a view illustrating the current density according to the voltage in the organic solar cells according to Experimental Examples 17-1 and 17-2.

Experimental Example 18-1. Manufacture of Organic Solar Cell

An organic solar cell was manufactured in the same manner as in Experimental Example 2, except that Polymer 9 was used instead of Polymer 1 and the composite solution of Polymer 9 and $PC_{71}BM$ was spin-coated at 700 rpm instead of 1,000 rpm in Experimental Example 2.

Experimental Example 18-2. Manufacture of Organic Solar Cell

An organic solar cell was manufactured in the same manner as in Experimental Example 18-1, except that the composite solution of Polymer 9 and $PC_{71}BM$ was spin-coated at 1,100 rpm instead of 700 rpm for the coating of the photoactive layer in Experimental Example 18-1.

The photoelectric conversion characteristics of the organic solar cells manufactured in Experimental Examples 18-1 and 18-2 were measured under the condition of 100 mW/cm$^2$ (AM 1.5), and the results are shown in the following Table 15.

[Table 15]

| | $V_{OC}$ (V) | $J_{SC}$ (mA/cm$^2$) | FF (%) | PCE (%) |
|---|---|---|---|---|
| Experimental Example 18-1 | 0.839 | 12.065 | 0.667 | 6.74 |
| Experimental Example 18-2 | 0.840 | 10.594 | 0.691 | 6.14 |

FIG. 27 is a view illustrating the current density according to the voltage in the organic solar cells according to

Experimental Examples 18-1 and 18-2.

Experimental Example 19-1. Manufacture of Organic Solar Cell

An organic solar cell was manufactured in the same manner as in Experimental Example 2, except that Polymer 10 was used instead of Polymer 1 and the composite solution of Polymer 10 and $PC_{71}BM$ was spin-coated at 900 rpm instead of 1,000 rpm in Experimental Example 2.

Experimental Example 19-2. Manufacture of Organic Solar Cell

An organic solar cell was manufactured in the same manner as in Experimental Example 2, except that Polymer 10 was used instead of Polymer 1 in Experimental Example 2.

The photoelectric conversion characteristics of the organic solar cells manufactured in Experimental Examples 19-1 and 19-2 were measured under the condition of 100 $mW/cm^2$ (AM 1.5), and the results are shown in the following Table 16.

[Table 16]

| | $V_{OC}$ (V) | $J_{SC}$ ($mA/cm^2$) | FF % | PCE (%) |
|---|---|---|---|---|
| Experimental Example 19-1 | 0.764 | 16.760 | 0.555 | 7.11 |
| Experimental Example 19-2 | 0.763 | 16.721 | 0.588 | 7.50 |

FIG. 28 is a view illustrating the current density according to the voltage in the organic solar cells according to Experimental Examples 19-1 and 19-2.

Experimental Example 20-1. Manufacture of Organic Solar Cell

An organic solar cell was manufactured in the same manner as in Experimental Example 2, except that Polymer 11 was used instead of Polymer 1 and the composite solution of Polymer 11 and $PC_{71}BM$ was spin-coated at 700 rpm instead of 1,000 rpm in Experimental Example 2.

Experimental Example 20-2. Manufacture of Organic Solar Cell

An organic solar cell was manufactured in the same manner as in Experimental Example 20-1, except that the composite solution of Polymer 11 and $PC_{71}BM$ was spin-coated at 1,300 rpm instead of 700 rpm for the coating of the photoactive layer in Experimental Example 20-1.

The photoelectric conversion characteristics of the organic solar cells manufactured in Experimental Examples 20-1 and 20-2 were measured under the condition of 100 $mW/cm^2$ (AM 1.5), and the results are shown in the following Table 17.

[Table 17]

| | $V_{OC}$ (V) | $J_{SC}$ ($mA/cm^2$) | FF (%) | PCE (%) |
|---|---|---|---|---|
| Experimental Example 20-1 | 0.775 | 15.698 | 0.502 | 6.11 |
| Experimental Example 20-2 | 0.787 | 14.077 | 0.682 | 7.56 |

FIG. 29 is a view illustrating the current density according to the voltage in the organic solar cells according to Experimental Examples 20-1 and 20-2.

Experimental Example 21-1. Manufacture of Organic Solar Cell

An organic solar cell was manufactured in the same manner as in Experimental Example 2, except that Polymer 12 was used instead of Polymer 1 and the composite solution of Polymer 12 and $PC_{71}BM$ was spin-coated at 700 rpm instead of 1,000 rpm in Experimental Example 2.

Experimental Example 21-2. Manufacture of Organic Solar Cell

An organic solar cell was manufactured in the same manner as in Experimental Example 2, except that Polymer 12 was used instead of Polymer 1 in Experimental Example 2.

The photoelectric conversion characteristics of the organic solar cells manufactured in Experimental Examples 21-1 and 21-2 were measured under the condition of 100 mW/cm$^2$ (AM 1.5), and the results are shown in the following Table 18.

[Table 18]

| | $V_{OC}$ (V) | $J_{SC}$ (mA/cm$^2$) | FF (%) | PCE (%) |
|---|---|---|---|---|
| Experimental Example 21-1 | 0.813 | 11.331 | 65.49 | 6.033 |
| Experimental Example 21-2 | 0.818 | 11.278 | 66.95 | 6.179 |

FIG. 30 is a view illustrating the current density according to the voltage in the organic solar cells according to Experimental Examples 21-1 and 21-2.

Experimental Example 22-1. Manufacture of Organic Solar Cell

An organic solar cell was manufactured in the same manner as in Experimental Example 2, except that Polymer 13 was used instead of Polymer 1 and the composite solution of Polymer 13 and $PC_{71}BM$ was spin-coated at 700 rpm instead of 1,000 rpm in Experimental Example 2.

Experimental Example 22-2. Manufacture of Organic Solar Cell

An organic solar cell was manufactured in the same manner as in Experimental Example 2, except that Polymer 13 was used instead of Polymer 1 in Experimental Example 2.

The photoelectric conversion characteristics of the organic solar cells manufactured in Experimental Examples 22-1 and 22-2 were measured under the condition of 100 mW/cm$^2$ (AM 1.5), and the results are shown in the following Table 19.

[Table 19]

| | $V_{OC}$ (V) | $J_{SC}$ (mA/cm$^2$) | FF (%) | PCE (%) |
|---|---|---|---|---|
| Experimental Example 22-1 | 0.793 | 10.308 | 67.08 | 5.482 |
| Experimental Example 22-2 | 0.792 | 8.898 | 65.66 | 4.627 |

FIG. 31 is a view illustrating the current density according to the voltage in the organic solar cells according to Experimental Examples 22-1 and 22-2.

Experimental Example 23-1. Manufacture of Organic Solar Cell

A composite solution was prepared by dissolving Polymer 14 and $PC_{71}BM$ at a ratio of 1:2 in chlorobenzene (CB). In this case, the concentration was adjusted to 2.5 wt%, and the organic solar cell was made to have an inverted structure of ITO/ZnO NP/a photoactive layer/$MoO_3$/Ag.

A glass substrate coated with ITO with 1.5 cm × 1.5 cm as a bar type was ultrasonically washed by using distilled water, acetone, and 2-propanol, the ITO surface was treated with ozone for 10 minutes, and then ZnO NP (2.5 wt% of ZnO nanograde N-10 in isopropanol) was produced, the ZnO NP solution was spin-coated at 4,000 rpm for 20 seconds, and then the remaining solvent was removed by performing a heat treatment at 100°C for 10 minutes, thereby completing an electron transporting layer. For the coating of the photoactive layer, the composite solution of Polymer 14 and $PC_{71}BM$ was spin-coated at 700 rpm. In a thermal deposition apparatus, $MoO_3$ was deposited to have a thickness of 10 nm at a rate of 0.2 Å/s, thereby manufacturing a hole transporting layer. After the electron transporting layer and the hole transporting layer were manufactured in the above order, Ag was deposited to have a thickness of 100 nm at a rate of 1 Å/s in a thermal deposition apparatus, thereby manufacturing an organic solar cell having an inverted structure.

Experimental Example 23-2. Manufacture of Organic Solar Cell

An organic solar cell was manufactured in the same manner as in Experimental Example 23-1, except that the composite solution of Polymer 14 and $PC_{71}BM$ was spin-coated at 1,500 rpm instead of 700 rpm in Experimental Example 23-1.

The photoelectric conversion characteristics of the organic solar cells manufactured in Experimental Examples 23-1 and 23-2 were measured under the condition of 100 mW/cm$^2$ (AM 1.5), and the results are shown in the following Table 20.

[Table 20]

| | $V_{OC}$ (V) | $J_{SC}$ (mA/cm$^2$) | FF (%) | PCE (%) |
|---|---|---|---|---|
| Experimental Example 23-1 | 0.804 | 13.477 | 0.664 | 7.19 |
| Experimental Example 23-2 | 0.810 | 13.295 | 0.662 | 7.13 |

FIG. 32 is a view illustrating the current density according to the voltage in the organic solar cells according to Experimental Examples 23-1 and 23-2.

Experimental Example 24-1. Manufacture of Organic Solar Cell

An organic solar cell was manufactured in the same manner as in Experimental Example 2, except that Polymer 15 was used instead of Polymer 1 and the composite solution of Polymer 15 and $PC_{71}BM$ was spin-coated at 700 rpm instead of 1,000 rpm in Experimental Example 2.

Experimental Example 24-2. Manufacture of Organic Solar Cell

An organic solar cell was manufactured in the same manner as in Experimental Example 24-1, except that the composite solution of Polymer 15 and $PC_{71}BM$ was spin-coated at 1,500 rpm instead of 700 rpm in Experimental Example 24-1.

The photoelectric conversion characteristics of the organic solar cells manufactured in Experimental Examples 24-1 and 24-2 were measured under the condition of 100 mW/cm$^2$ (AM 1.5), and the results are shown in the following Table 21.

[Table 21]

| | $V_{OC}$ (V) | $J_{SC}$ (mA/cm$^2$) | FF (%) | PCE (%) |
|---|---|---|---|---|
| Experimental Example 24-1 | 0.761 | 16.474 | 0.459 | 5.75 |
| Experimental Example 24-2 | 0.778 | 13.838 | 0.580 | 6.25 |

FIG. 33 is a view illustrating the current density according to the voltage in the organic solar cells according to Experimental Examples 24-1 and 24-2.

Experimental Example 25-1. Manufacture of Organic Solar Cell

An organic solar cell was manufactured in the same manner as in Experimental Example 23-1, except that Polymer 16 was used instead of Polymer 14 in Experimental Example 23-1.

Experimental Example 25-2. Manufacture of Organic Solar Cell

An organic solar cell was manufactured in the same manner as in Experimental Example 25-1, except that the composite solution of Polymer 16 and $PC_{71}BM$ was spin-coated at 1,000 rpm instead of 700 rpm in Experimental Example 25-1.

The photoelectric conversion characteristics of the organic solar cells manufactured in Experimental Examples 25-1 and 25-2 were measured under the condition of 100 mW/cm$^2$ (AM 1.5), and the results are shown in the following Table 22.

[Table 22]

| | $V_{OC}$ (V) | $J_{SC}$ (mA/cm$^2$) | FF (%) | PCE (%) |
|---|---|---|---|---|
| Experimental Example 25-1 | 0.750 | 14.230 | 0.619 | 6.60 |
| Experimental Example 25-2 | 0.749 | 13.486 | 0.660 | 6.67 |

FIG. 34 is a view illustrating the current density according to the voltage in the organic solar cells according to Experimental Examples 25-1 and 25-2.

Experimental Example 26-1. Manufacture of Organic Solar Cell

An organic solar cell was manufactured in the same manner as in Experimental Example 2, except that Polymer 17 was used instead of Polymer 1 in Experimental Example 2.

Experimental Example 26-2. Manufacture of Organic Solar Cell

An organic solar cell was manufactured in the same manner as in Experimental Example 26-1, except that the composite solution of Polymer 17 and $PC_{71}BM$ was spin-coated at 1,200 rpm instead of 1,000 rpm in Experimental Example 26-1.

The photoelectric conversion characteristics of the organic solar cells manufactured in Experimental Examples 26-1 and 26-2 were measured under the condition of 100 mW/cm$^2$ (AM 1.5), and the results are shown in the following Table 23.

[Table 23]

| | $V_{OC}$ (V) | $J_{SC}$ (mA/cm$^2$) | FF (%) | PCE (%) |
|---|---|---|---|---|
| Experimental Example 26-1 | 0.693 | 16.398 | 53.18 | 6.045 |
| Experimental Example 26-2 | 0.687 | 16.788 | 57.34 | 6.617 |

FIG. 35 is a view illustrating the current density according to the voltage in the organic solar cells according to Experimental Examples 26-1 and 26-2.

Experimental Example 27-1. Manufacture of Organic Solar Cell

A composite solution was prepared by dissolving Polymer 18 and $PC_{71}BM$ at a ratio of 1:2 in chlorobenzene (CB). In this case, the concentration was adjusted to 2 wt%, and the organic solar cell was made to have an inverted structure of ITO/ZnO/a photoactive layer/$MoO_3$/Ag.

A glass substrate coated with ITO with 1.5 × 1.5 cm$^2$ as a bar type was ultrasonically washed by using distilled water, acetone, and 2-propanol, the ITO surface was treated with ozone for 10 minutes, and then a zinc oxide precursor (ZnO precursor solution: ZnO nanoparticle 25 mg/ml in butanol) was produced, the zinc oxide (ZnO) solution was spin-coated at 4,000 rpm for 40 seconds, and then the remaining solvent was removed by performing a heat treatment at 100°C for 10 minutes, thereby completing an electron transporting layer. For the coating of the photoactive layer, the composite solution of Polymer 18 and $PC_{71}BM$ was spin-coated at 700 rpm for 20 seconds. In a thermal deposition apparatus, $MoO_3$ was deposited to have a thickness of 10 nm at a rate of 0.2 Å/s, thereby manufacturing a hole transporting layer. After the electron transporting layer and the hole transporting layer were manufactured in the above order, Ag was deposited to have a thickness of 100 nm at a rate of 1 Å/s in a thermal deposition apparatus, thereby manufacturing an organic solar cell having an inverted structure.

Experimental Example 27-2. Manufacture of Organic Solar Cell

An organic solar cell was manufactured in the same manner as in Experimental Example 27-1, except that the composite solution of Polymer 18 and $PC_{71}BM$ was spin-coated at 1,000 rpm instead of 700 rpm in Experimental Example 27-1.

The photoelectric conversion characteristics of the organic solar cells manufactured in Experimental Examples 27-1 and 27-2 were measured under the condition of 100 mW/cm$^2$ (AM 1.5), and the results are shown in the following

Table 24.

[Table 24]

| | $V_{OC}$ (V) | $J_{SC}$ (mA/cm$^2$) | FF (%) | PCE (%) |
|---|---|---|---|---|
| Experimental Example 27-1 | 0.755 | 12.702 | 0.595 | 5.70 |
| Experimental Example 27-2 | 0.798 | 13.206 | 0.618 | 6.52 |

FIG. 36 is a view illustrating the current density according to the voltage in the organic solar cells according to Experimental Examples 27-1 and 27-2.

Experimental Example 28-1. Manufacture of Organic Solar Cell

An organic solar cell was manufactured in the same manner as in Experimental Example 27-1, except that Polymer 19 was used instead of Polymer 18 and the composite solution of Polymer 19 and $PC_{71}BM$ was spin-coated at 1,000 rpm instead of 700 rpm in Experimental Example 27-1.

Experimental Example 28-2. Manufacture of Organic Solar Cell

An organic solar cell was manufactured in the same manner as in Experimental Example 28-1, except that the composite solution of Polymer 19 and $PC_{71}BM$ was spin-coated at 1,500 rpm instead of 1,000 rpm in Experimental Example 28-1.

The photoelectric conversion characteristics of the organic solar cells manufactured in Experimental Examples 28-1 and 28-2 were measured under the condition of 100 mW/cm$^2$ (AM 1.5), and the results are shown in the following Table 25.

[Table 25]

| | $V_{OC}$ (V) | $J_{SC}$ (mA/cm$^2$) | FF (%) | PCE (%) |
|---|---|---|---|---|
| Experimental Example 28-1 | 0.794 | 12.254 | 0.571 | 5.55 |
| Experimental Example 28-2 | 0.782 | 12.335 | 0.580 | 5.60 |

FIG. 37 is a view illustrating the current density according to the voltage in the organic solar cells according to Experimental Examples 28-1 and 28-2.

$V_{oc}$, $J_{sc}$, FF, and PCE ($\eta$) mean an open-circuit voltage, a short-circuit current, a fill factor, and energy conversion efficiency, respectively. The open-circuit voltage and the short-circuit current are an X axis intercept and an Y axis intercept, respectively, in the fourth quadrant of the voltage-current density curve, and as the two values are increased, the efficiency of the solar cell is preferably increased. In addition, the fill factor is a value obtained by dividing the area of a rectangle, which may be drawn within the curve, by the product of the short-circuit current and the open-circuit voltage. The energy conversion efficiency may be obtained when these three values are divided by the intensity of the irradiated light, and the higher value is preferred. From the results in Tables 1 to 25, it can be confirmed that the polymer according to an exemplary embodiment of the present specification exhibits high efficiency.

[Explanation of Reference Numerals and Symbols]

101: Substrate
102: First electrode
103: Hole transporting layer
104: Photoactive layer
105: Second electrode

## Claims

**1.** A polymer consisting of:
a unit represented by any one of the following Chemical Formula 4-1, Chemical Formula 5-1, Chemical Formula 6-1, and Chemical Formula 7-1:

[Chemical Formula 4-1]

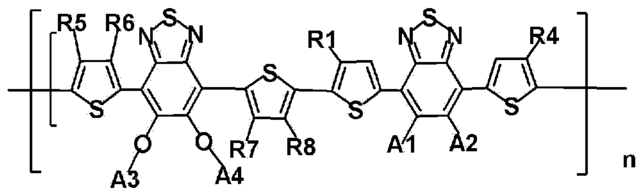

[Chemical Formula 5-1]

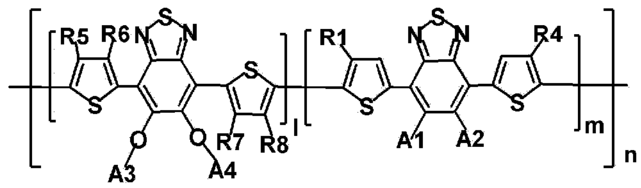

[Chemical Formula 6-1]

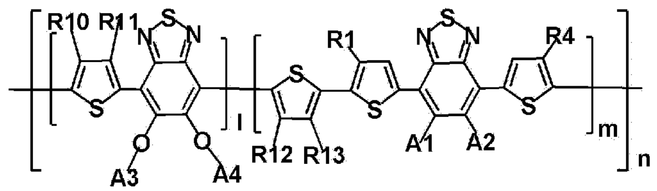

[Chemical Formula 7-1]

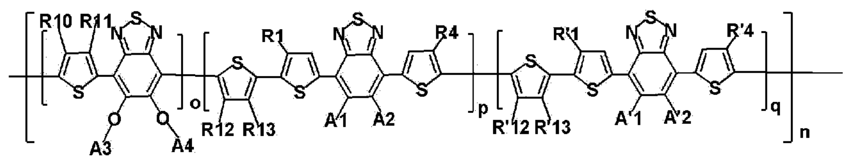

in Chemical Formula 4-1, Chemical Formula 5-1, Chemical Formula 6-1, and Chemical Formula 7-1,

A1, A2, A'1 and A'2 are the same as or different from each other, and are each independently hydrogen; or fluorine,
A3 and A4 are the same as or different from each other, and are each independently a substituted or unsubstituted alkyl group,
R1, R4 to R8, R'1, R'4, R10 to R13, R'12, and R'13 are the same as or different from each other, and are each independently hydrogen; or a substituted or unsubstituted alkyl group,
1 is a molar ratio and 0 < 1 < 1,
m is a molar ratio and 0 < m < 1,
o is a molar ratio and 0 < o < 1,
p is a molar ratio and 0 < p < 1,
q is a molar ratio and 0 < q < 1,
1 + m = 1,
o + p + q = 1, and

n is a repeating number of the unit, and an integer from 1 to 10,000,
wherein the polymer has a number average molecular weight of 5,000 g/mol to 1,000,000 g/mol, and
wherein the number average molecular weight is measured by GPC.

**2.** The polymer of claim 1, wherein the polymer comprises a unit represented by any one of the following Chemical Formulae 4-1-1 to 4-1-10, Chemical Formulae 5-1-1 to 5-1-3, Chemical Formulae 6-1-1 to 6-1-14, and Chemical Formulae 7-1-1 to 7-1-5:

[Chemical Formula 4-1-1]

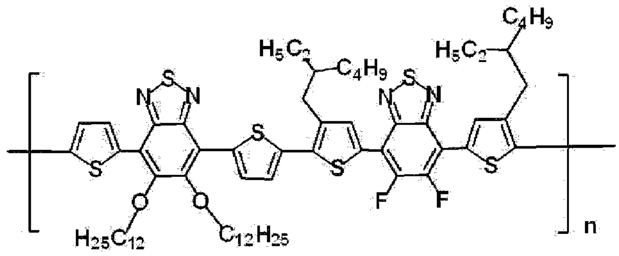

[Chemical Formula 4-1-2]

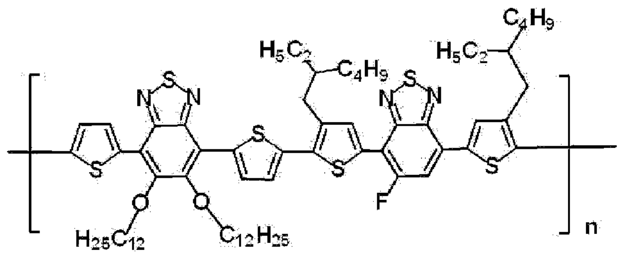

[Chemical Formula 4-1-3]

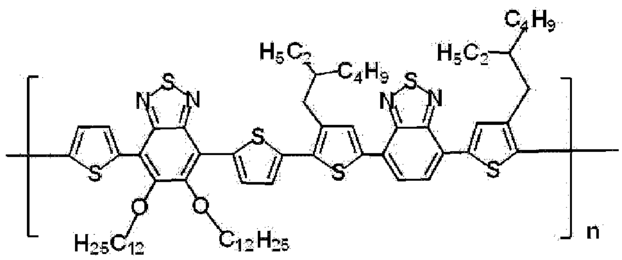

[Chemical Formula 4-1-4]

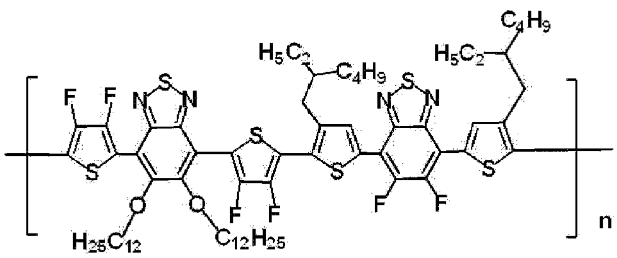

[Chemical Formula 4-1-5]

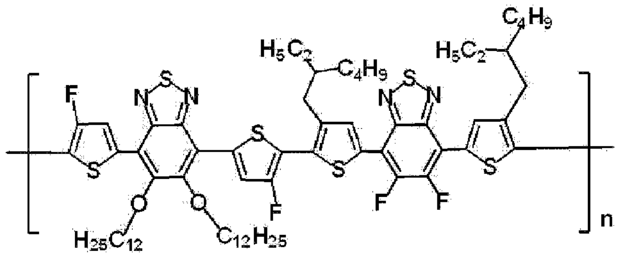

[Chemical Formula 4-1-6]

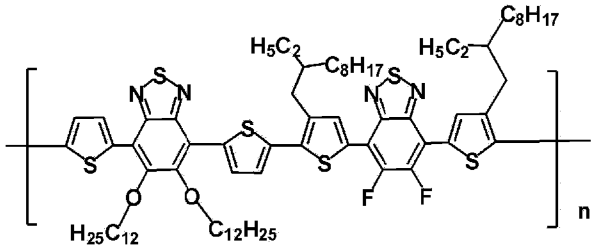

[Chemical Formula 4-1-7]

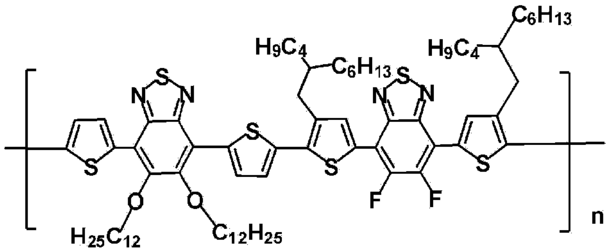

[Chemical Formula 4-1-8]

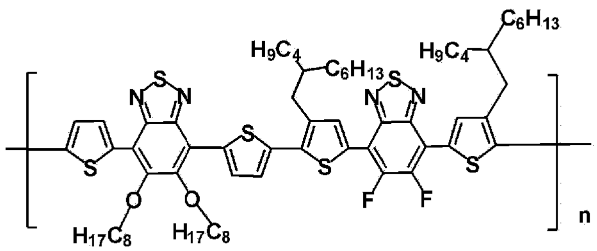

[Chemical Formula 4-1-9]

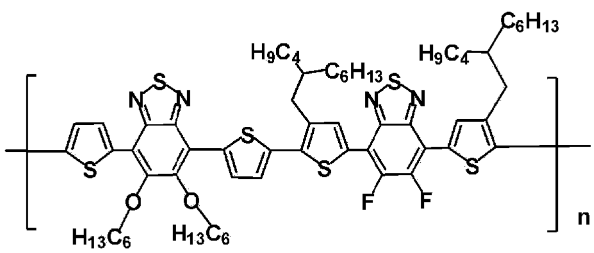

[Chemical Formula 4-1-10]

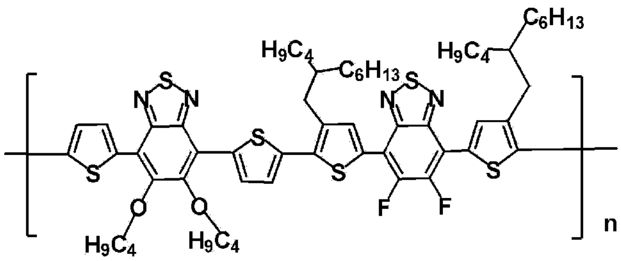

[Chemical Formula 5-1-1]

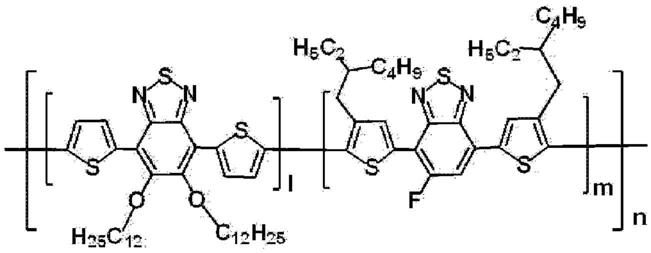

[Chemical Formula 5-1-2]

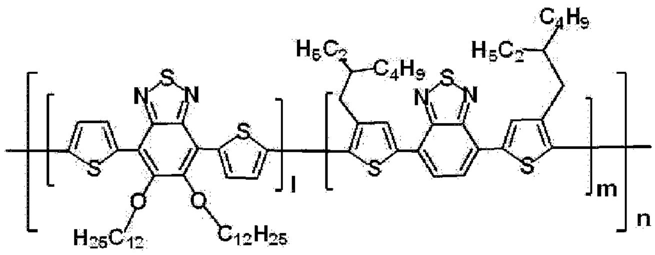

[Chemical Formula 5-1-3]

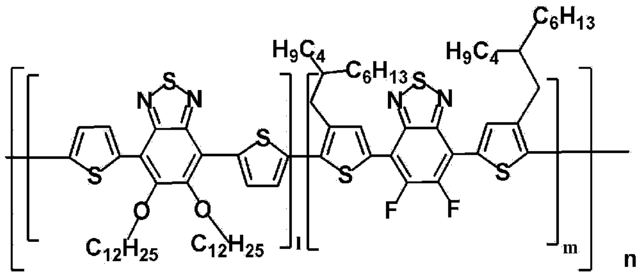

[Chemical Formula 6-1-1]

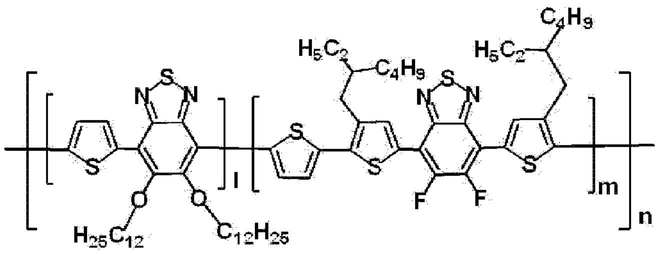

[Chemical Formula 6-1-2]

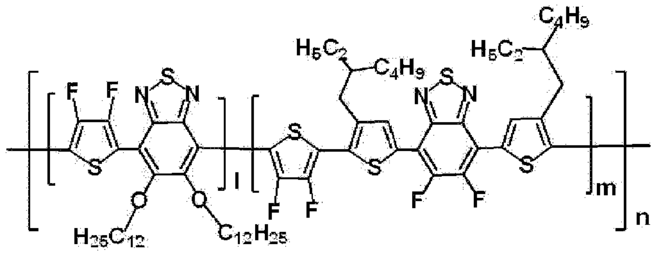

[Chemical Formula 6-1-3]

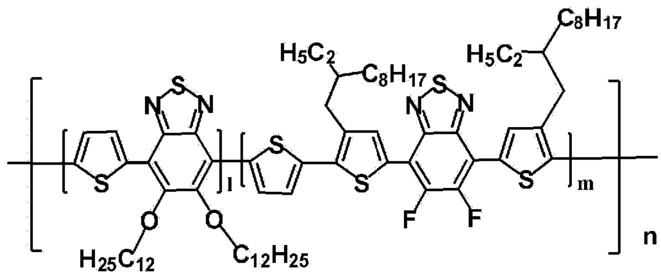

[Chemical Formula 6-1-4]

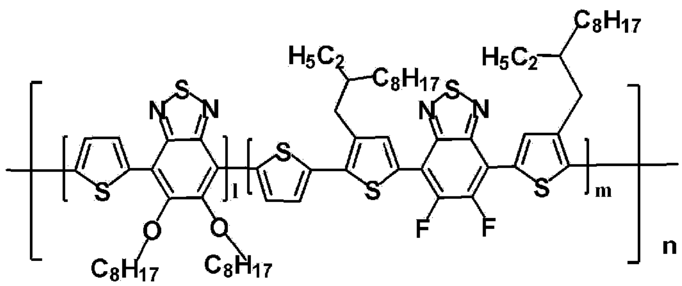

[Chemical Formula 6-1-5]

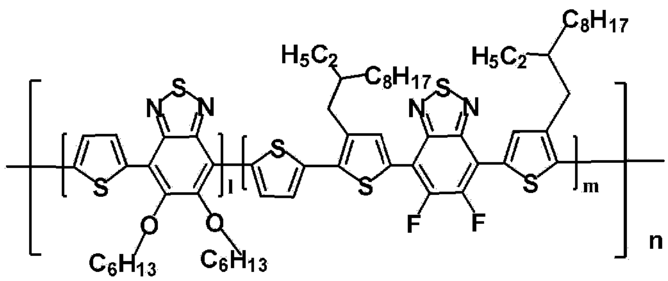

[Chemical Formula 6-1-6]

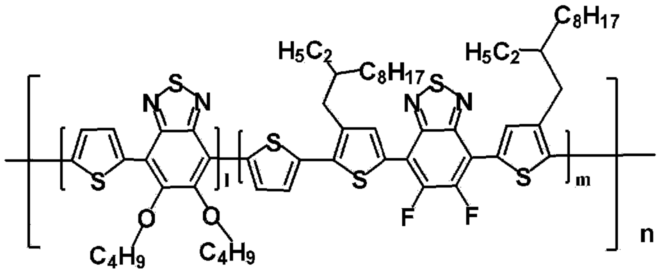

[Chemical Formula 6-1-7]

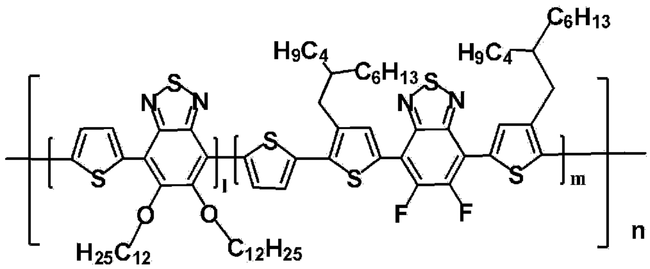

[Chemical Formula 6-1-8]

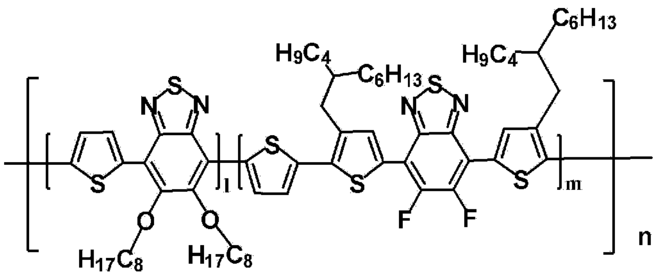

[Chemical Formula 6-1-9]

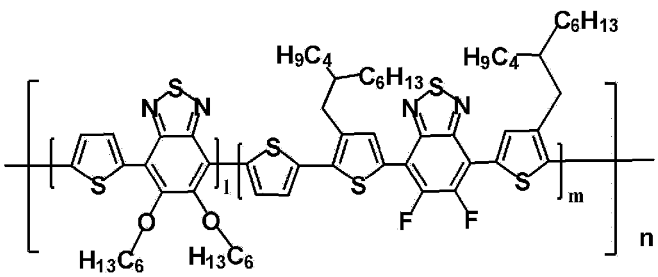

[Chemical Formula 6-1-10]

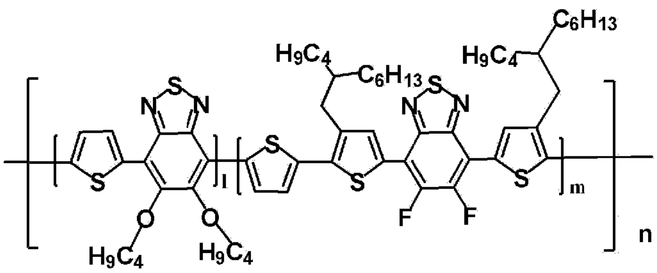

[Chemical Formula 6-1-11]

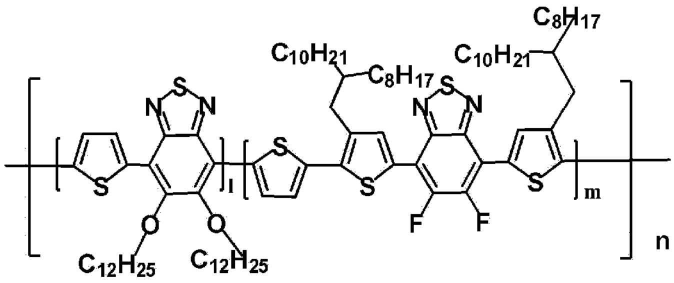

[Chemical Formula 6-1-12]

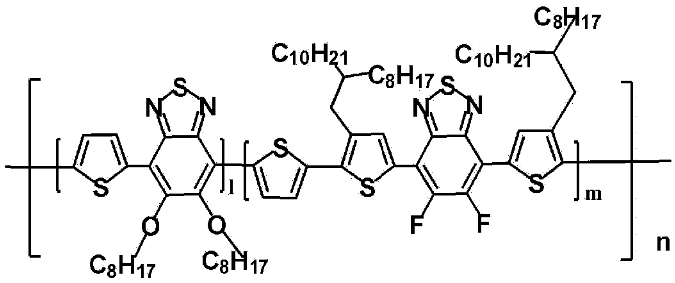

[Chemical Formula 6-1-13]

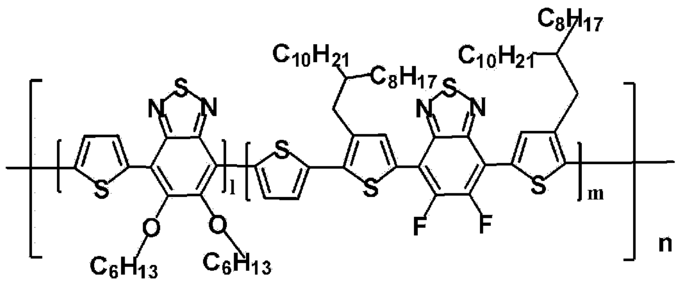

[Chemical Formula 6-1-14]

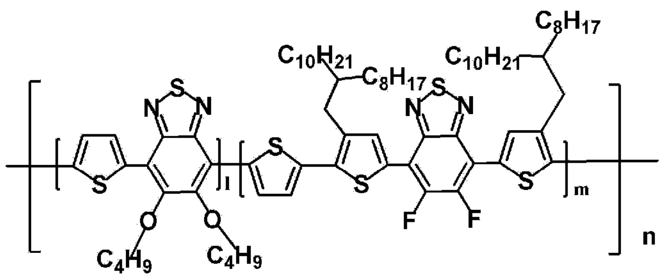

[Chemical Formula 7-1-1]

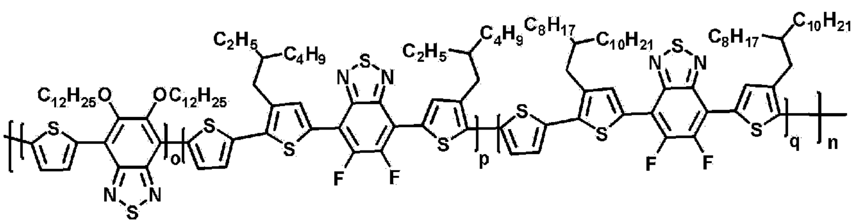

[Chemical Formula 7-1-2]

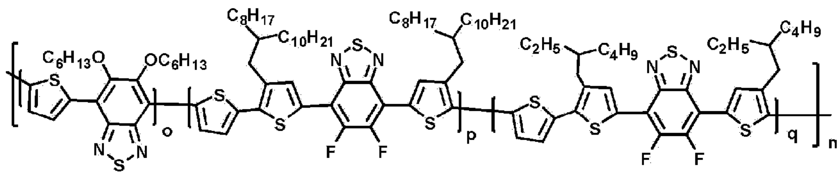

[Chemical Formula 7-1-3]

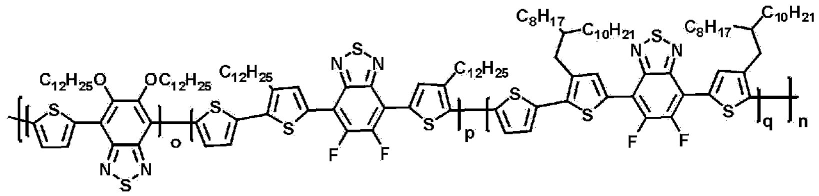

[Chemical Formula 7-1-4]

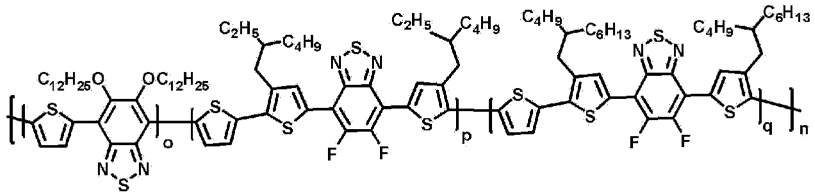

[Chemical Formula 7-1-5]

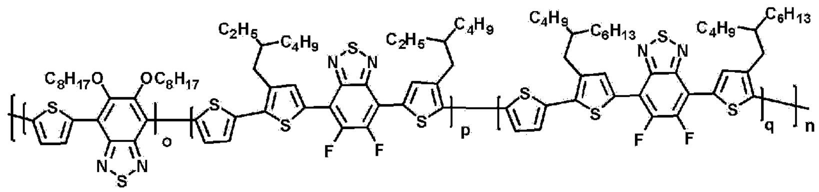

in Chemical Formulae 4-1-1 to 4-1-10, Chemical Formulae 5-1-1 to 5-1-3, Chemical Formulae 6-1-1 to 6-1-14, and Chemical Formulae 7-1-1 to 7-1-5,

1 is a molar ratio and 0 < 1 < 1,
m is a molar ratio and 0 < m < 1,
o is a molar ratio and 0 < o < 1,
p is a molar ratio and 0 < p < 1,
q is a molar ratio and 0 < q < 1,
1 + m = 1,
o + p + q = 1, and
n is a repeating number of the unit, and an integer from 1 to 10,000.

3. The polymer of claim 1, wherein the polymer has a HOMO energy level of 5 eV to 5.9 eV, wherein the HOMO energy level is measured by means of a cyclic voltammetry which is an electrochemical method.

4. The polymer of claim 1, wherein the polymer has a solubility of 0.1 wt% to 20 wt% for chlorobenzene.

5. The polymer of claim 1, wherein the polymer has a molecular weight distribution of 1 to 10, wherein the molecular weight is measured by GPC.

6. An organic solar cell comprising:

a first electrode;
a second electrode which is disposed to face the first electrode; and
an organic material layer having one or more layers which is disposed between the first electrode and the second electrode and comprises a photoactive layer,
wherein one or more layers of the organic material layer comprise the polymer of any one of claims 1 to 5.

7. The organic solar cell of claim 6, wherein the photoactive layer comprises one or two or more selected from the group consisting of an electron donor and an electron acceptor, and
the electron donor comprises the polymer.

8. The organic solar cell of claim 7, wherein the photoactive layer further comprises an additive.

9. The organic solar cell of claim 6, wherein the photoactive layer has a bilayer thin film structure comprising an n-type organic material layer and a p-type organic material layer, and
the p-type organic material layer comprises the polymer.

## Patentansprüche

1. Polymer, bestehend aus:
einer durch irgendeine der folgenden chemischen Formel 4-1, chemischen Formel 5-1, chemischen Formel 6-1 und chemischen Formel 7-1 dargestellten Einheit:

[Chemische Formel 4-1]

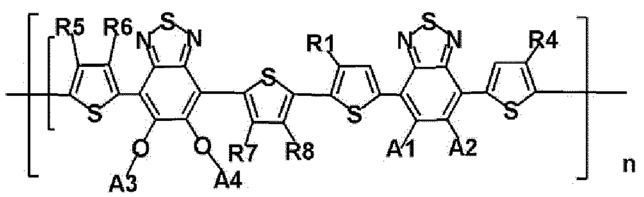

[Chemische Formel 5-1]

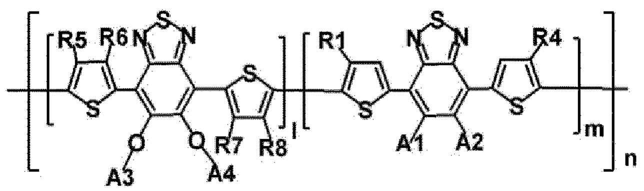

[Chemische Formel 6-1]

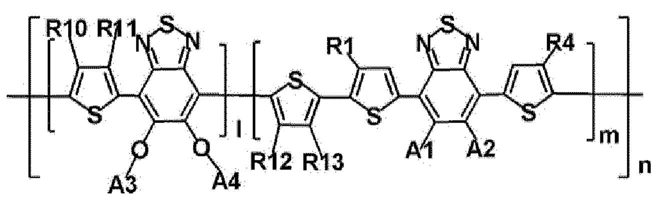

[Chemische Formel 7-1]

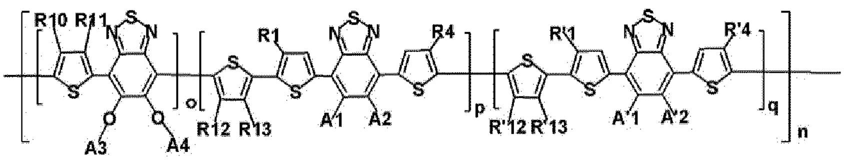

in der chemischen Formel 4-1, chemischen Formel 5-1, chemischen Formel 6-1 und chemischen Formel 7-1

sind A1, A2, A'1, A'2 gleich oder verschieden voneinander und sind jeweils unabhängig Wasserstoff oder Fluor,
A3 und A4 sind gleich oder verschieden voneinander und sind jeweils unabhängig eine substituierte oder unsubstituierte Alkylgruppe,
R1, R4 bis R8, R'1, R'4, R10 bis R13, R'12 und R'13 sind gleich oder verschieden voneinander und sind jeweils unabhängig Wasserstoff oder eine substituierte oder unsubstituierte Alkylgruppe,
l ist ein Molanteil und $0 < l < 1$,
m ist ein Molanteil und $0 < m < 1$,
o ist ein Molanteil und $0 < o < 1$,
p ist ein Molanteil und $0 < p < 1$,
q ist ein Molanteil und $0 < q < 1$,
$l + m = 1$
$o + p + q = 1$ und
n ist eine Wiederholungsanzahl der Einheit und eine ganze Zahl von 1 bis 10.000,
wobei das Polymer ein zahlengemitteltes Molekulargewicht von 5.000 g/mol bis 1.000.000 g/mol aufweist und wobei das zahlengemittelte Molekulargewicht durch GPC gemessen wird.

2. Polymer gemäß Anspruch 1, wobei das Polymer eine durch irgendeine der folgenden chemischen Formeln 4-1-1 bis 4-1-10, chemischen Formeln 5-1-1 bis 5-1-3, chemischen Formeln 6-1-1 bis 6-1-14 und chemischen Formeln 7-1-1 bis 7-1-5 dargestellte Einheit umfasst:

[Chemische Formel 4-1-1]

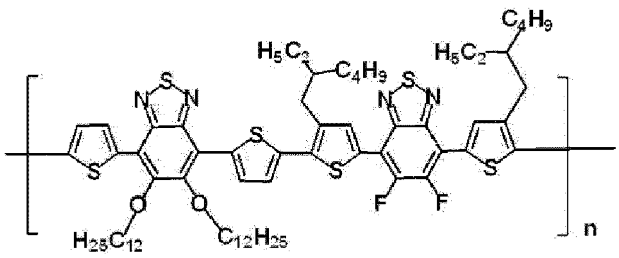

[Chemische Formel 4-1-2]

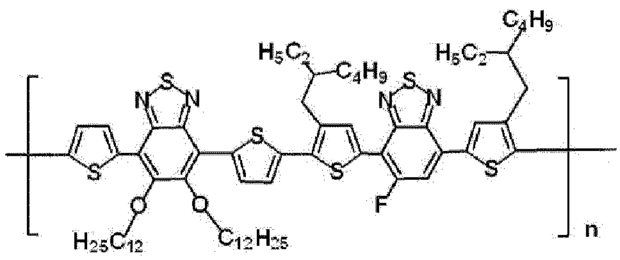

[Chemische Formel 4-1-3]

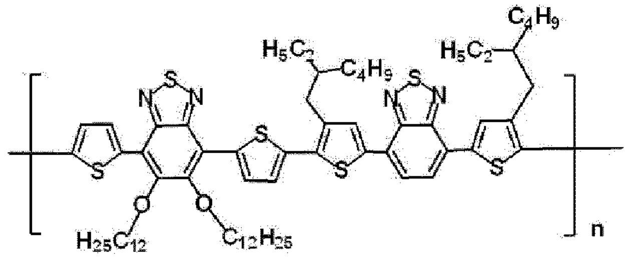

[Chemische Formel 4-1-4]

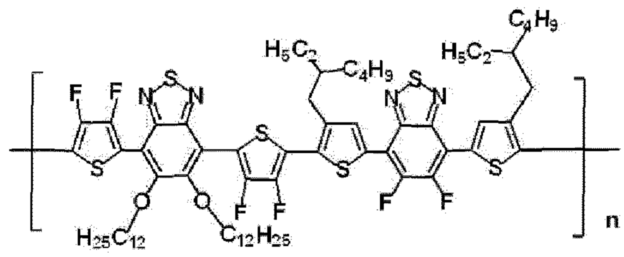

[Chemische Formel 4-1-5]

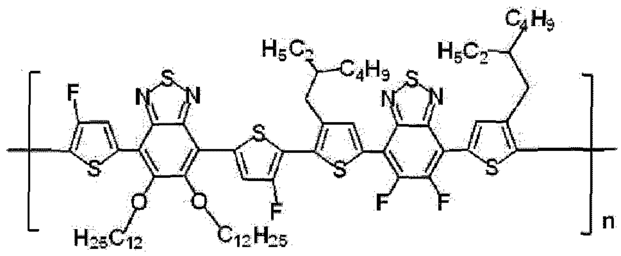

[Chemische Formel 4-1-6]

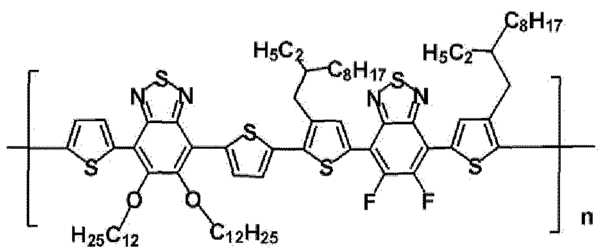

[Chemische Formel 4-1-7]

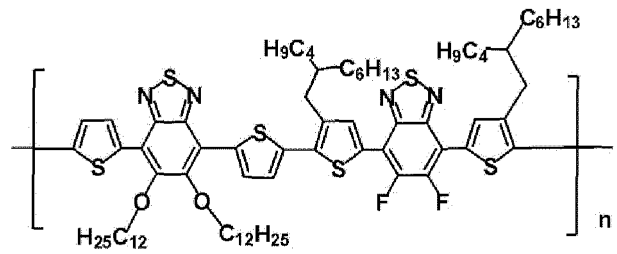

[Chemische Formel 4-1-8]

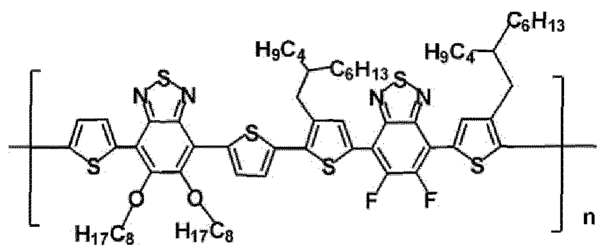

[Chemische Formel 4-1-9]

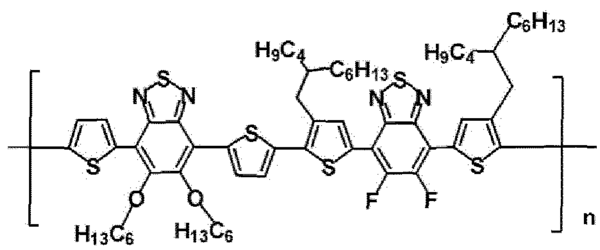

[Chemische Formel 4-1-10]

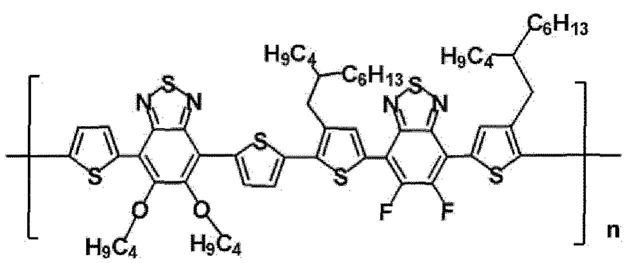

[Chemische Formel 5-1-1]

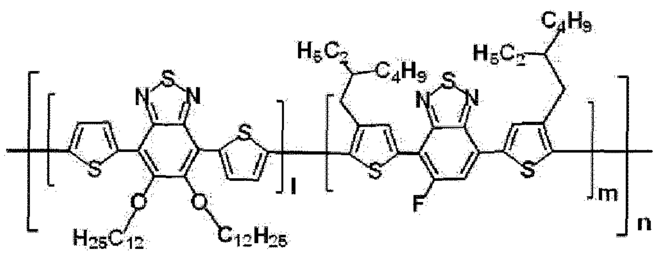

[Chemische Formel 5-1-2]

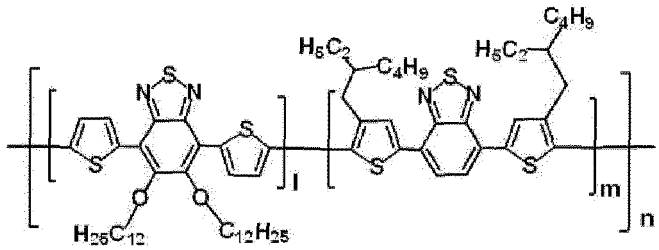

[Chemische Formel 5-1-3]

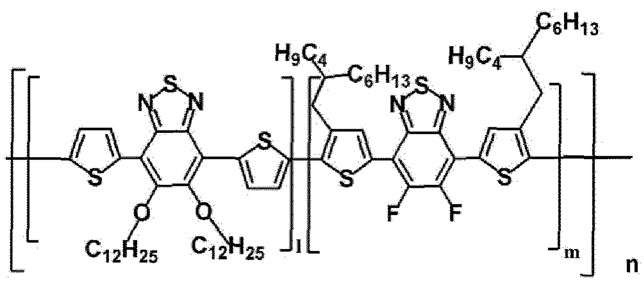

[Chemische Formel 6-1-1]

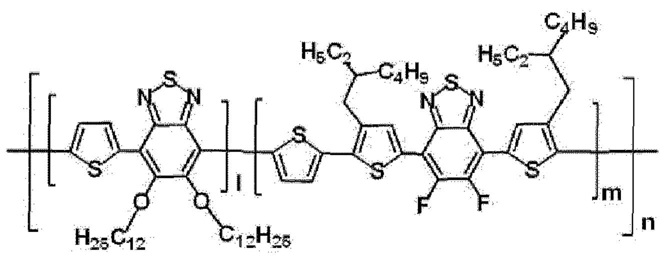

[Chemische Formel 6-1-2]

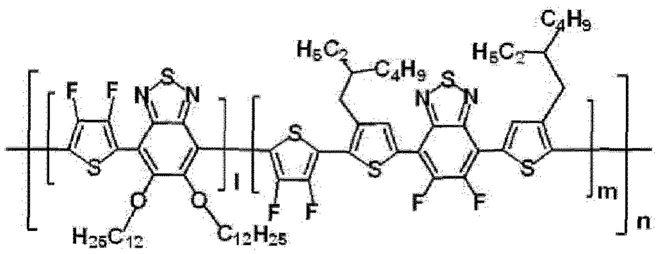

[Chemische Formel 6-1-3]

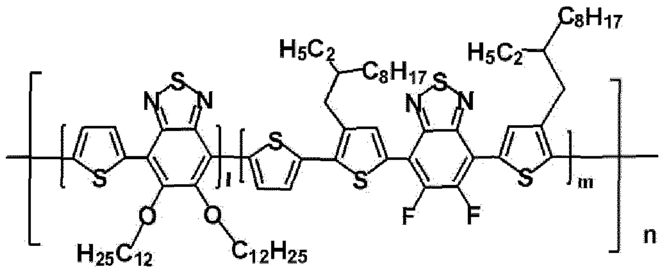

[Chemische Formel 6-1-4]

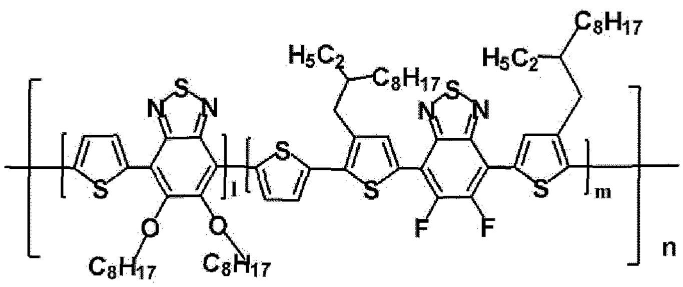

[Chemische Formel 6-1-5]

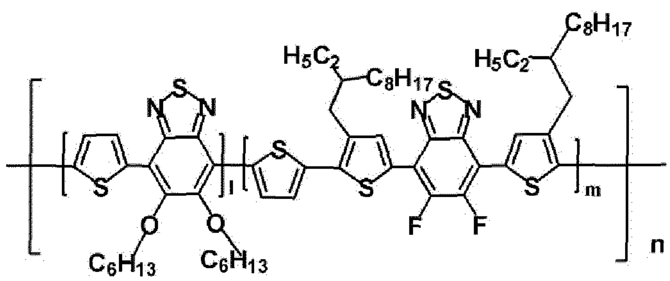

[Chemische Formel 6-1-6]

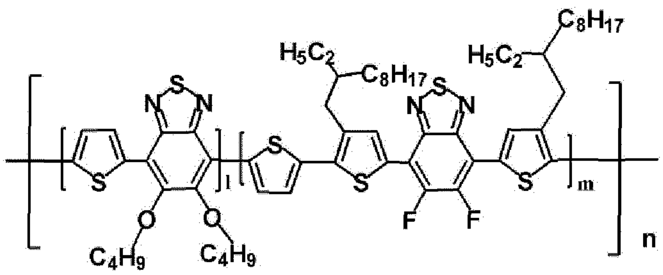

[Chemische Formel 6-1-7]

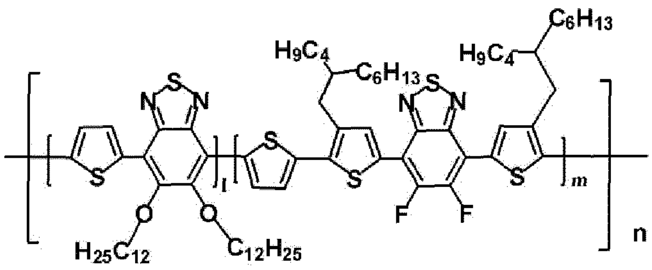

[Chemische Formel 6-1-8]

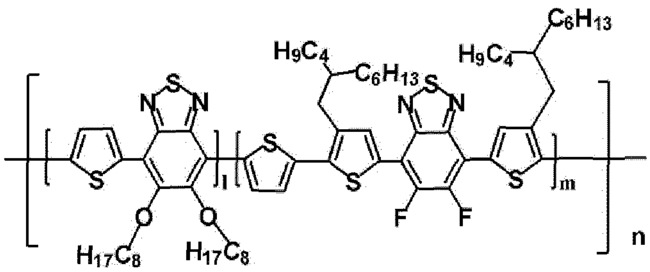

[Chemische Formel 6-1-9]

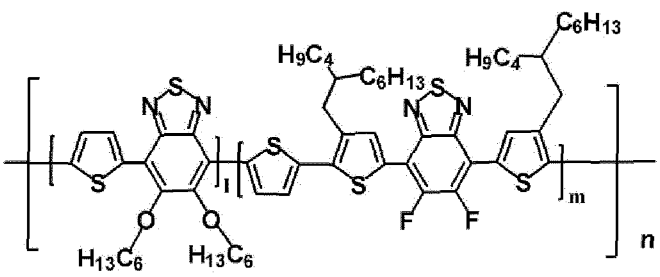

[Chemische Formel 6-1-10]

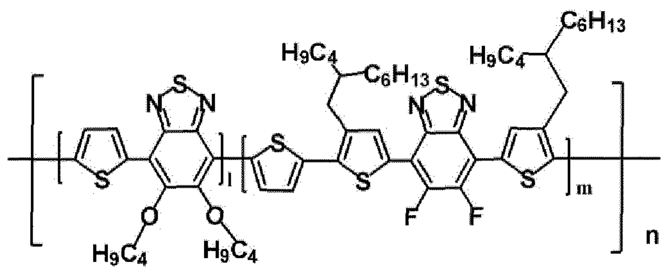

[Chemische Formel 6-1-11]

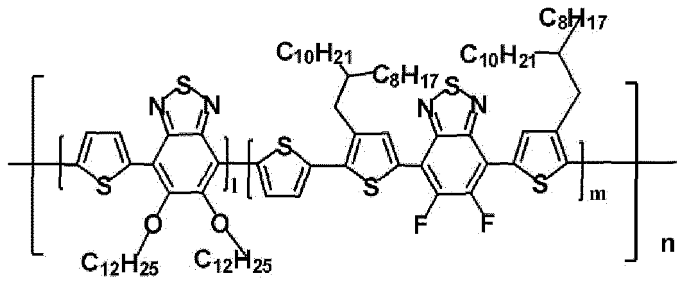

[Chemische Formel 6-1-12]

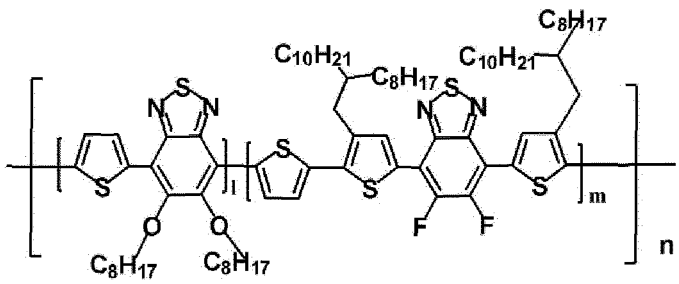

[Chemische Formel 6-1-13]

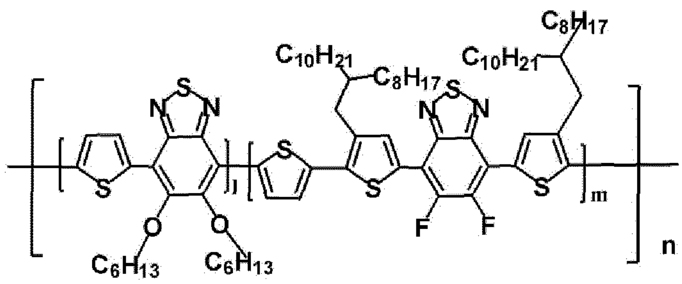

[Chemische Formel 6-1-14]

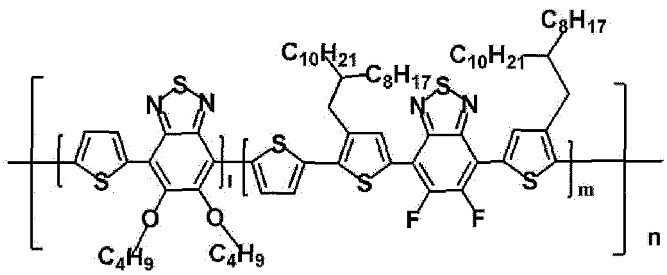

[Chemische Formel 7-1-1]

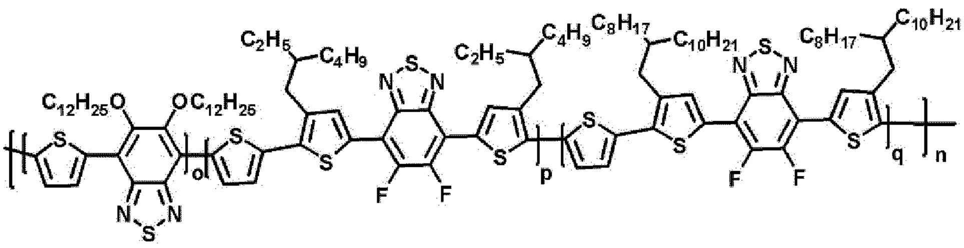

[Chemische Formel 7-1-2]

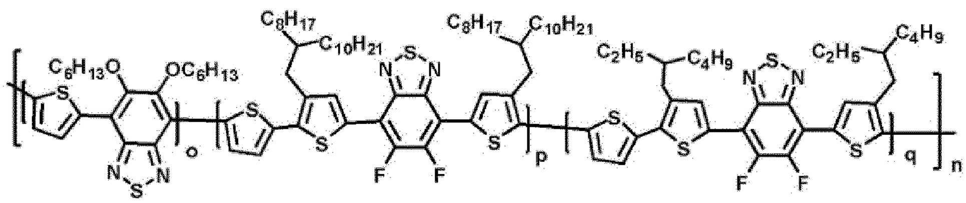

[Chemische Formel 7-1-3]

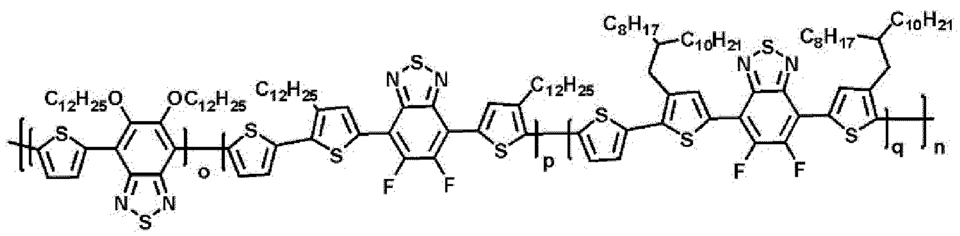

[Chemische Formel 7-1-4]

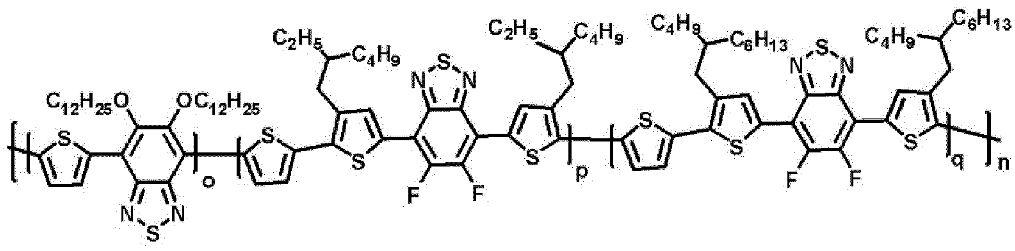

[Chemische Formel 7-1-5]

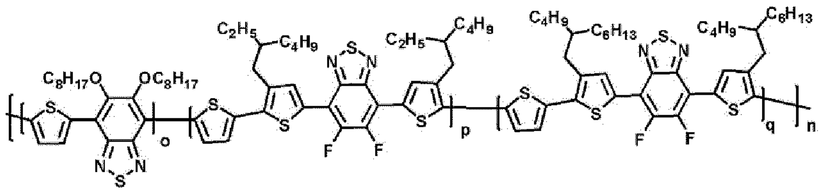

in den chemischen Formeln 4-1-1 bis 4-1-10, chemischen Formeln 5-1-1 bis 5-1-3, chemischen Formeln 6-1-1 bis 6-1-14 und chemischen Formeln 7-1-1 bis 7-1-5

ist l ein Molanteil und $0 < l < 1$,
m ist ein Molanteil und $0 < m < 1$,
o ist ein Molanteil und $0 < o < 1$,
p ist ein Molanteil und $0 < p < 1$,
q ist ein Molanteil und $0 < q < 1$,
$l + m = 1$
$o + p + q = 1$ und
n ist eine Wiederholungsanzahl der Einheit und eine ganze Zahl von 1 bis 10.000.

**3.** Polymer gemäß Anspruch 1, wobei das Polymer eine HOMO-Energieniveau von 5 eV bis 5,9 eV aufweist, wobei das HOMO-Energieniveau mittels Cyclovoltametrie, die ein elektrochemisches Verfahren ist, gemessen wird.

**4.** Polymer gemäß Anspruch 1, wobei das Polymer eine Löslichkeit von 0,1 Gew.-% bis 20 Gew.-% in Chlorbenzol aufweist.

**5.** Polymer gemäß Anspruch 1, wobei das Polymer eine Molekulargewichtsverteilung von 1 bis 10 aufweist, wobei das Molekulargewicht durch GPC gemessen wird.

**6.** Organische Solarzelle, umfassend:

eine erste Elektrode,
eine zweite Elektrode, die so angeordnet ist, dass sie der ersten Elektrode gegenübersteht, und
eine organische Materialschicht mit einer oder mehreren Schichten, die zwischen der ersten Elektrode und der zweiten Elektrode angeordnet ist und eine photoaktive Schicht umfasst,
wobei eine oder mehrere Schichten der organischen Materialschicht das Polymer gemäß irgendeinem der Ansprüche 1 bis 5 umfasst.

**7.** Organische Solarzelle gemäß Anspruch 6, wobei die photoaktive Schicht einen oder zwei oder mehr, ausgewählt aus der Gruppe, bestehend aus einem Elektronendonor und einem Elektronenakzeptor, umfasst und der Elektronendonor das Polymer umfasst.

**8.** Organische Solarzelle gemäß Anspruch 7, wobei die photoaktive Schicht ferner ein Additiv umfasst.

**9.** Organische Solarzelle gemäß Anspruch 6, wobei die photoaktive Schicht eine Doppelschicht-Dünnfilmstruktur aufweist, die eine organische Materialschicht vom n-Typ und eine organische Materialschicht vom p-Typ umfasst, und die organische Materialschicht vom p-Typ das Polymer umfasst.

## Revendications

**1.** Polymère consistant en :
une unité représentée par l'une quelconque parmi la formule chimique 4-1, la formule chimique 5-1, la formule chimique 6-1 et la formule chimique 7-1 suivantes :

[Formule chimique 4-1]

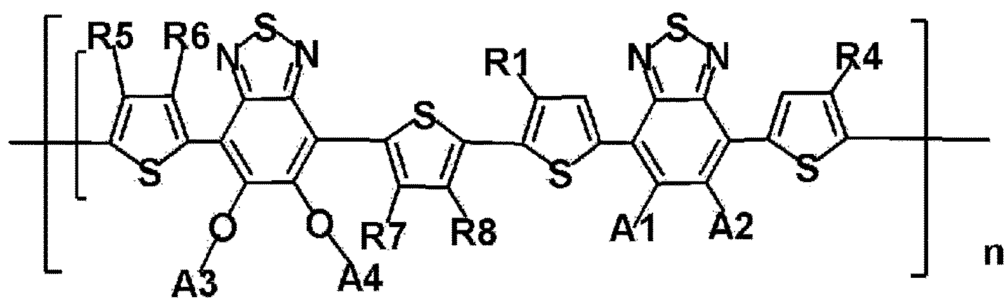

[Formule chimique 5-1]

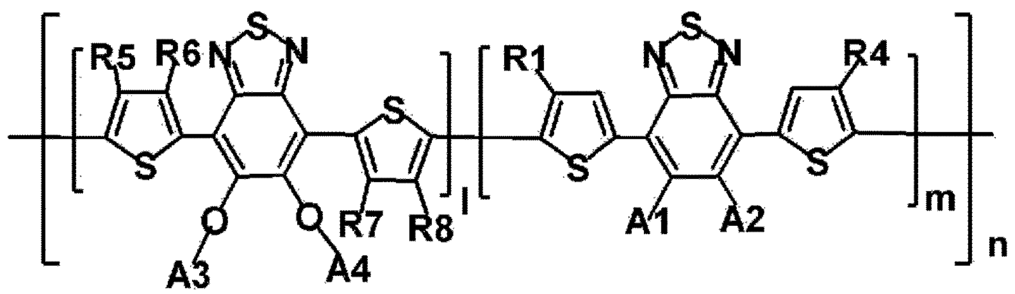

[Formule chimique 6-1]

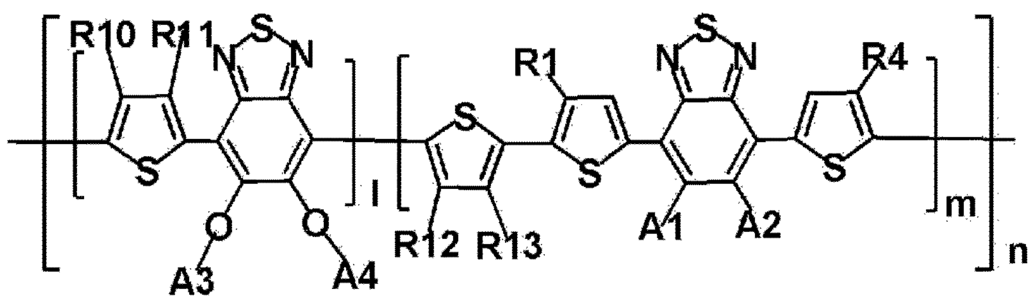

[Formule chimique 7-1]

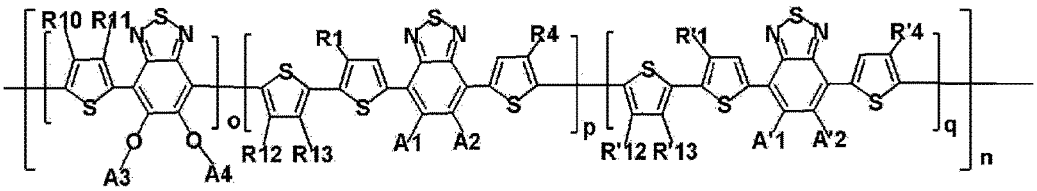

dans la formule chimique 4-1, la formule chimique 5-1, la formule 6-1 et la formule chimique 7-1,

A1, A2, A' 1 et A' 2 sont identiques les uns aux autres ou différents les uns des autres, et représentent chacun indépendamment un hydrogène ; ou un fluor,
A3 et A4 sont identiques les uns aux autres ou différents les uns des autres, et représentent chacun indépendamment un groupe alkyle substitué ou non substitué,
R1, R4 à R8, R' 1, R'4, R10 à R13, R'12 et R'13 sont identiques les uns aux autres ou différents les uns des autres, et représentent chacun indépendamment un hydrogène ; ou un groupe alkyle substitué ou non substitué,
l représente un rapport molaire et $0 < l < 1$,
m représente un rapport molaire et $0 < m < 1$,
o représente un rapport molaire et $0 < o < 1$,
p représente un rapport molaire et $0 < p < 1$,
q représente un rapport molaire et $0 < q < 1$,
$1 + m = 1$,
$o + p + q = 1$, et
n représente un nombre répétitif de l'unité, et un nombre entier allant de 1 à 10 000,
dans lequel le polymère présente une masse moléculaire moyenne en nombre allant de 5000 g/ml à 1 000 000 g/mol, et
dans lequel la masse moléculaire moyenne en nombre est mesurée par GPC.

**2.** Polymère selon la revendication 1, dans lequel le polymère comprend une unité représentée par l'une quelconque des formules chimiques suivantes 4-1-1 à 4-1-10, les formules chimiques 5-1-1 à 5-1-3, les formules chimiques 6-1-1 à 6-1-14, et les formules chimiques 7-1-1 à 7-1-5 :

[Formule chimique 4-1-1]

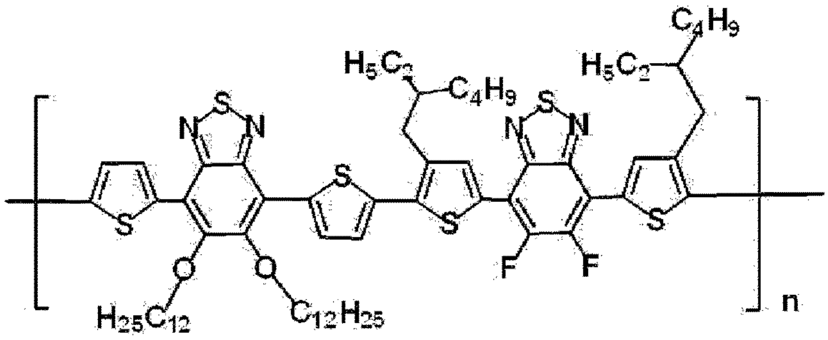

[Formule chimique 4-1-2]

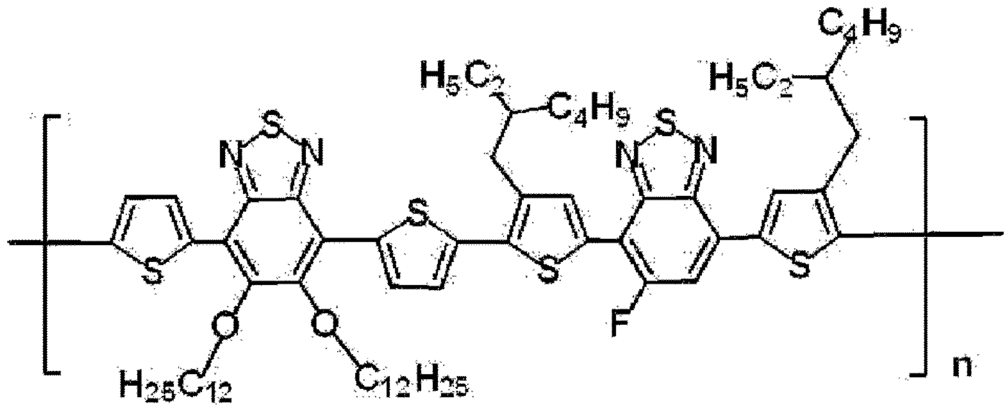

[Formule chimique 4-1-3]

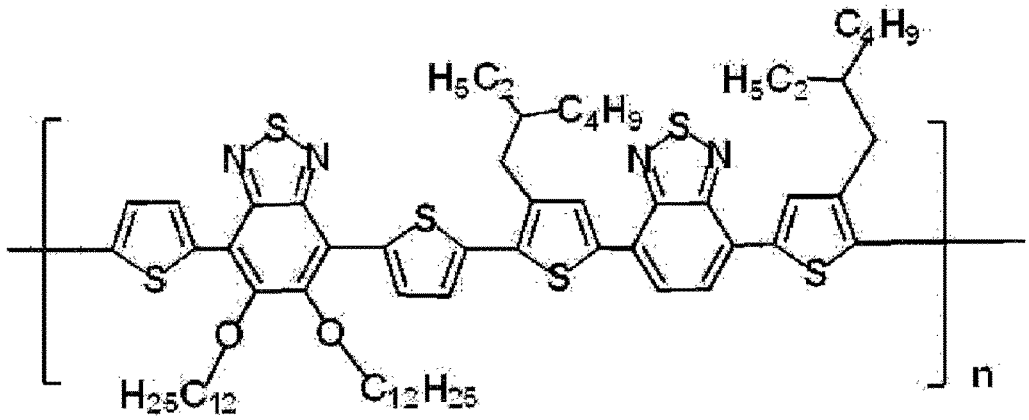

[Formule chimique 4-1-4]

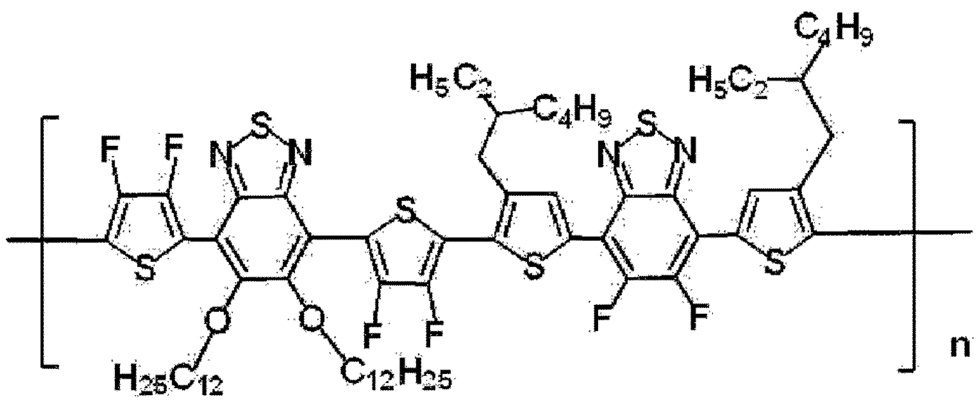

[Formule chimique 4-1-5]

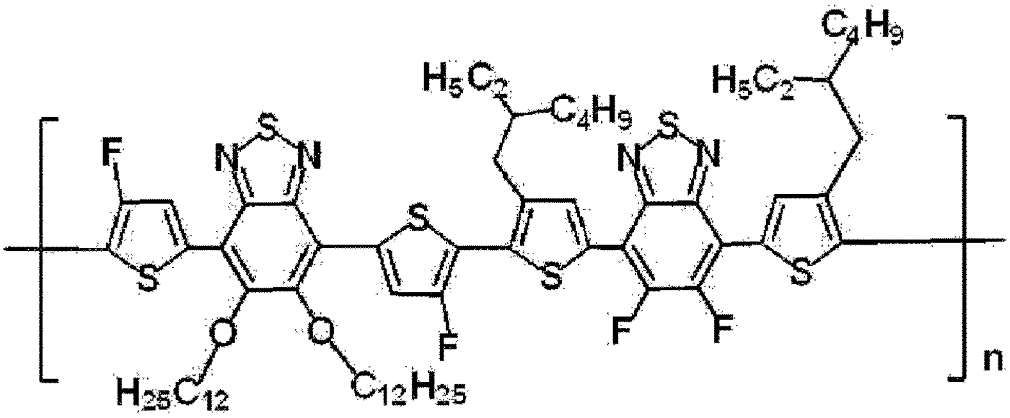

[Formule chimique 4-1-6]

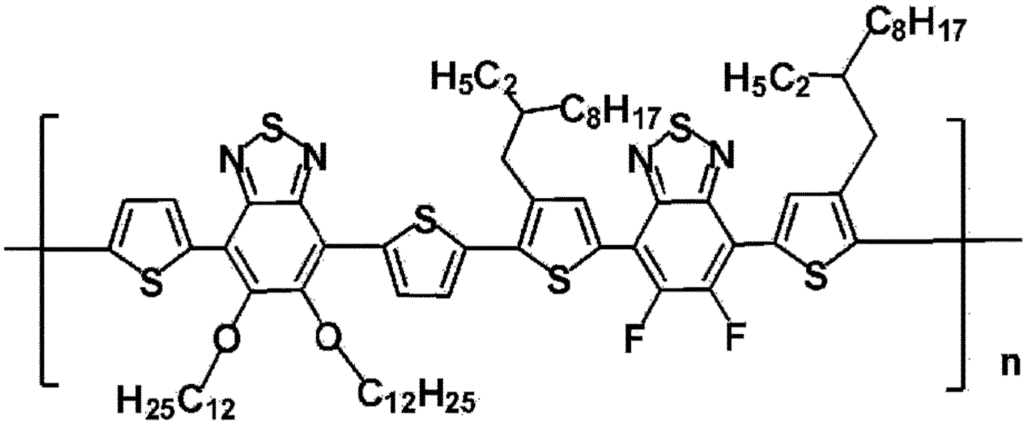

[Formule chimique 4-1-7]

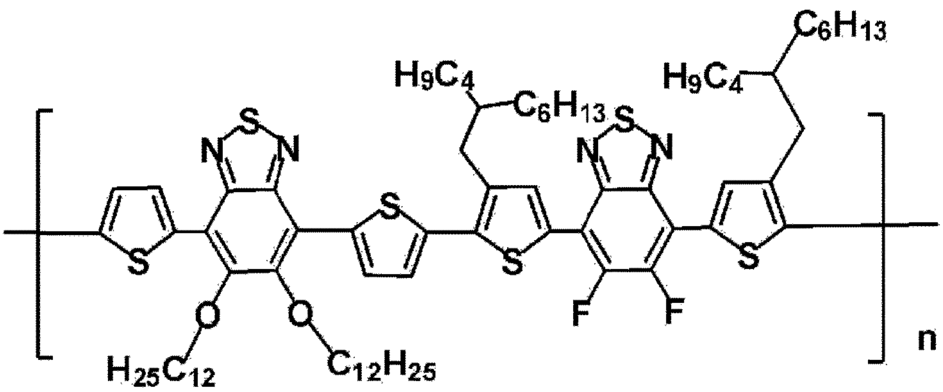

[Formule chimique 4-1-8]

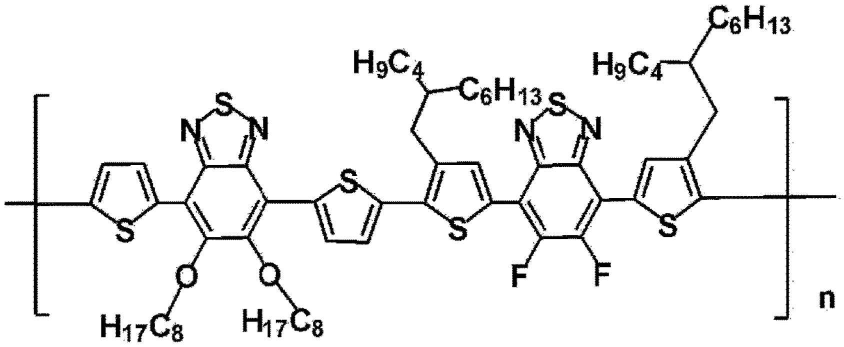

[Formule chimique 4-1-9]

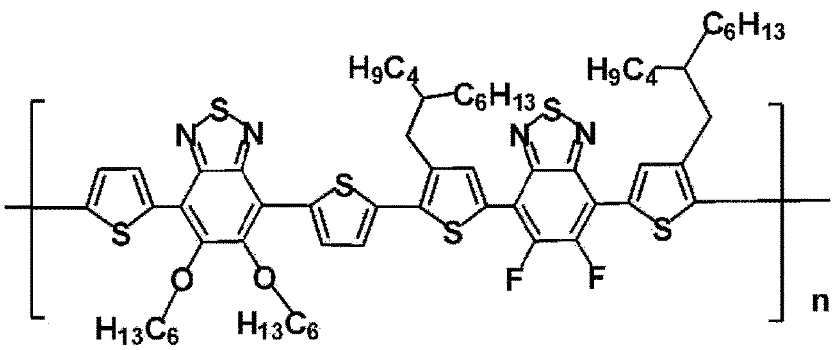

[Formule chimique 4-1-10]

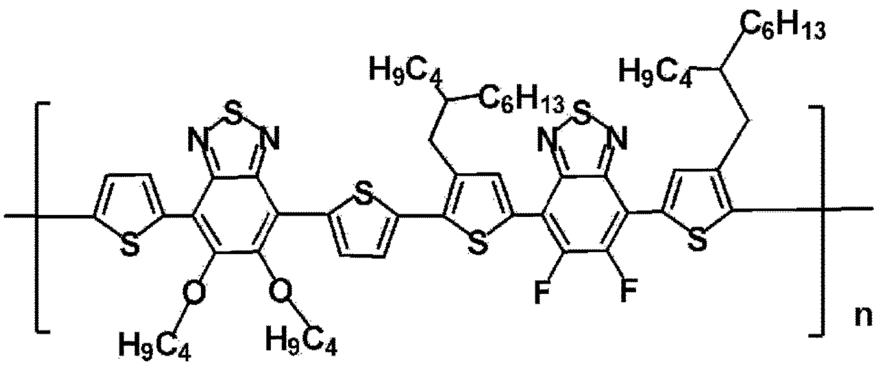

[Formule chimique 5-1-1]

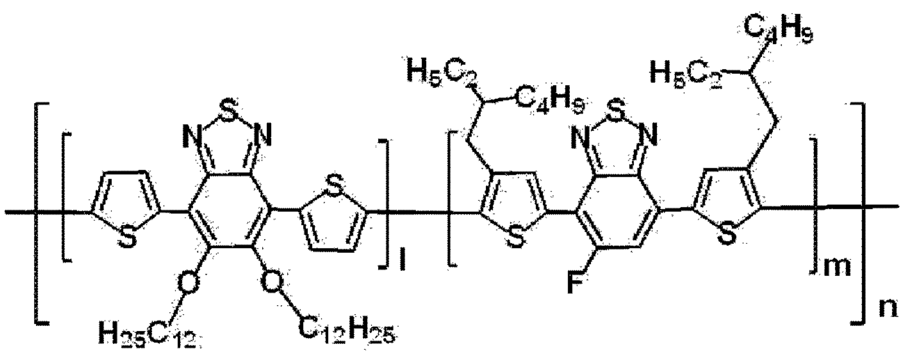

[Formule chimique 5-1-2]

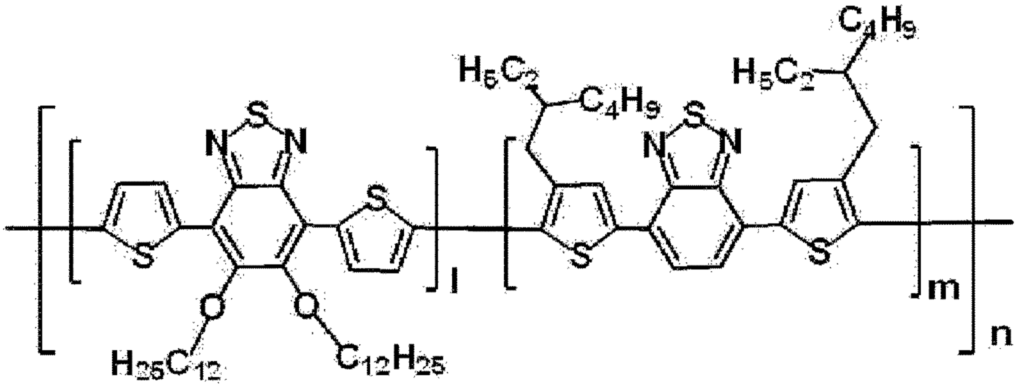

[Formule chimique 5-1-3]

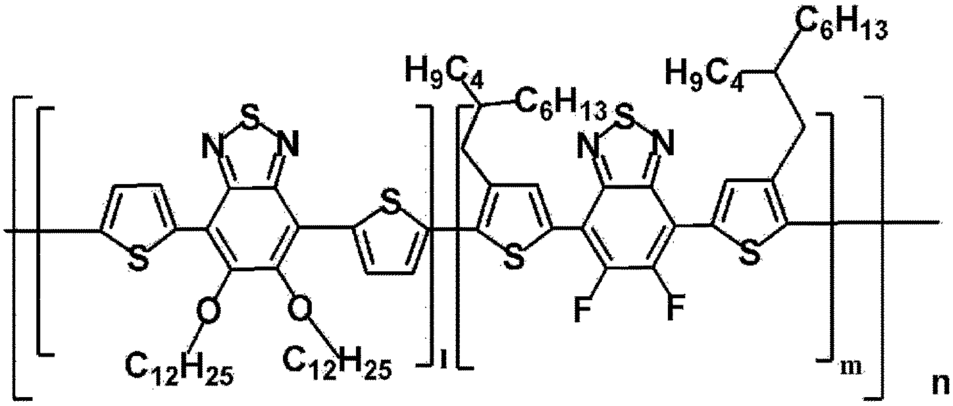

[Formule chimique 6-1-1]

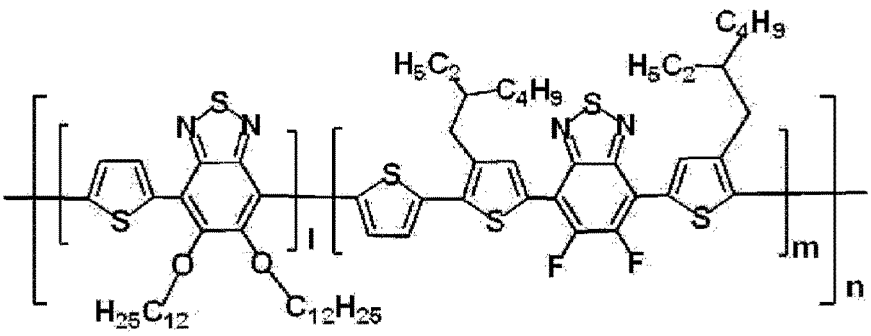

[Formule chimique 6-1-2]

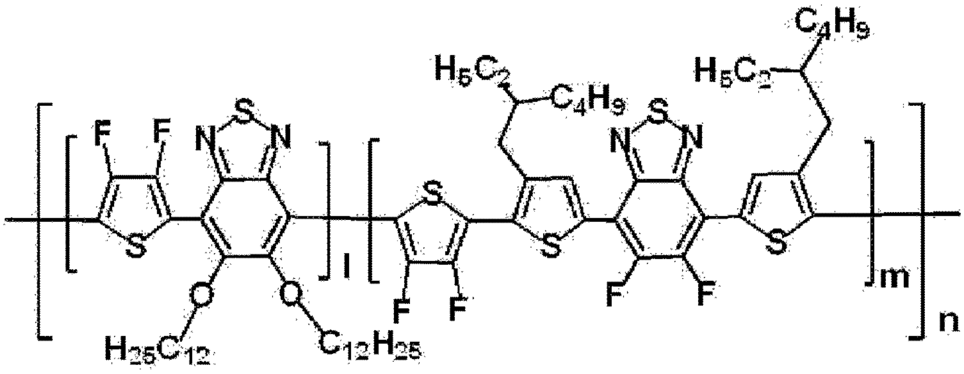

[Formule chimique 6-1-3]

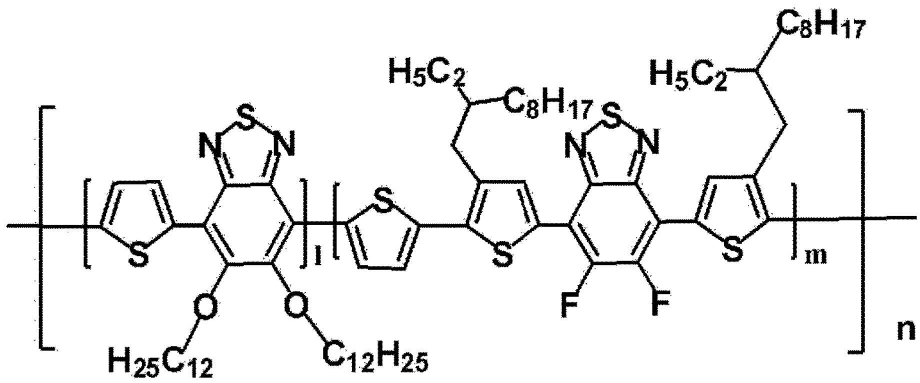

[Formule chimique 6-1-4]

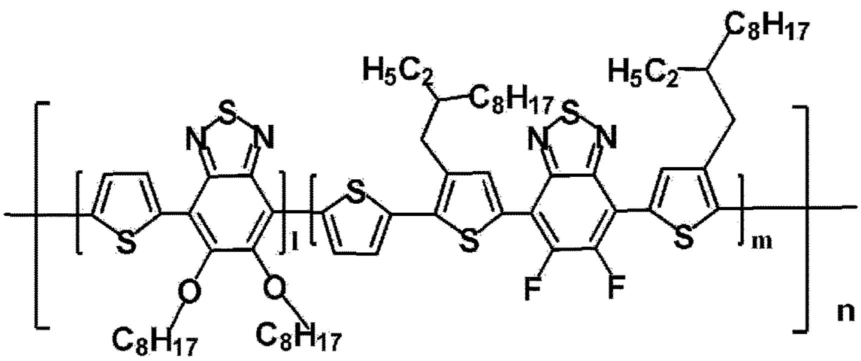

[Formule chimique 6-1-5]

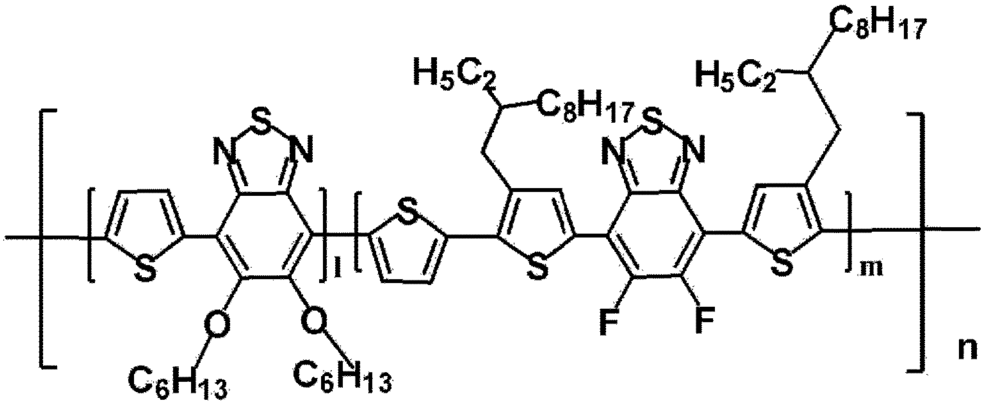

[Formule chimique 6-1-6]

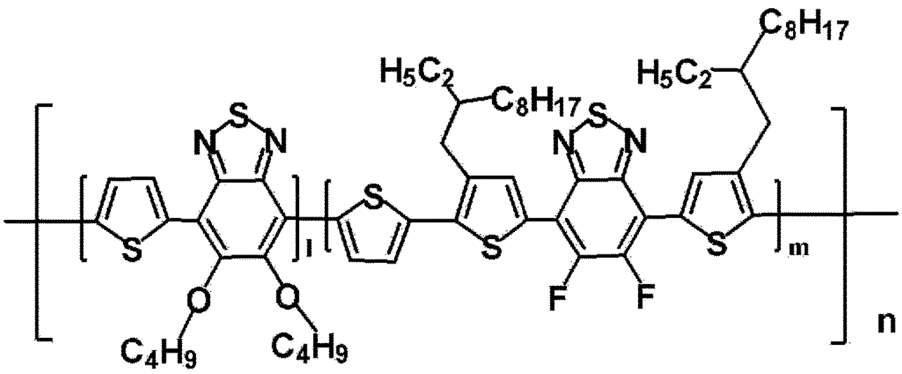

[Formule chimique 6-1-7]

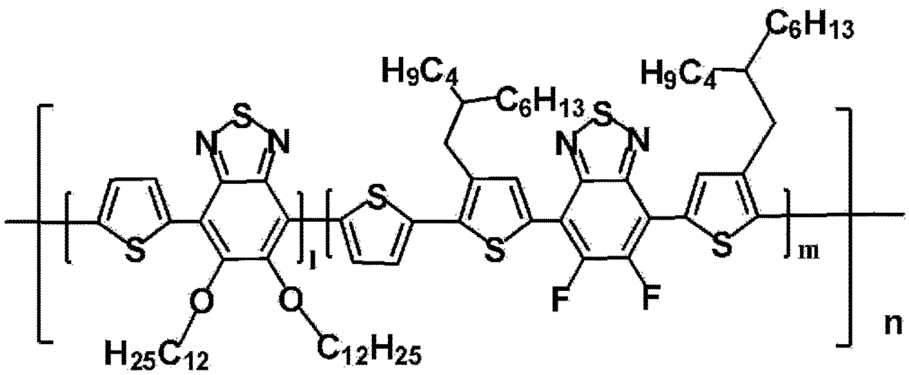

[Formule chimique 6-1-8]

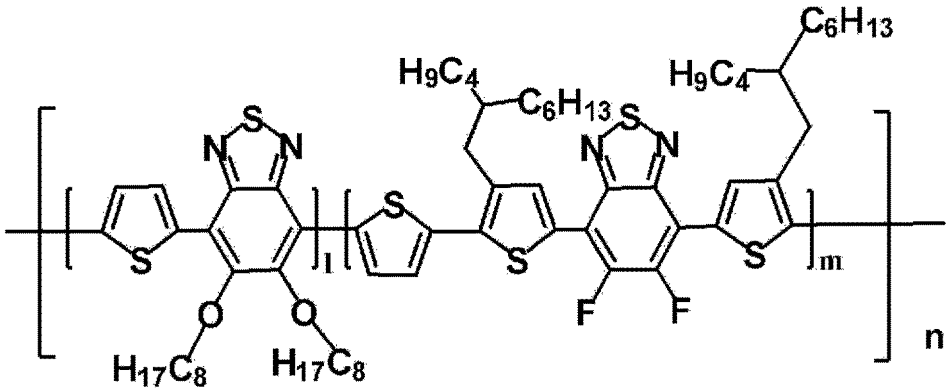

[Formule chimique 6-1-9]

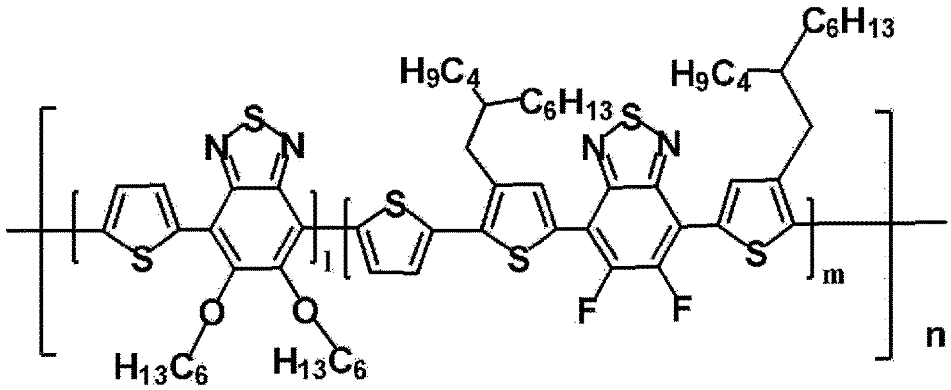

[Formule chimique 6-1-10]

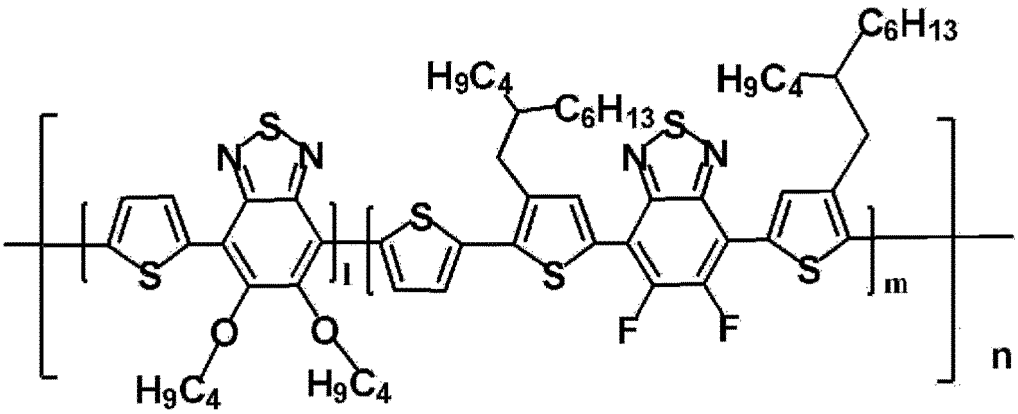

[Formule chimique 6-1-11]

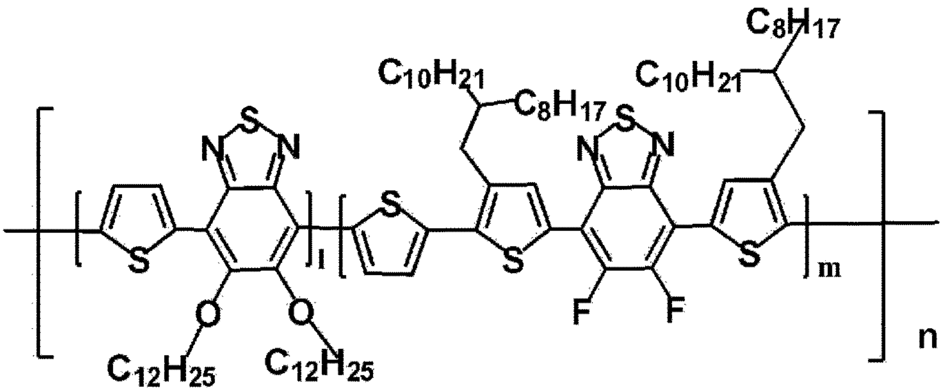

[Formule chimique 6-1-12]

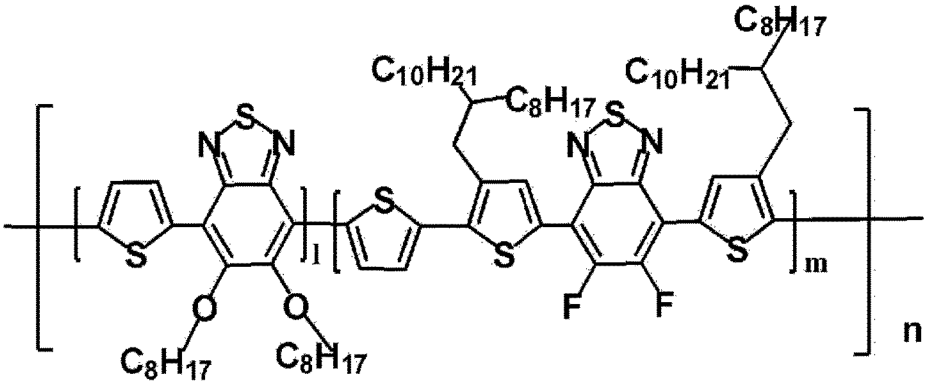

[Formule chimique 6-1-13]

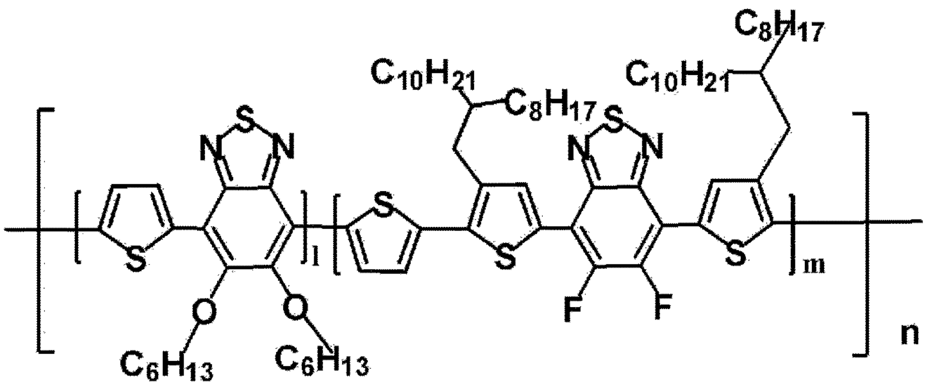

[Formule chimique 6-1-14]

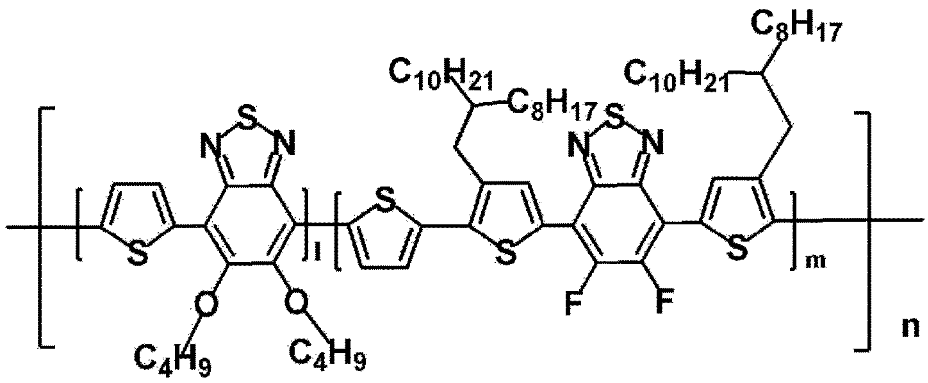

[Formule chimique 7-1-1]

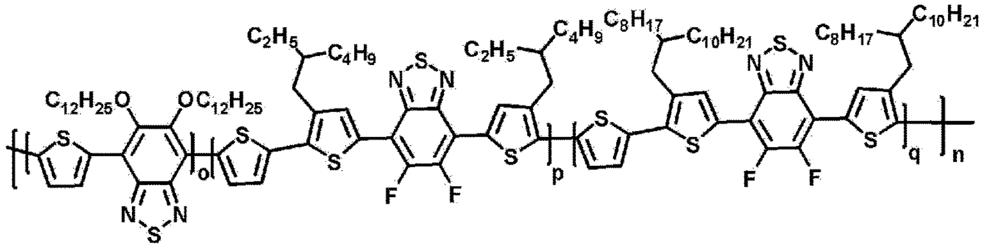

[Formule chimique 7-1-2]

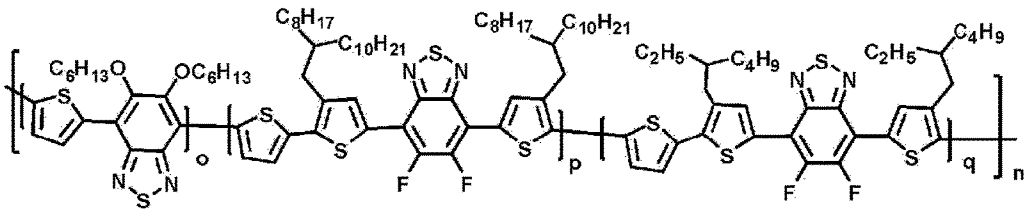

[Formule chimique 7-1-3]

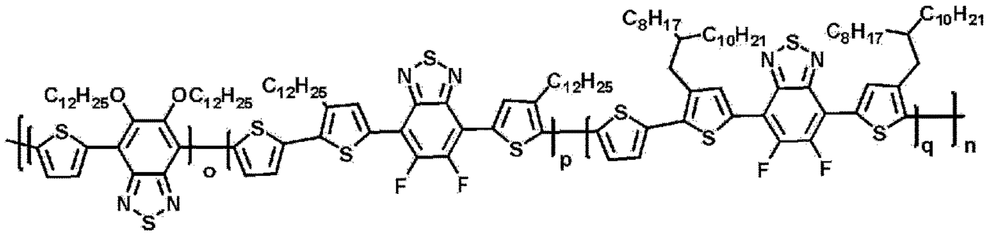

[Formule chimique 7-1-4]

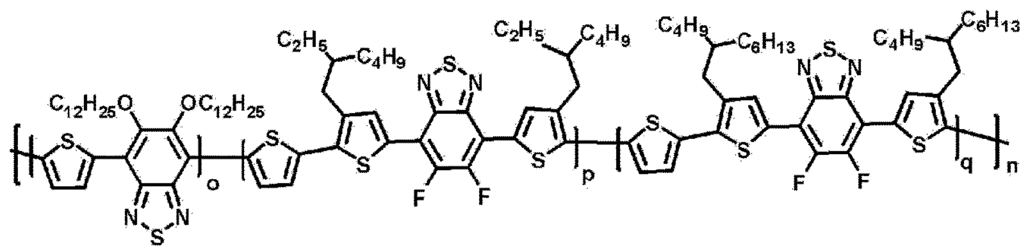

[Formule chimique 7-1-5]

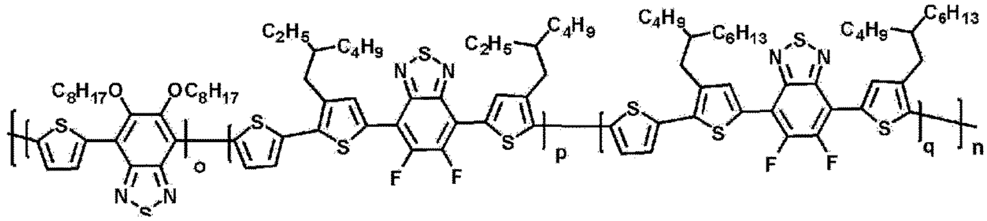

dans les formules chimiques 4-1-1 à 4-1-10, les formules chimiques 5-1-1 à 5-1-3, les formules chimiques 6-1-1 à 6-1-14, et les formules chimiques 7-1-1 à 7-1-5,

l représente un rapport molaire et $0 < l < 1$,
m représente un rapport molaire et $0 < m < 1$,
o représente un rapport molaire et $0 < o < 1$,
p représente un rapport molaire et $0 < p < 1$,
q représente un rapport molaire et $0 < q < 1$,
$1 + m = 1$,
$o + p + q = 1$, et
n représente un nombre répétitif de l'unité, et un nombre entier allant de 1 à 10 000.

**3.** Polymère selon la revendication 1, dans lequel le polymère présente un niveau d'énergie HOMO allant de 5 eV à 5,9 eV,
dans lequel le niveau d'énergie HOMO est mesuré au moyen d'une voltampérométrie cyclique qui est un procédé électrochimique.

**4.** Polymère selon la revendication 1, dans lequel le polymère présente une solubilité allant de 0,1 % en poids à 20 % en poids pour le chlorobenzène.

**5.** Polymère selon la revendication 1, dans lequel le polymère présente une distribution des masses moléculaires allant de 1 à 10,
dans lequel la masse moléculaire est mesurée par GPC.

**6.** Cellule solaire organique comprenant :

une première électrode ;
une seconde électrode qui est disposée pour faire face à la première électrode ; et
une couche de matériau organique présentant une ou plusieurs couches qui est disposée entre la première électrode et la seconde électrode et comprend une couche photoactive,
dans laquelle une ou plusieurs couches de la couche de matériau organique comprend/comprennent le polymère selon l'une quelconque des revendications 1 à 5.

**7.** Cellule solaire organique selon la revendication 6, dans laquelle la couche photoactive comprend un ou deux ou plusieurs éléments choisis parmi le groupe consistant en un donneur d'électrons et un accepteur d'électrons, et le donneur d'électrons comprend le polymère.

**8.** Cellule solaire organique selon la revendication 7, dans laquelle la couche photoactive comprend en outre un additif.

**9.** Cellule solaire organique selon la revendication 6, dans laquelle la couche photoactive présente une structure de film mince bicouche comprenant une couche de matériau organique de type n et une couche de matériau organique de type p, et
la couche de matériau organique de type p comprend le polymère.

[Figure 1]

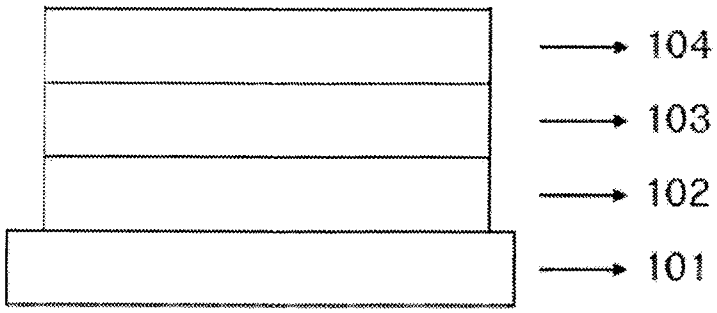


[Figure 2]

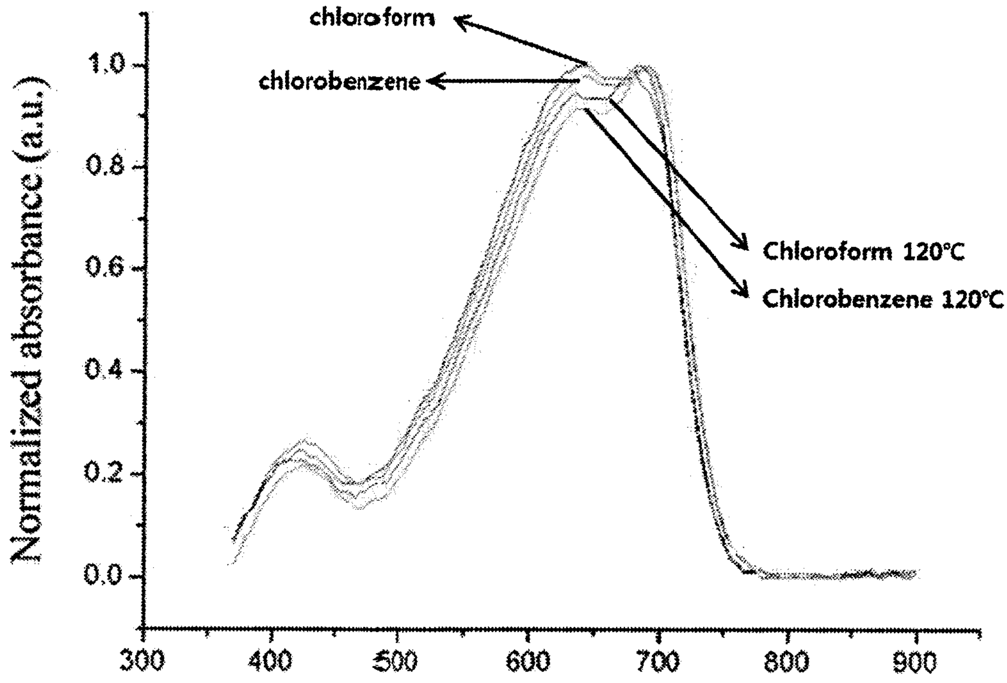

[Figure 3]

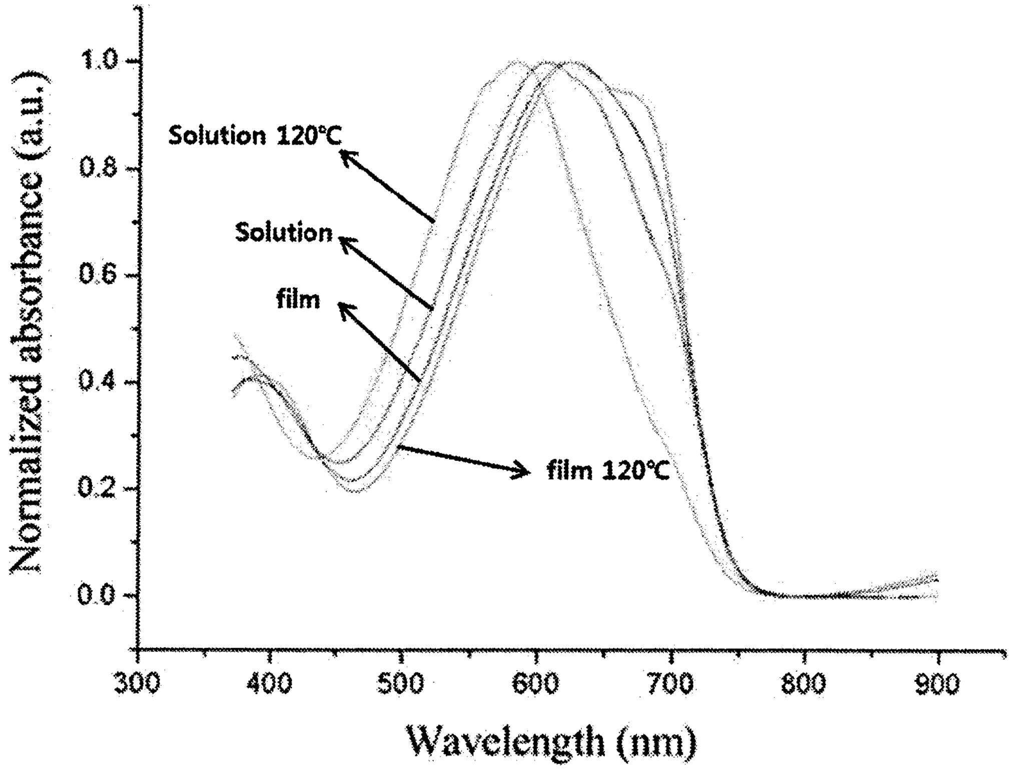


[Figure 4]

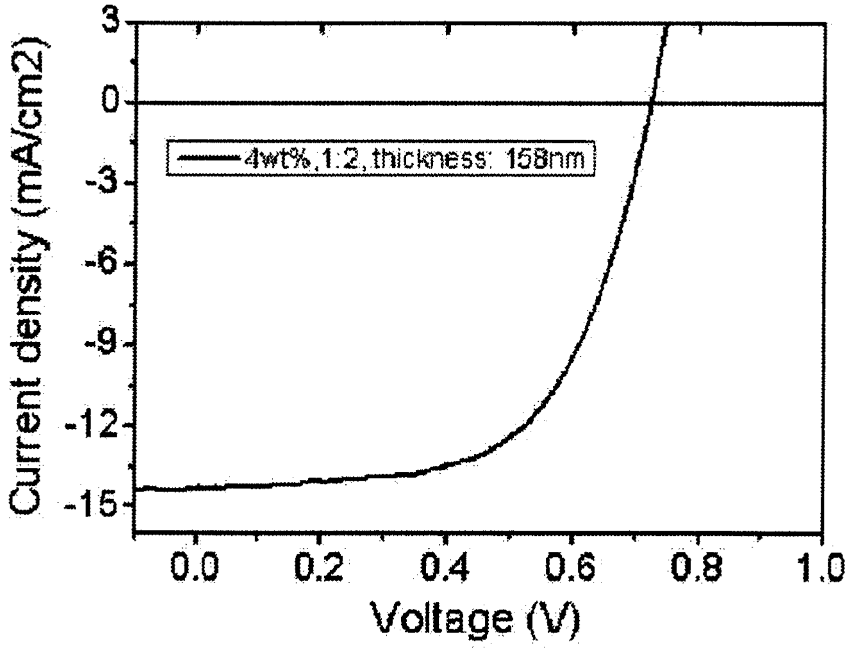

[Figure 5]

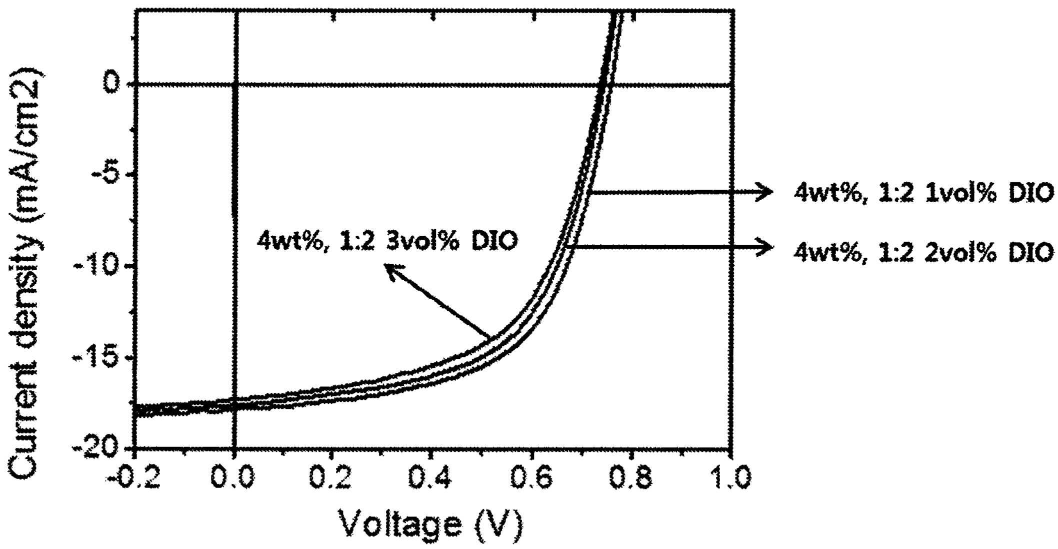


[Figure 6]

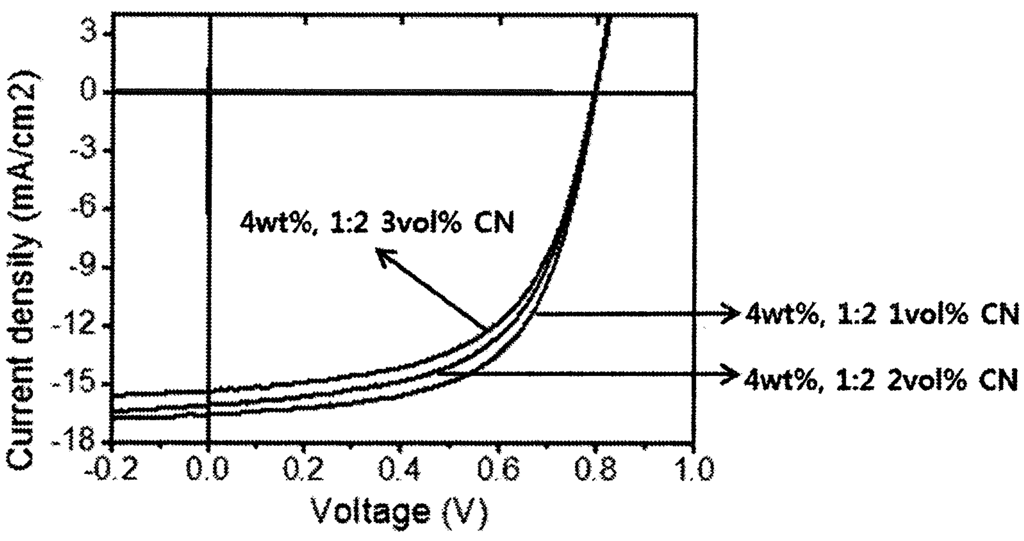

[Figure 7]

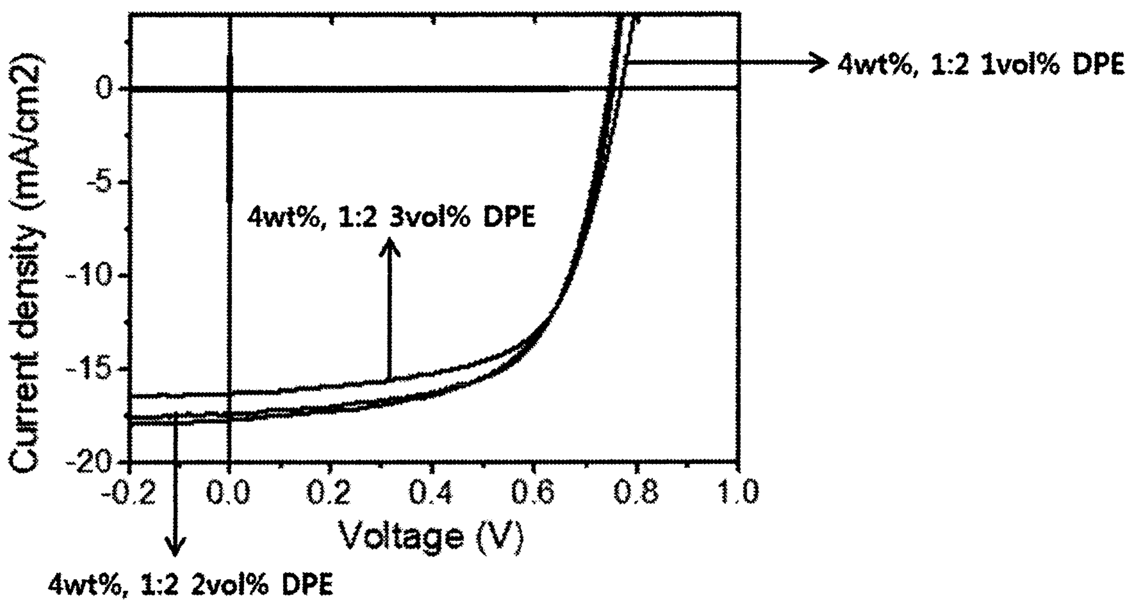


[Figure 8]

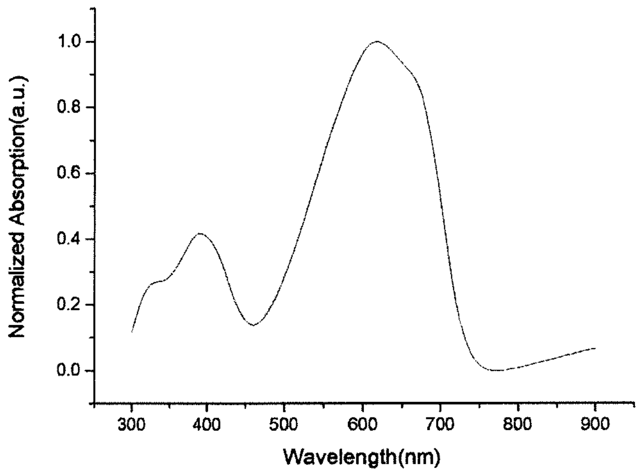

[Figure 9]

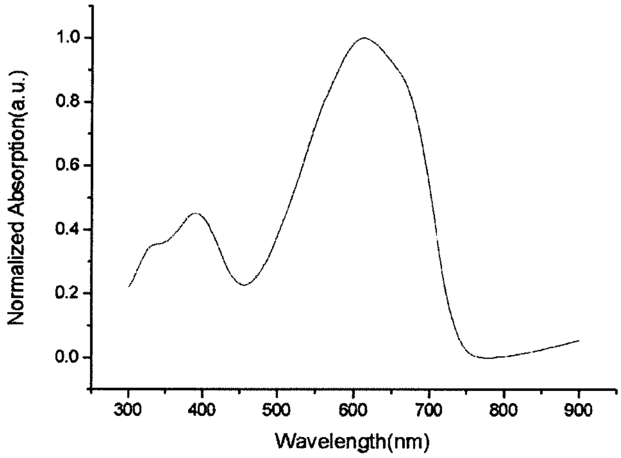


[Figure 10]

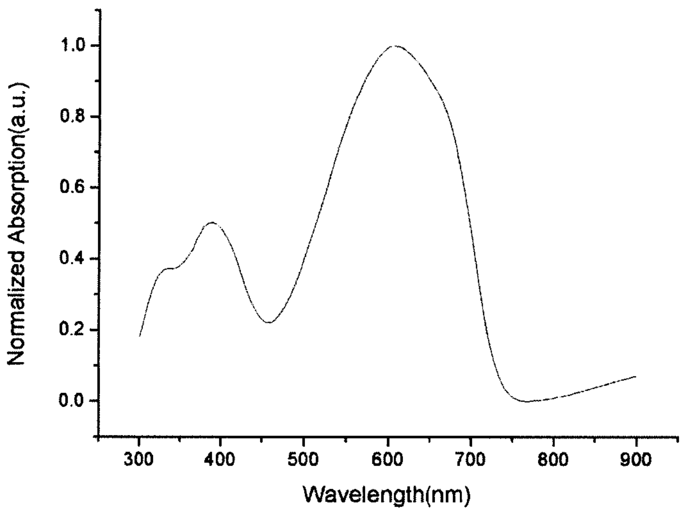

[Figure 11]

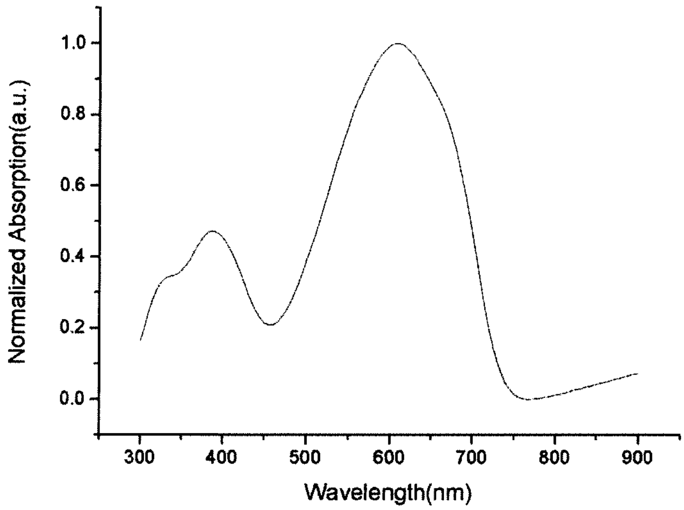


[Figure 12]

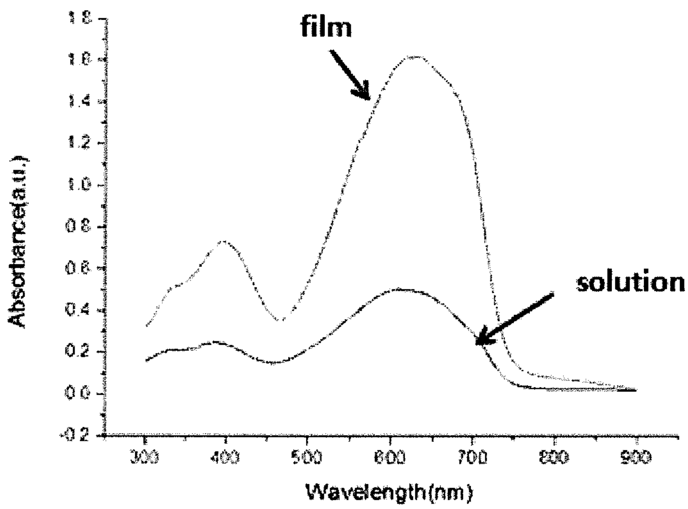

[Figure 13]

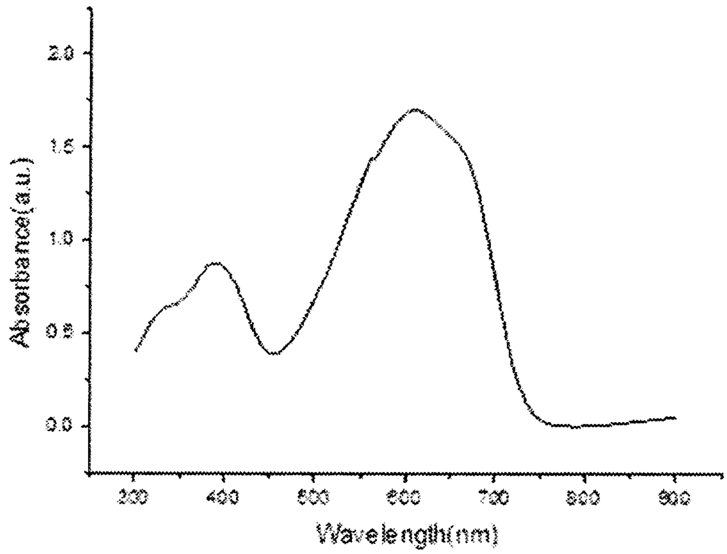


[Figure 14]

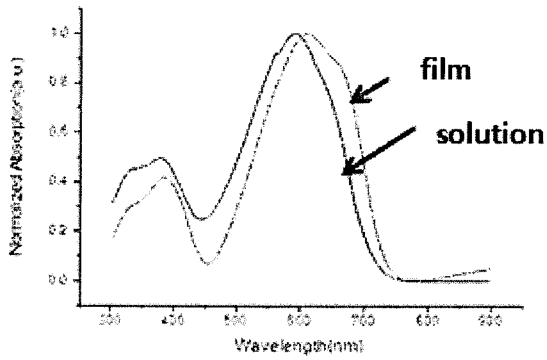

[Figure 15]

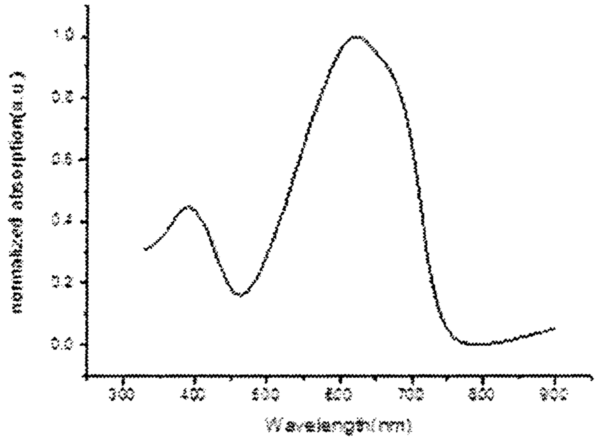


[Figure 16]

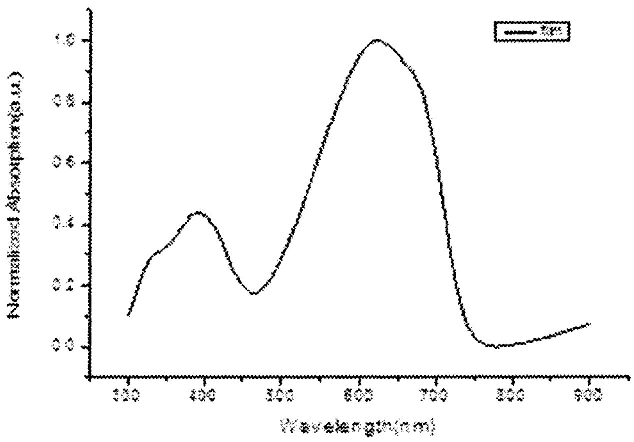

[Figure 17]

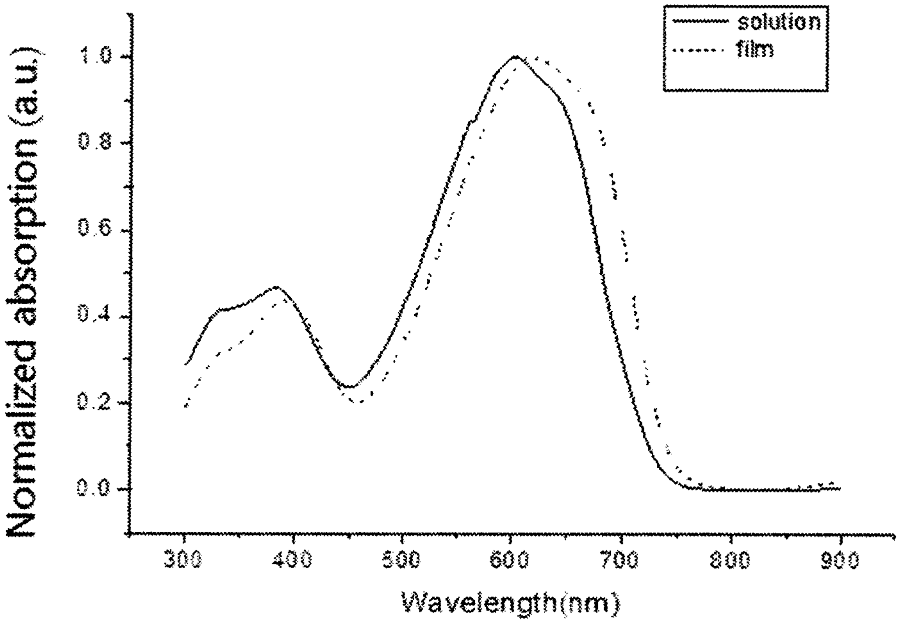


[Figure 18]

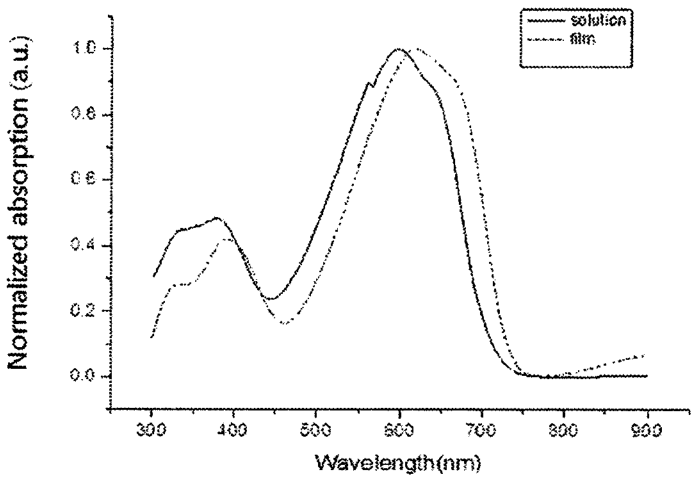

[Figure 19]

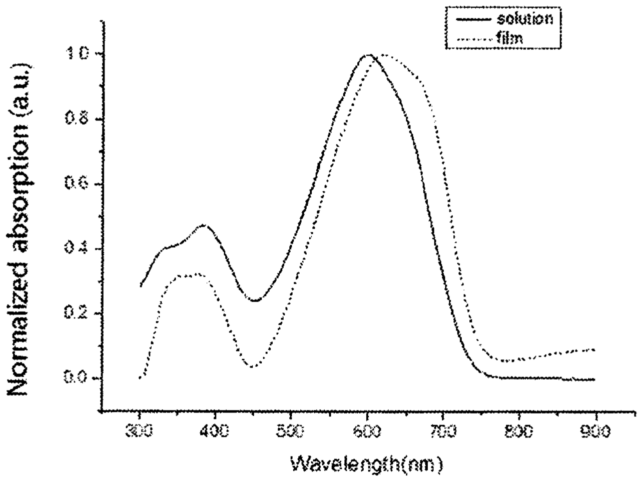


[Figure 20]

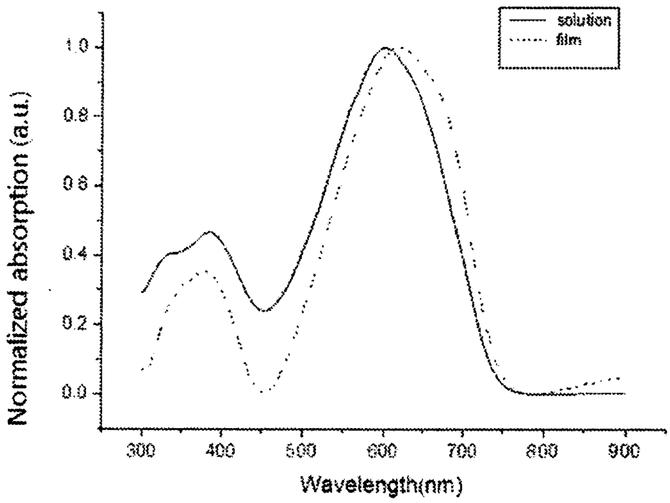

[Figure 21]

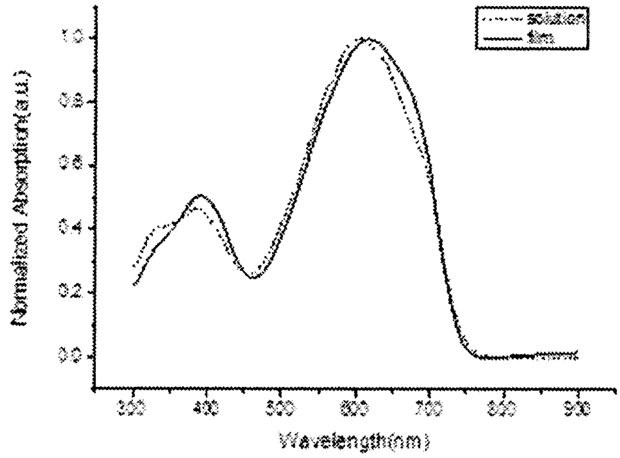


[Figure 22]

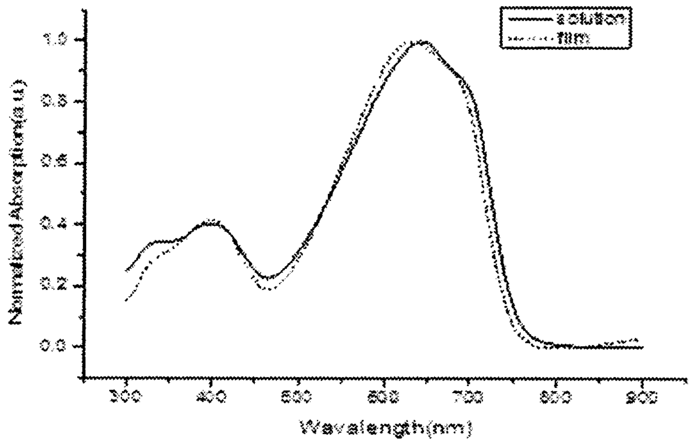

[Figure 23]

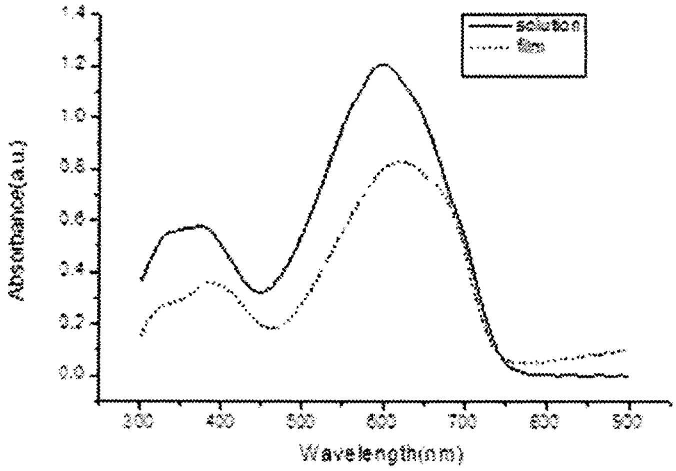


[Figure 24]

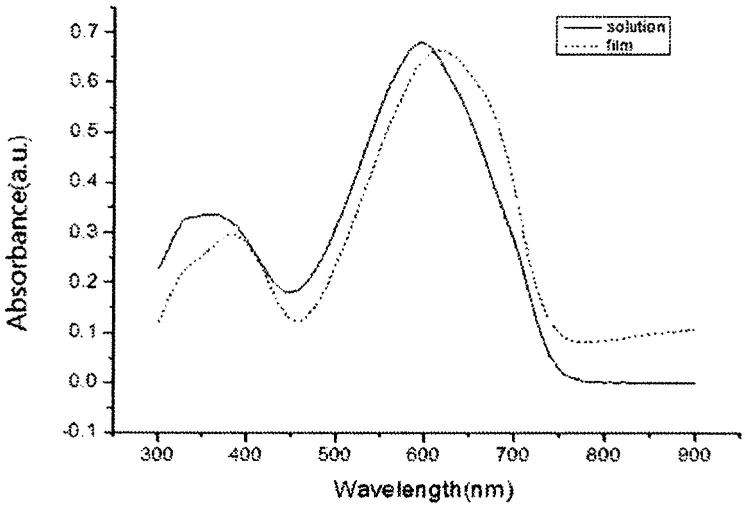

[Figure 25]

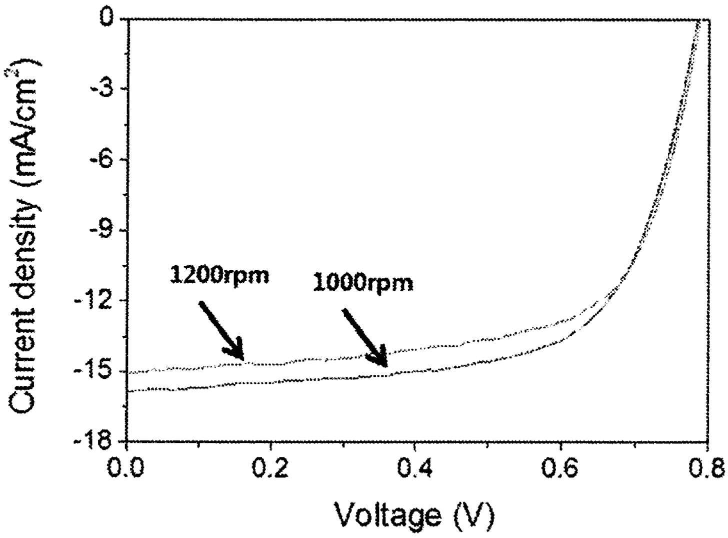


[Figure 26]

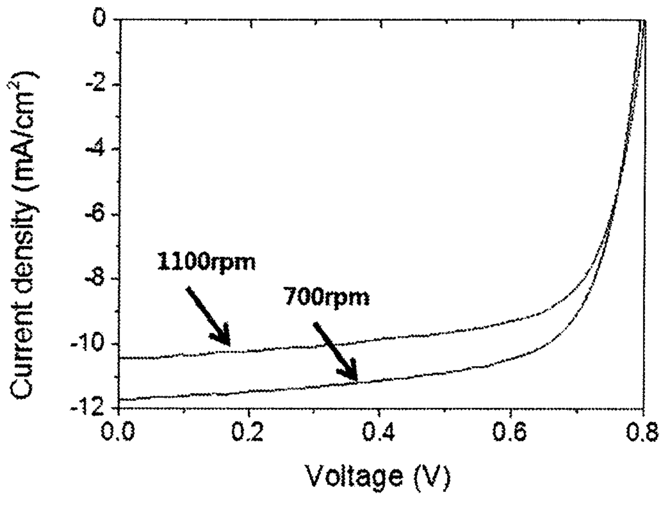

[Figure 27]

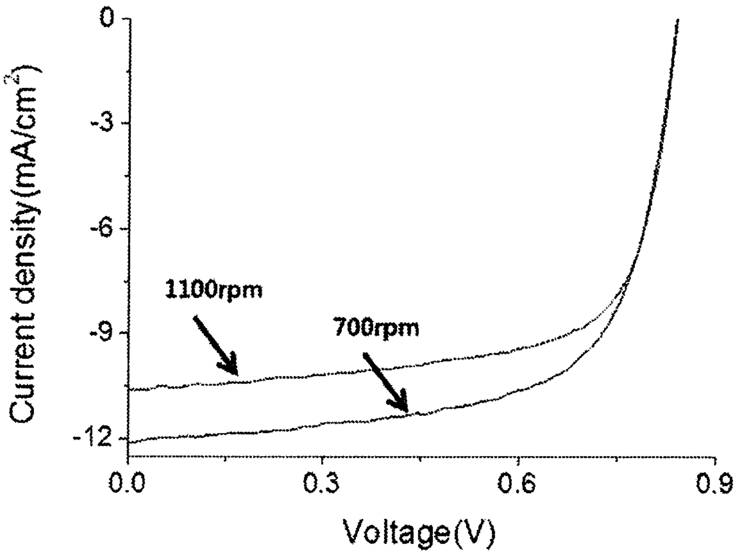


[Figure 28]

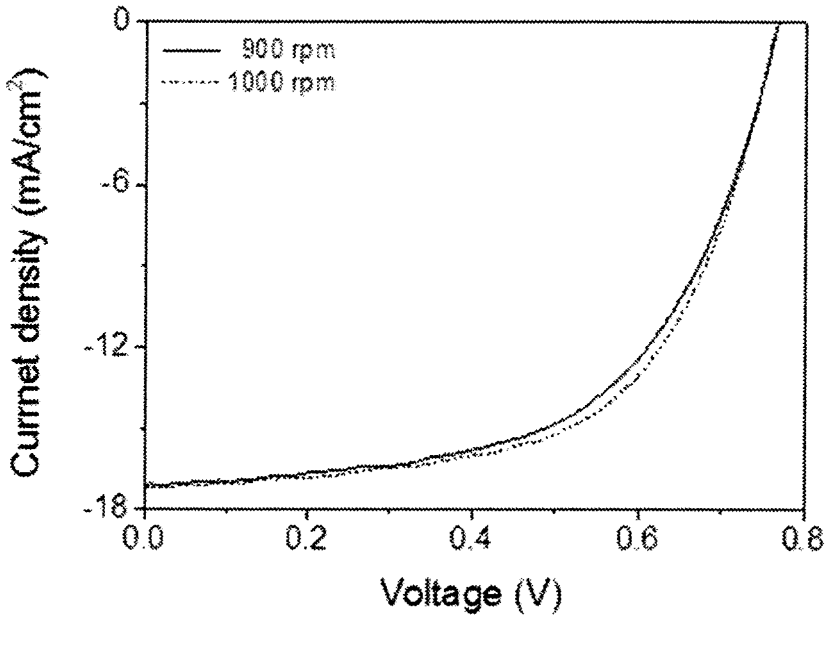

[Figure 29]

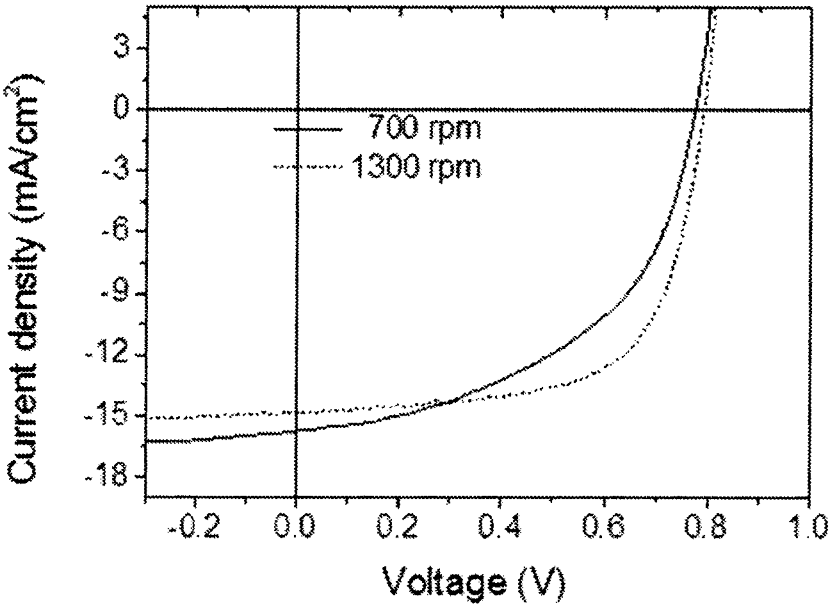


[Figure 30]

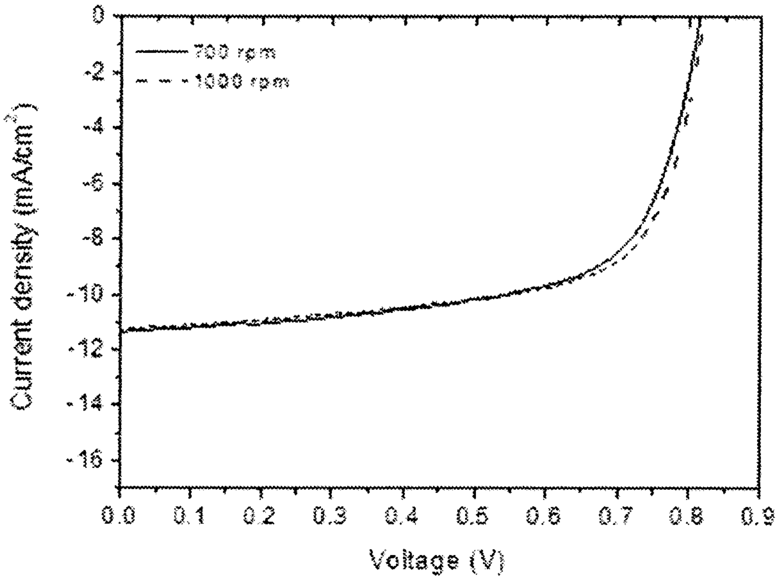

[Figure 31]

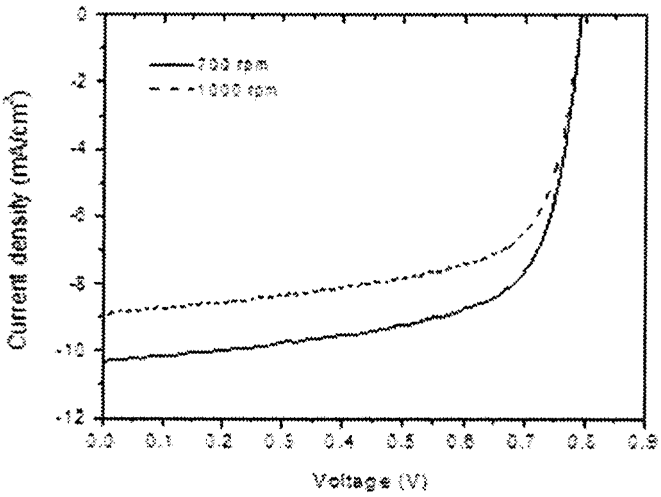


[Figure 32]

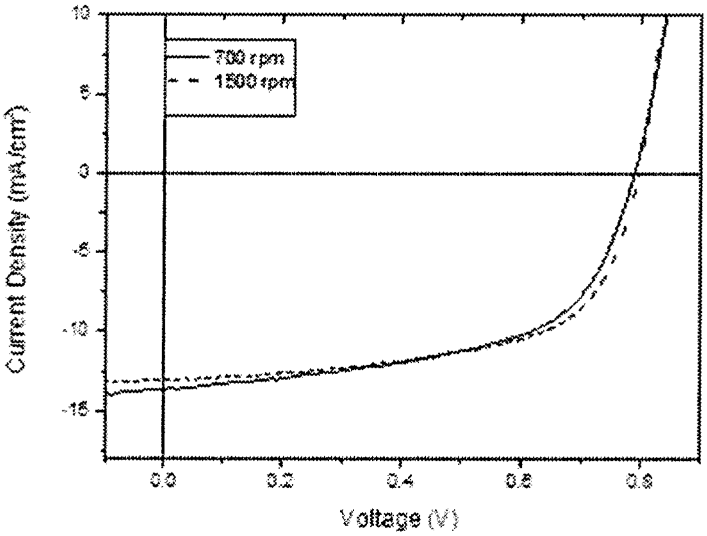

[Figure 33]

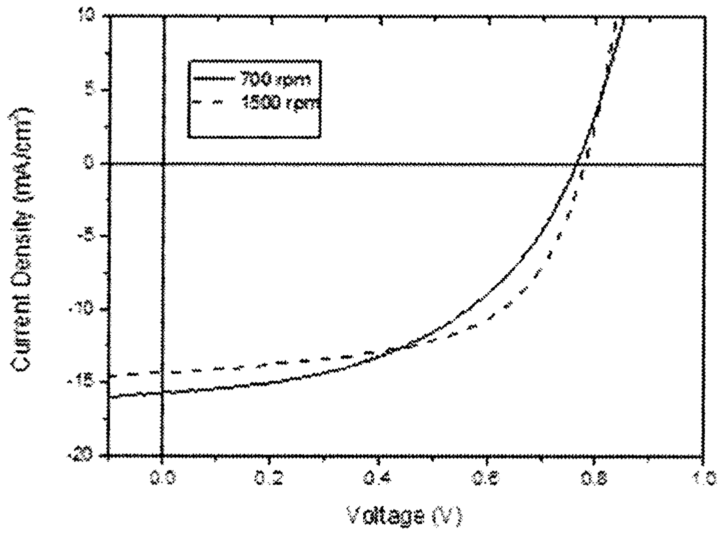


[Figure 34]

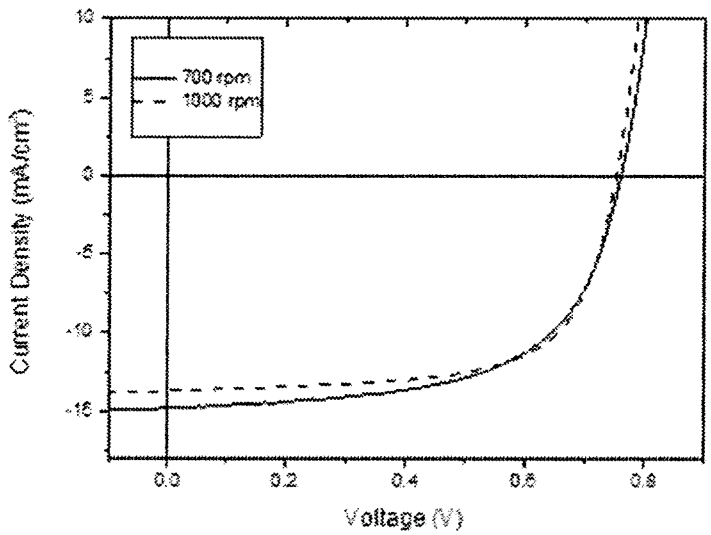

[Figure 35]

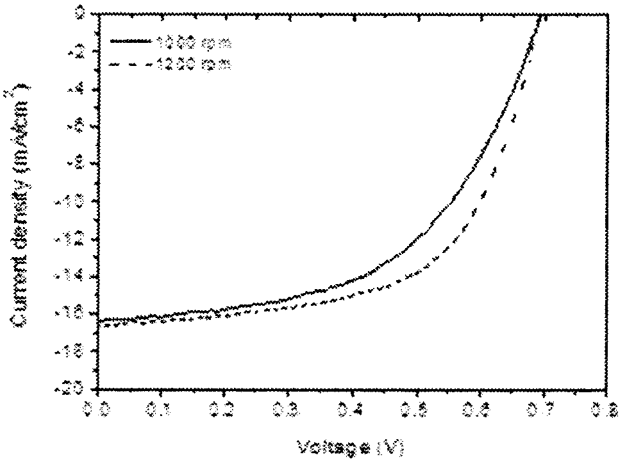


[Figure 36]

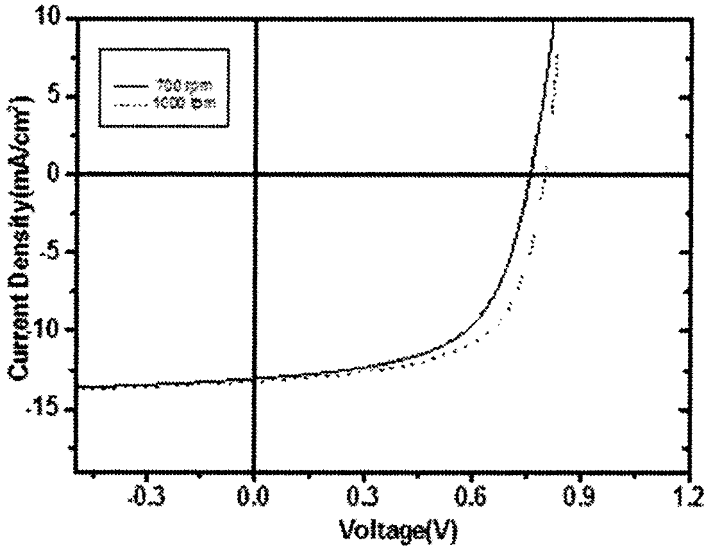

[Figure 37]

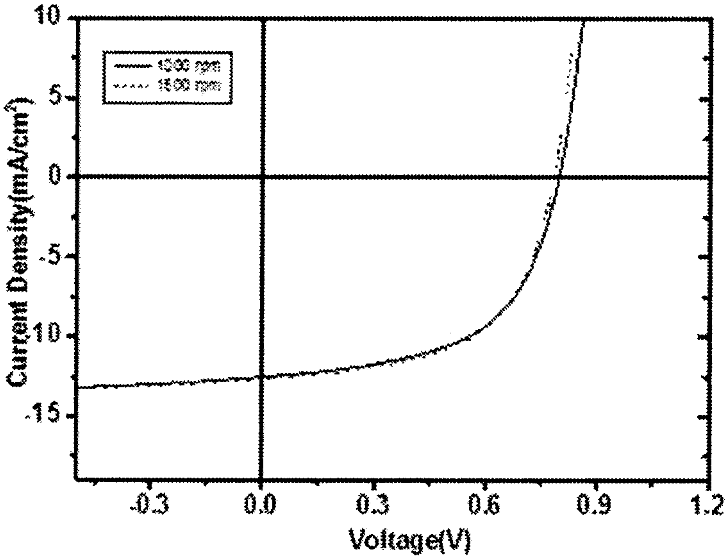

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- KR 1020150032475
- KR 20140025621
- CN 103030790 A


### Non-patent literature cited in the description


- **C.W. TANG.** *Appl. Phys. Lett.,* 1996, vol. 48, 183
- **G. YU ; J. GAO ; J. C. HUMMELEN ; F. WUDL ; A. J. HEEGER.** *Science,* 1995, vol. 270, 1789
- **ZHENG BANG LIM et al.** Polymer Chemistry. *Journal of Polymer Science,* vol. 49 (20), 4387-4397
- POLYMER CHEMISTRY. *JOURNAL OF POLYMER SCIENCE,* 2011, vol. 49, 4387-4397
- *Polymer Chemistry,* 2014, vol. 5 (2), 502-511